(19) Europäisches Patentamt
European Patent Office
Office européen des brevets

(11) EP 3 315 638 B1

(12) # EUROPEAN PATENT SPECIFICATION

(45) Date of publication and mention of the grant of the patent:
**21.04.2021 Bulletin 2021/16**

(21) Application number: **17175368.4**

(22) Date of filing: **09.06.2017**

(51) Int Cl.:
*C30B 7/14* (2006.01)
*C30B 29/22* (2006.01)
*C30B 29/60* (2006.01)
*H01M 4/525* (2010.01)
*H01M 4/02* (2006.01)
*H01M 10/0525* (2010.01)

(54) **LITHIUM COMPLEX OXIDE FOR LITHIUM SECONDARY BATTERY POSITIVE ACTIVE MATERIAL AND METHOD OF PREPARING THE SAME**

LITHIUMKOMPLEXOXID FÜR POSITIVES AKTIVES MATERIAL EINER LITHIUMSEKUNDÄRBATTERIE UND VERFAHREN ZUR HERSTELLUNG DAVON

OXYDE COMPLEXE DE LITHIUM POUR MATÉRIAU ACTIVE POSITIF DE BATTERIE SECONDAIRE AU LITHIUM ET SON PROCÉDÉ DE PRÉPARATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.07.2016 KR 20160087527**
**10.10.2016 KR 20160130562**

(43) Date of publication of application:
**02.05.2018 Bulletin 2018/18**

(73) Proprietor: **ECOPRO BM CO., LTD.**
**Cheongju-si, Chungcheongbuk-do 28117 (KR)**

(72) Inventors:
- **CHOI, Moon Ho**
**Cheongju-si, Chungcheongbuk-do, 28425 (KR)**
- **SHIN, Jong-Seung**
**Eumseong-gun, Chungcheongbuk-do, 27735 (KR)**
- **KIM, Dong-Hee**
**Changwon-si, Gyeongsangnam-do, 51132 (KR)**
- **JEON, Suk Yong**
**Chungcheongbuk-do, 27373 (KR)**
- **YU, Hyun Jong**
**Cheongju-si, Chungcheongbuk-do, 28115 (KR)**
- **LEE, Kyoung Jun**
**Cheongju-si, Chungcheongbuk-do, 28109 (KR)**
- **PARK, Young Nam**
**Seo-gu, Incheon, 22815 (KR)**

(74) Representative: **Vossius & Partner**
**Patentanwälte Rechtsanwälte mbB**
**Siebertstrasse 3**
**81675 München (DE)**

(56) References cited:
**EP-A1- 2 882 013**
**EP-A1- 3 024 069**
**WO-A1-2016/103511**
**WO-A1-2016/108375**
**JP-B2- 5 505 608**
**KR-A- 20140 081 663**
**US-A1- 2012 009 474**
**US-A1- 2014 205 898**
**US-A1- 2016 181 611**

- **ZUO DAXIAN ET AL: "Recent progress in surface coating of cathode materials for lithium ion secondary batteries", JOURNAL OF ALLOYS AND COMPOUNDS, ELSEVIER SEQUOIA, LAUSANNE, CH, vol. 706, 24 February 2017 (2017-02-24), pages 24-40, XP029950253, ISSN: 0925-8388, DOI: 10.1016/J.JALLCOM.2017.02.230**
- **KALYANI P ET AL: "Various aspects of LiNiO"2 chemistry: A review", SCIENCE AND TECHNOLOGY OF ADVANCED MATERIALS, ELSEVIER SCIENCE, vol. 6, no. 6, 1 September 2005 (2005-09-01), pages 689-703, XP027624516, ISSN: 1468-6996 [retrieved on 2005-09-01]**
- **Sonja Laubach ET AL: "Changes in the crystal and electronic structure of LiCoO2 and LiNiO2 upon Li intercalation and de-intercalation", Phys. Chem. Chem. Phys.,, 1 January 2009 (2009-01-01), pages 3278-3289, XP055661846, Retrieved from the Internet: URL:https://pubs.rsc.org/en/content/articlepdf/2009/cp/b901200a [retrieved on 2020-01-24]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 315 638 B1

## Description

BACKGROUND

Embodiments of the inventive concept described herein relate to a lithium complex oxide and a method of preparing the same, and more particularly, relate to a lithium complex oxide, and a method of preparing the same, improving the characteristics of capacity, resistance, and battery lifetime with different interplanar distances of crystalline structure between a primary particle locating on the surface part of a secondary particle and a primary particle locating in the internal part secondary particle by coating different elements on the surface part, in consideration of inclination to functional degradation but reduction of residual lithium after a washing for removing the residual lithium in a preparation process, for a positive active material where lithium ion pathways in a-axis and c-axis of a crystalline structure.

With an increase of technology and demand for mobile devices, secondary batteries as energy sources are increasing in demand. Among secondary batteries, lithium (Li) secondary batteries are being now commercialized and widely used on the merits of high energy density and operating potential, long cycle lifetime, and low discharge rate.

A positive active material for a lithium secondary battery usually employs a lithium-contained cobalt oxide ($LiCoO_2$). It is also considered therefor even to use a lithium-contained manganese oxide such as layered crystalline structure of $LiMnO_2$ or spinel crystalline structure of $LiMn_2O_4$, or a lithium-contained nickel oxide such as $LiNiO_2$.

Among those positive active materials, $LiCoO_2$ is most frequently used because of good characteristics of battery lifetime and charge/discharge efficiency, but there is a limit to competitiveness of cost in mass use as power sources for middle/large-scale batteries of electric vehicles because cobalt (Co) is rare and expensive as a resource, and small in capacity. Although the lithium manganese oxide such as $LiMnO_2$ or $LiMn_2O_4$, as the positive active material, is low in price, eco-friendly, and highly stable in heat, it is deteriorative in high temperature and cycle characteristics. For instance, Patent Literature KR 2014 0081663 A discloses a manufacturing method of a cathode active material for Lithium rechargeable battery and cathode active material made by the same.

A method of preparing a lithium complex oxide generally includes the steps of manufacturing transition metal precursors, mixing a lithium compound and the transition metal precursors, and then baking the mixture. During this, LiOH and/or $Li_2CO_3$ are/is used for the lithium compound. It is generally preferred to use $Li_2CO_3$ in the case that Ni content of the positive active material is equal to or lower than 65% and preferred to use LiOH in the case that Ni content of the positive active material is equal to or higher than 65%.

However, a nickel (Ni) rich system containing nickel equal to or higher than 65%, reactive at a low temperature, has a problem of having much residual lithium which remains in a form of LiOH and $Li_2CO_3$ on the surface of a positive active material. The residual lithium, that is, unreacted LiOH and $Li_2CO_3$ generate gas and a swelling effect by reacting with an electrolyte in the battery, and then cause high temperature stability to be seriously worse. Additionally, the unreacted LiOH also causes gelation because its viscosity is high when mixing slurry before manufacturing electrode plates.

To remove such unreacted Li, the inventors executed a washing process after preparing a positive active material, thereby much reducing residual lithium. However, during the washing process, the surface of the positive active material was damaged and degraded in characteristics of capacity and efficiency. Additionally, there was another problem to increase resistance in high temperature storage. Therefore, it is necessary to improve the characteristics of capacity, efficiency, and battery lifetime as well as to reduce residual lithium.

SUMMARY

Embodiments of the inventive concept provide a lithium complex oxide of a new structure improving the characteristics of capacity, resistance, and battery lifetime as well as reducing residual lithium.

According to an aspect of an embodiment, a lithium complex oxide secondary particle is formed by agglomeration of a plurality of primary particles and configured to satisfy a relation that is d1 > d2 wherein d1 is an interplanar distance of a crystalline structure in a primary particle locating in the internal part of secondary particle among the plurality of primary particles measured from diffraction patterns, and d2 is an interplanar distance of a crystalline structure in a primary particle locating on a surface part of the secondary particle relation measured from diffraction patterns, wherein the interplanar distances d1 and d2 mean averages of 10 adjacent interplanar distances based on an interplanar distance of a part which is measured by TEM analysis, and wherein the interplanar distance between 10 consecutive adjacent oxide layers d1 is ≥ 4.8 nm and the interplanar distance between 10 consecutive adjacent oxide layers d2 is ≤ 4.75 nm; and wherein the secondary particle is given by the Formula $Li_{x1}Ni_{1-(x1+y1+z1)}Co_{x1}M1_{y1}M2_{z1}M3_{r1}O_a$, wherein M1 is Mg, Al, or Mg and Al, M2 is Co, and M3 is Ti, and wherein $0.95 \le X1 \le 1.05$, $1.50 \le a \le 2.1$, $0.02 \le x1 \le 0.25$, $0.01 \le y1 \le 0.20$, $0 \le z1 \le 0.20$, and $0 \le r1 \le 0.20$, and wherein the lithium complex oxide secondary particle has a hexagonal structure.

The present inventors have already filed an application about a structure which a lithium ion pathway is formed in a primary particle of a lithium complex oxide. The inventive concept is technically characterized in that interplanar distances forming such a lithium ion pathway may be different between a primary particle locating in the internal part secondary particle and a primary particle locating on the surface part of the secondary particle. That is, a lithium complex oxide secondary particle according to the inventive concept is characterized in that an interplanar distance of a primary particle locating in the internal part of secondary particle may be different from an interplanar distance of a primary particle locating on the surface part of the secondary particle, and for example an interplanar distance of a primary particle locating in the internal part of the secondary particle is formed larger than an interplanar distance of a primary particle locating on the surface part of the secondary particle.

In the lithium complex oxide secondary particle according to the inventive concept, the interplanar distances d1 and d2 mean averages of 10 adjacent interplanar distances based on an interplanar distance of a part which is measured by a crystalline structure spectrometry such as TEM analysis for a positive active material.

In the lithium complex oxide secondary particle, the d1, which is the interplanar distance of the crystalline structure in the primary particle locating in the internal part of secondary particle, is configured to be equal to or larger than 4.8 nm.

In the lithium complex oxide secondary particle, the d2, which is the interplanar distance of the crystalline structure in the primary particle locating on the surface part of the secondary particle, is equal to or smaller than 4.75 nm.

The lithium complex oxide secondary particle is in a hexagonal structure and a lithium ion pathway may be formed toward the center from the surface of the secondary particle.

In the lithium complex oxide secondary particle, a primary particle locating on the surface part of the secondary particle means a primary particle locating at a surface part on which different metals are coated. In the lithium complex oxide secondary particle, a primary particle locating in the internal part of secondary particle may mean a primary particle of the inside, except the surface part of the secondary particle.

In the lithium complex oxide secondary particle, for defining a primary particle locating on the surface part of the secondary particle, a thickness of the surface part of the secondary particle may be in 50 to 200 nm from the outer shell of the secondary particle.

In the lithium complex oxide secondary particle, the surface part of the secondary particle may have a grade of Co ion concentration.

In the lithium complex oxide secondary particle, a primary particle locating on the surface part of the secondary particle may have a concentration grade with Co ion concentration therein, and Co ion concentration is not constant.

In the lithium complex oxide secondary particle, primary particles locating on the surface part of the secondary particle and primary particles locating in the internal part of secondary particle have concentration grading portions, which exhibit Co ion concentration, at boundaries of the primary particles.

The lithium complex oxide secondary particle may have a bound energy (P1) of spin-orbit-spit 2p3/2 peak and a bound energy (P2) of 2p1/2 peak in a Co 2p core-level spectrometry obtained through XPS measurement, and the P1 and the P2 are ranged in $779eV \leq P1 \leq 780eV$ and $794eV \leq P2 \leq 795eV$.

The lithium complex oxide secondary particle may have a ratio of peak intensity ($I_{531}$) around 531 eV and peak intensity ($I_{528}$) around 528.5 eV during an O 1s core-level spectrometry that is obtained through XRS measurement, wherein, wherein $1531/1528 \leq 2$.

The lithium complex oxide secondary particle may have a ratio between peak intensity ($I_{289}$) around 289 eV and peak intensity ($I_{284}$) around 284.5 eV during a C 1s core-level spectrometry that is obtained through XRS measurement, wherein $I289/I284 \leq 0.9$.

The lithium complex oxide secondary particle is given by the following Formula 1,

[Formula 1] $Li_{x1}Ni_{1-(x1+y1+z1)}Co_{x1}M1_{y1}M2_{z1}M3_{r1}O_a$

In Formula 1, M1 is Mg, Al, or Mg and Al, M2 is Co, and M3 is Ti, and $0.95 \leq X1 \leq 1.05$, $1.50 \leq a \leq 2.1$, $0.02 \leq x1 \leq 0.25$, $0.01 \leq y1 \leq 0.20$, $0 \leq z \leq 0.20$, and $0 \leq r1 \leq 0.20$.

According to another aspect of the inventive concept, a method of preparing a lithium complex oxide secondary particle includes: manufacturing precursors of a lithium complex oxide secondary particle given by the following Formula 2,

[Formula 2] $Ni_{1-(x2+y2+z2)}Co_{x2}M1_{y2}M2_{z2}(OR)_2$,

wherein, in Formula 2, M1 is Mg, Al, or Mg and Al, and M2 is Co, and wherein $0 \leq x2 \leq 0.25$, $0 \leq y2 \leq 0,20$, and $0 \leq z2 \leq 0.20$; reacting precursors of a lithium complex oxide secondary particle with a lithium compound and manufacturing a positive active material by first thermal treating the reactant; washing the positive active material with distilled water or an alkaline solution; mixedly agitating the washed positive active material with a solution containing M2, that is Co, and reactively coating the surface; drying particles of the positive active material; and mixing the dried positive active material that is a metal Ti and doping the metal M3 into the particles by second thermally treating the mixture.

Still another aspect of the inventive concept provides a lithium secondary battery including a lithium complex oxide secondary particle according to embodiments of the inventive concept.

In the lithium secondary battery according to the inventive concept, residual lithium may be equal to or smaller than 6,000 ppm.

In the method of preparing a lithium complex oxide secondary particle according to the inventive concept, the first thermal treatment may be processed in 700 to 900 °C.

In the method of preparing a lithium complex oxide secondary particle according to the inventive concept, the second thermal treatment may be processed in 400 to 750 °C.

In the method of preparing a lithium complex oxide secondary particle according to the inventive concept, concentration of the solution containing the compound containing the M2 may be 1 to 10 mol%.

BRIEF DESCRIPTION OF THE FIGURES

The above and other objects and features will become apparent from the following description with reference to the following figures, wherein like reference numerals refer to like parts throughout the various figures unless otherwise specified, and wherein:

FIG. 1 shows a result of measuring diffraction patterns and interplanar distances of an $LiCoO_2$ positive active material of Comparison 1 according to the inventive concept;
FIG. 2 shows a result of measuring TEM and EDX photographs of a positive active material prepared according to an embodiment of the inventive concept;
FIG. 3 shows a result of measuring diffraction patterns and interplanar distances of a positive active material prepared according to an embodiment of the inventive concept;
FIG. 4 shows a result of measuring TEM and EDX photographs of a positive active material prepared according to an embodiment of the inventive concept;
FIG. 5 shows a result of measuring diffraction patterns and interplanar distances of a positive active material prepared according to an embodiment of the inventive concept;
FIG. 6 shows a result of measuring respective variations of concentration for Ni, Co, and Al toward the center from the surface of a positive active material prepared according to an embodiment of the inventive concept;
FIG. 7 shows a result of measuring an EDX photograph of a positive active material prepared according to an embodiment of the inventive concept;
FIG. 8 shows a result of measuring diffraction patterns and interplanar distances of a positive active material prepared according to an embodiment of the inventive concept;
FIG. 9 shows a result of measuring TEM and EDX photographs of a positive active material prepared according to an embodiment of the inventive concept;
FIG. 10 shows a result of measuring respective variations of concentration for Ni, Co, and Al toward the center from the surface of a positive active material prepared according to an embodiment of the inventive concept;
FIG. 11 shows a result of measuring respective variations of concentration for Ni, Co, and Al toward the center from a third spot of a positive active material prepared according to an embodiment of the inventive concept;
FIGS. 12 to 14 show results of measuring diffraction patterns and interplanar distances of positive active materials manufactured by comparison examples and embodiments of the inventive concept;
FIGS. 15 and 16 show results of measuring EDX photographs of positive active materials manufactured by comparison examples of the inventive concept;
FIGS. 17 to 19 show results of measuring diffraction patterns and interplanar distances of positive active materials manufactured by comparison examples and embodiments of the inventive concept;
FIGS. 20 and 21 show results of measuring respective variations of concentration for Ni, Co, and Al toward the center from the surface of a positive active material prepared according to an embodiment of the inventive concept;
FIGS. 22 to 25 show results of measuring XRD of positive active materials manufactured by comparison examples and embodiments of the inventive concept;
FIG. 26 shows a result of measuring XPS of positive active materials manufactured by a comparison example and an embodiment of the inventive concept; and
FIGS. 27A to 31E show results of measuring the characteristics of batteries including positive active materials manufactured by comparison examples and embodiments of the inventive concept.

DETAILED DESCRIPTION

Hereafter, embodiments of the inventive concept will be described in detail with reference to the accompanying figures. The inventive concept may not be however restrictive to the embodiments proposed below.

**<Comparison 1>**

A $LiCoO_2$ positive active material, which is commercially sold, was used for Comparison 1.

**<Experimental example> Measuring distance between crystalline structures**

FIG. 1 shows respective diffraction patterns and interplanar distances for a primary particle, which locates in a secondary particle, and a primary particle locating on the surface part of the secondary particle of the $LiCoO_2$ positive active material of Comparison 1.

After mounting the $LiCoO_2$ positive active material on a carbon grid, coating the $LiCoO_2$ positive active material with carbon and PT, and then magnifying the coated $LiCoO_2$ positive active material in 20 million or 25 million times through a TEM pre-treatment that slices the coated $LiCoO_2$ positive active material, ten interplanar distances were measured left and light around an interplanar distance to be known.

As shown in FIG. 1, diffraction patterns of the primary particles locating in the secondary particle of the $LiCoO_2$ positive active material and locating on the surface part of the secondary particle were all in hexagonal structure, and interplanar distances of the primary particles locating in the internal part of secondary particle and locating on the surface part of the secondary particle were all measured as 4.70 nm.

**<Embodiment 1> Manufacturing positive active material**

First, NiCo(OH)2 precursors were manufactured through a coprecipitation. Then, a lithium secondary battery positive active material was manufactured by adding $Li_2CO_3$ and LiOH as lithium compounds to the manufactured precursors, adding Al and Mg as M1 thereto, and processing the mixture in first thermal treatment.

After preparing distilled water, the manufactured lithium secondary battery positive active material was washed by injecting the distilled water in uniform temperature.

Afterward, the surface of the positive active material was washed and coated with Co as M2 by agitating the positive active material while injecting a cobalt sulfate solution of 0.03 mol into the positive active material washing liquid for one hour in a specific ratio, and then dried at 120 °C under a vacuum.

Then, the lithium secondary battery positive active material was manufactured by adding Ti as M3 to the coated positive active material and processing the Ti-added positive active material in second thermal treatment at 450 °C.

**<Experimental example> Measuring TEM and EDX**

TEM and EDX photographs were taken from the positive active material manufactured through Embodiment 1 and shown in FIG. 2.

As shown in FIG. 2, the positive active material manufactured through Embodiment 1 of the inventive concept has Co concentration that is higher on the surface part of the secondary particle and lower toward the inside from the surface of the secondary particle. Co concentration is ununiform in the secondary particle with a grade.

**<Experimental example> Measuring interplanar distances between crystalline structures**

FIG. 3 shows respective diffraction patterns and interplanar distances for primary particles locating in the internal part of the secondary particle manufactured through Embodiment 1 and locating on the surface part on which Co and Ti are coated.

As shown in FIG. 3, the thickness of a Co-coated layer is about 80 nm, and the diffraction pattern of the primary particle locating in the secondary particle is in hexagonal structure. For the primary particle locating in the secondary particle, 10 adjacent interplanar distances were measured as 4.88 nm on average in a TEM photograph. Comparatively, the primary particle locating on the surface part having the Co-coated layer was measured as exhibiting a diffraction pattern of hexagonal structure with an interplanar distance of 4.73 nm.

From this result, it can be seen that the interplanar distance of the primary particle locating on the surface part was relatively reduced in comparison with the primary particle locating in the internal part of secondary particle which was not coated with cobalt, and the interplanar distance of the primary particle locating on the surface part was changed similar to an interplanar distance of $LiCoO_2$ of a comparison example.

**<Embodiment 2> Manufacturing positive active material**

A positive active material of Embodiment 2 was manufactured in the same as Embodiment 1, but is different such that a cobalt solution having concentration of 4 mol% was added to the positive active material washing liquid.

**<Experimental example> Measuring TEM and EDX**

FIG. 4 shows a result of measuring TEM and EDX photographs of the positive active material manufactures through Embodiment 2.

As shown in FIG. 4, it can be seen that the positive active material manufactured through Embodiment 2 of the inventive concept has Co concentration that is higher on the surface part of the secondary particle and lower toward the inside of the secondary particle. That is, Co concentration of the positive active material is ununiform and distributed in a grade.

**<Experimental example> Measuring distances between crystalline structures**

FIG. 5 shows a result of measuring respective diffraction patterns and interplanar distances of primary particles locating in the internal part of the positive active material manufactured through Embodiment 1 and locating on the surface part where Co and Ti are coated.

As shown in FIG. 5, it was measured that a thickness of the Co-coated layer was about 90 nm, a diffraction pattern of the primary particle locating in a secondary particle was in a hexagonal structure, and an average of 10 adjacent interplanar distances of the primary particle locating in the internal part of secondary particle was measured as 4.85 nm in a TEM photograph, while the primary particle locating on the surface part of the Co-coated layer had a diffraction pattern of hexagonal structure but an interplanar distance thereof was measured as 4.73 nm.

It can be seen that, comparative to the primary particle locating in the Co-uncoated secondary particle, the interplanar distance of the primary particle locating on the surface part was reduced and changed similar to the interplanar distance of $LiCoO_2$ of a comparison example.

**<Embodiment 3> Manufacturing NCM-based positive active material**

In the same manner with Embodiment 1, a positive active material of Embodiment 3 was manufactured by executing a coating process with 5 mol% concentration of a cobalt solution added to the positive active material washing liquid.

**<Experimental example> Concentration scanning**

FIG. 6 shows a result of measuring respective concentration variations of No, Co, and Al from the surface of the secondary particle of the positive active material, which is manufactured through Embodiment 3, toward the center of the particle.

From FIG. 6, it can be seen that the positive active material manufactured through Embodiment 3 of the inventive concept has Co concentration that becomes higher toward the center from the surface in the Co-coated layer where Co is coated, but after the Co-coated layer, the Co concentration turns to be reduced as close as the center and a thickness of the Co-coated layer is 0.1 $\mu$m.

**<Experimental example> TEM and EDX**

FIG. 7 shows a result of measuring respective EDX photographs for Ni, Co, and Al from the surface of the secondary particle of the positive active material, which is manufactured through Embodiment 3, toward the center of the particle.

From FIG. 7, it can be seen that the positive active material manufactured through Embodiment 3 of the inventive concept has Co concentration that becomes higher toward the center from the surface in the Co-coated layer where Co is coated, but after the Co-coated layer, the Co concentration turns to be reduced as close as the center and concentration of the Co-coated layer is higher along the boundaries of the primary particles.

**<Experimental example> Measuring distances between crystalline structures**

FIG. 8 shows a result of measuring respective diffraction patterns and interplanar distances of primary particles locating in the positive active material manufactured through Embodiment 3 and locating on the surface part on which Co and Ti are coated.

As shown in FIG. 8, it was measured that a thickness of the Co-coated layer was about 100 nm, a diffraction pattern of the primary particle locating in a secondary particle was in a hexagonal structure, and an average of 10 adjacent interplanar distances of the primary particle locating in the secondary particle was measured as 4.84 nm in a TEM photograph, while the primary particle locating on the Co-coated layer had a diffraction pattern of hexagonal structure but an interplanar distance thereof was measured as 4.67 nm.

It can be seen that, comparative to the primary particle locating in the Co-uncoated secondary particle, the interplanar distance of the primary particle locating on the Co-coated surface was reduced and changed similar to interplanar distances of $LiCoO_2$ of a comparison example.

**<Embodiment** 4> **Manufacturing NCM-based positive active material**

In the same manner with Embodiment 1, a positive active material of Embodiment 4 was manufactured by executing a washing and coating process with 10 mol% concentration of a cobalt solution added to the positive active material washing liquid.

**<Experimental example> Measuring TEM and EDX**

FIG. 9 shows a result of measuring TEM and EDX photographs on the surface of the secondary particle of the positive active material manufactured through Embodiment 4.

As shown in FIG. 9, it can be seen that the positive active material manufactured through Embodiment 4 of the inventive concept has Co concentration that becomes higher on the surface of the secondary particle but turns to be lower as close as the center of the secondary particle. Thus, the Co concentration is ununiform in a grade.

Additionally, the EDX measurement shows a Co distribution of bar-shaped primary particle, from which it can be seen that Co concentration is measured as being higher at the periphery of the bar-shaped primary particle.

**<Experimental example> Concentration scanning**

FIG. 10 shows a result of measuring respective concentration variations of No, Co, and Al from the surface of a secondary particle of the positive active material, which is manufactured through Embodiment 4, toward the center of the particle.

From FIG. 10, it can be seen that the positive active material manufactured through Embodiment 4 of the inventive concept has Co concentration that becomes higher toward the center from the surface in the Co-coated layer where Co is coated, but after the Co-coated layer, the Co concentration turns to be reduced as close as the center and a thickness of the Co-coated layer is 0.14 $\mu$m.

**<Experimental example> Concentration scanning**

FIG. 11 shows a result of measuring respective concentration variations of No, Co, and Al from three spots on the surface of a secondary particle of the positive active material, which is manufactured through Embodiment 4, toward the center of the secondary particle.

From FIG. 11, it can be seen that three independent spots on the surface of the secondary particle of the positive active material manufactured through Embodiment 4 have thicknesses of 0.14 $\mu m$ that forms a uniform grade therein.

**<Experimental example> Measuring distances between crystalline structures**

FIG. 12 shows a result of measuring respective diffraction patterns and interplanar distances of primary particle locating in the internal part of a secondary particle of the positive active material manufactured through Embodiment 4 and locating on the surface where Co and Ti are coated.

As shown in FIG. 12, it was measured that a thickness of the Co-coated layer was about 140 nm, a diffraction pattern of the primary particle locating in a secondary particle was in a hexagonal structure, and interplanar distance of the primary particle locating in the secondary particle was measured as 4.85 nm, while the primary particle locating on the surface part, which was coated with Co and Ti, had a diffraction pattern of hexagonal structure but its interplanar distance thereof was measured as 4.69 nm.

It can be seen that, comparative to the primary particle locating in the Co-uncoated secondary particle, the interplanar distance of the primary particle locating on the Co-coated surface was reduced and changed similar to the interplanar distance of $LiCoO_2$ of a comparison example.

**<Experimental example> Measuring interplanar distances between crystalline structures at coated layer boundary**

FIG. 13 shows a result of measuring a diffraction pattern and interplanar distances from a boundary between the inside of a primary particle, which locates on the surface part of a secondary particle of the positive active material manufactured through Embodiment 4, and a coated layer in the primary particle locating on the surface part of the secondary particle.

As shown in FIG. 13, from the boundary between the inside of the primary particle, which locates on the surface of the secondary particle of the positive active material manufactured through Embodiment 4, and the coated layer, which is coated with Co and Ti, in the primary particle locating on the surface part of the secondary particle, the diffraction pattern was in a hexagonal structure and the interplanar distances were measured as 4.71 nm on average.

It can be seen that, comparative to the primary particle locating in the secondary particle has an interplanar distance of 4.85 nm and the primary particle locating on the surface part of the secondary particle, which is coated with Co and Ti, has an interplanar distance of 4.69 nm, the interplanar distance of the coated layer boundary in the primary particle locating on the surface part of the secondary particle coated with Co and Ti, that is, 4.71 nm, was measured as an intermediate value between the interplanar distance of the primary particle locating in the internal part of secondary particle and the interplanar distance of the primary particle locating on the surface part of the secondary particle which is coated with Co and Ti.

Additionally, it can be seen that the interplanar distance of the primary particle at the coated layer boundary was changed similar to the interplanar distance of $LiCoO_2$ of a comparison example.

**<Experimental example> Measuring interplanar distances between crystalline structures at boundary of primary particle**

FIG. 14 shows diffraction patterns and interplanar distances at boundaries of a primary particle locating on the surface part of a secondary particle, which is coated with Co and Ti, of the positive active material manufactured through Embodiment 4.

As shown in FIG. 14, from the boundaries of the primary particle locating on the surface part of the secondary particle of the positive active material, the diffraction patterns are in a hexagonal structure and the interplanar distances are measured as 4.69 nm and 4.71 nm as an intermediate value of interplanar distances between a core part and a coated layer part.

Additionally, it can be seen that the interplanar distance of the primary particle at the coated layer boundary was changed similar to the interplanar distance of $LiCoO_2$ of a comparison example.

**<Embodiment 5> Manufacturing positive active material**

In the same manner with Embodiment 1, a positive active material of Embodiment 5 was manufactured by manufacturing a lithium secondary battery positive active material, which had been processed through the first thermal treatment, in the composition of $Li_{1.02}Ni_{0.816}Co_{0.15}Al_{0.034}O_2$ without addition of Ti.

**<Embodiment 6> Manufacturing positive active material**

In the same manner with Embodiment 1, a positive active material of Embodiment 6 was manufactured by manufacturing a lithium secondary battery positive active material, which had been processed through the first thermal treatment, in the composition of $Li_{1.02}Ni_{0.903}Co_{0.08}Al_{0.014}Mg_{0.003}O_2$.

**<Embodiment 7> Manufacturing positive active material**

In the same manner with Embodiment 1, a positive active material of Embodiment 7 was manufactured by manufacturing a lithium secondary battery positive active material, which had been processed through the first thermal treatment, in the composition of $Li_{1.00}Ni_{0.965}Co_{0.02}Al_{0.014}Mg_{0.001}O_2$.

**<Embodiment 8> Manufacturing positive active material**

In the same manner with Embodiment 7, a positive active material of Embodiment 8 was manufactured by executing a coating process with 4 mol% concentration of a cobalt solution which was added to the positive active material washing liquid.

**<Embodiment 9> Manufacturing positive active material**

In the same manner with Embodiment 7, a positive active material of Embodiment 9 was manufactured by executing a coating process with 5 mol% concentration of a cobalt solution which was added to the positive active material washing liquid.

**<Embodiment 10> Manufacturing positive active material**

In the same manner with Embodiment 7, a positive active material of Embodiment 10 was manufactured by manufacturing a lithium secondary battery positive active material, which had been processed through the first thermal treatment, in the composition of $Li_{1.00}Ni_{0.985}Al_{0.014}Mg_{0.001}O_2$.

The final formulas of compositions used in Embodiments 1 to 10 are summarized in Table 1 as follows.

[Table 1]

| | Final Composition Formula |
|---|---|
| | $Li_{x1}Ni_{1-(X1+y1+z1)}Co_{x1}M1_{y1}M2_{z1}M3_{r1}O_a$ |
| Embodiment 1 | $Li_{1.01}Ni_{0.903}Co_{0.08}Al_{0.015}Mg_{0.001}Ti_{0.001}O_2$ |
| Embodiment 2 | $Li_{1.01}Ni_{0.893}Co_{0.09}Al_{0.015}Mg_{0.001}Ti_{0.001}O_2$ |
| Embodiment 3 | $Li_{1.02}Ni_{0.883}Co_{0.10}Al_{0.015}Mg_{0.001}Ti_{0.001}O_2$ |
| Embodiment 4 | $Li_{1.02}Ni_{0.833}Co_{0.10}Al_{0.015}Mg_{0.001}Ti_{0.001}O_2$ |
| Embodiment 5 | $Li_{1.02}Ni_{0.786}Co_{0.18}Al_{0.034}O_2$ |
| Embodiment 6 | $Li_{1.02}Ni_{0.873}Co_{0.11}Al_{0.015}Mg_{0.001}Ti_{0.001}O_2$ |
| Embodiment 7 | $Li_{1.00}Ni_{0.933}Co_{0.05}Al_{0.015}Mg_{0.001}Ti_{0.001}O_2$ |
| Embodiment 8 | $Li_{1.00}Ni_{0.923}Co_{0.06}Al_{0.015}Mg_{0.003}Ti_{0.001}O_2$ |
| Embodiment 9 | $Li_{1.00}Ni_{0.913}Co_{0.07}Al_{0.015}Mg_{0.015}Ti_{0.001}O_2$ |
| Embodiment 10 | $Li_{1.00}Ni_{0.953}Co_{0.03}Al_{0.015}Mg_{0.001}Ti_{0.001}O_2$ |

**<Comparison 2>**

In the same manner with Embodiment 4, a positive active material of Comparison 2 was manufactured by injecting active material particles into a 0.1 mol cobalt solution, coating the active material with cobalt while agitating the mixture, and drying the coated material.

**<Comparison 3>**

In the same manner with Embodiment 4, a positive active material of Comparison 3 was manufactured, without including Co during a washing process, by excluding a Ti adding process and a second thermal treatment.

**<Experimental example> Measuring TEM and TDX**

FIG. 15 shows a result of measuring TEM and EDX photographs from the surface of a secondary particle of the positive active material manufactured through Comparison 2.

As shown in FIG. 15, it can be seen that the positive active material resulted in an uneven surface, without being doped into the inside, because there was no subsequent thermal treatment even though the Co distribution was concentrated on the surface due to the agitation with the active material particles which were injected into the cobalt solution.

**<Comparison 4>**

In the same manner with Comparison 3, a positive active material of Comparison 4 was manufactured by adding Ti with concentration of 0.001 mol and then executing a second thermal treatment.

**<Comparison 5>**

In the same manner with Comparison 3, a positive active material of Comparison 5 was prepared, without a washing process, after manufacturing a lithium secondary battery positive active material which had been processed through a first thermal treatment.

**<Comparison 6>**

In the same manner with Comparison 3, a positive active material of Comparison 6 was prepared by manufacturing a lithium secondary battery positive active material, which had been processed through a first thermal treatment, in the composition of $Li_{1.00}Ni_{0.815}Co_{0.15}Al_{0.014}O_2$.

**<Comparison 7>**

In the same manner with Comparison 4, a positive active material of Comparison 7 was prepared by manufacturing a lithium secondary battery positive active material, which had been processed through a first thermal treatment, in the composition of $Li_{1.02}Ni_{0.903}Co_{0.08}Al_{0.014}\ Mg_{0.003}O_2$.

**<Comparison 8>**

In the same manner with Comparison 4, a positive active material of Comparison 8 was prepared by manufacturing a lithium secondary battery positive active material, which had been processed through a first thermal treatment, in the composition of $Li_{1.00}Ni_{0.965}Co_{0.02}Al_{0.014}\ Mg_{0.001}O_2$.

**<Comparison 9>**

In the same manner with Comparison 4, a positive active material of Comparison 9 was prepared by manufacturing a lithium secondary battery positive active material, which had been processed through a first thermal treatment, in the composition of $Li_{1.00}Ni_{0.985}Al_{0.014}\ Mg_{0.001}O_2$.

The final formulas of compositions used in Comparisons 1 to 9 are summarized in Table 2 as follows.

The final formulas of compositions for the first baking processes of Comparisons 1 to 9 are summarized in Table 2 as follows.

[Table 2]

| | Final Composition Formula |
|---|---|
| | $Li_{X1}Ni_{1-(X1+y1+z1)}Co_{x1}M1_{y1}M2_{z1}M3_{r1}O_a$ |
| Comparison 1 | $LiCoO_2$ |
| Comparison 2 | Washed and dried product of Embodiment 4 |
| Comparison 3 | Washed and dried product of Comparison 4 |
| Comparison 4 | $Li_{1.00}Ni_{0.933}Co_{0.05}Al_{0.015}Mg_{0.001}Ti_{0.001}O_2$ |
| Comparison 5 | $Li_{1.05}Ni_{0.934}Co_{0.05}Al_{0.015}Mg_{0.001}Ti_{0.001}O_2$ (Unwashed product) |
| Comparison 6 | $Li_{1.00}Ni_{0.815}Co_{0.15}Al_{0.035}O_2$ |
| Comparison 7 | $Li_{1.02}Ni_{0.903}Co_{0.08}Al_{0.015}Mg_{0.001}Ti_{0.001}O_2$ |
| Comparison 8 | $Li_{1.00}Ni_{0.963}Co_{0.02}Al_{0.015}Mg_{0.001}Ti_{0.001}O_2$ |
| Comparison 9 | $Li_{1.00}Ni_{0.983}Co_{0.05}Al_{0.015}Mg_{0.001}Ti_{0.001}O_2$ |

**<Experimental example> Measuring TEM and TDX**

FIG. 16 shows a result of measuring TEM and EDX photographs from the surface of a secondary particle of the positive active material manufactured through Comparison 4.

As shown in FIG. 16, it can be seen that the positive active material manufactured through Comparison 4 has Co concentration uniformly distributed in the particle, because a Co coating process is not preformed after manufacturing an active material, and a Co concentration grade toward the inside of the particle is not found on the surface.

**<Experimental example> Measuring distances between crystalline structures**

FIG. 17 shows a result of measuring respective a diffraction pattern and interplanar distances from the surface of a secondary particle of the positive active material manufactured through Embodiment 4.

As shown in FIG. 17, a diffraction pattern of the surface was in a hexagonal structure and the interplanar distances were measured as 4.85 nm on average.

FIG. 18 shows a result of measuring a diffraction pattern and interplanar distances of a primary particle locating in a secondary particle of the positive active material manufactured through Comparison 4.

As shown in FIG. 18, it can be seen that the primary particle locating in the secondary particle of the positive active material has a diffraction pattern of hexagonal structure and interplanar distances of 4.83 nm on average. It can be also seen that, even with a second thermal treatment in the case without a Co coating process, the interplanar distance of the primary particle locating in the secondary particle of the positive active material is almost similar to that of a primary particle locating on the surface part of the secondary particle.

**<Experimental example> Measuring interplanar distances between crystalline structures at primary particle boundary**

FIG. 19 shows a result of measuring diffraction patterns and interplanar distances from a boundary of a primary particle locating on the surface part of a secondary particle of the positive active material manufactured through Embodiment 4.

As shown in FIG. 19, the primary particle locating on the surface part of the secondary particle of the positive active material was measured as having a diffraction pattern of hexagonal structure and interplanar distances of 4.81 nm on average.

Additionally, it can be seen from FIGS. 18 and 19 that, in the case without a Co coating process, diffraction patterns and interplanar distances are similar between the inside and the boundary of the primary particle.

**<Experimental example> Concentration scanning**

FIG. 20 shows a result of measuring respective concentration of Ni, Co, and Al toward the core from the surface of a secondary particle of the positive active material manufactured through Comparison 4.

From FIG. 20, it can be seen that the positive active material manufactured through Comparison 4 has uniform concentration of Ni, Co, and Al in the particle.

**<Experimental example> Concentration scanning**

FIG. 21 shows a result of measuring respective concentration of Ni, Co, and Al in a direction horizontal to the surface direction of a primary particle locating on the surface part of a secondary particle of the positive active material manufactured through Comparison 4.

From FIG. 21, it can be seen that the positive active material manufactured through Comparison 4 has uniform concentration of Ni, Co, and Al in the particle, without a Co concentration grade due to absence of a CO coating process, and interplanar distances thereof are also similar between the surface and the inside.

**<Experimental example> Measuring XRD**

Results of measuring XRD for $LiCoO_2$ positive active materials of Embodiment 4 and Comparison 1 are shown in FIGS. 22 and 23.

As shown in FIGS. 22 and 23, it can be seen that a Co and Ti coated positive active material, which is manufactured through Embodiment 4 of the inventive concept, is detected with peaks of (104), (110), (113), (101), (102), and (003) as like the case of $LiCoO_2$ of Comparison 1.

**<Experimental example> Measuring XRD**

A result of measuring XRD for a positive active material of Comparison 2 is shown in FIG. 24.

As shown in FIG. 24, it can be seen that the positive active material manufactured through Comparison 2 of the inventive concept is detected only with a peak by $Co(OH)_2$ but there are no detection with peaks of (104), (110), (113), (101), (102), and (003).

**<Experimental example> Measuring XRD**

FIG. 25 shows a result of measuring XRD for positive active materials manufactured through Comparison 4, which does not execute a Co coating process, and through Embodiment 4 executing a thermal treatment after a Co coating process.

As shown in FIG. 25, it can be seen that the positive active material manufactured through Comparison 4, which does not execute the Co coating process of the inventive concept, is not detected with peaks of (104), (110), (113), (101), (102), and (003) that are distinctly detected from $LiCoO_2$.

**<Experimental example> Measuring XPS**

FIG. 26 shows results of measuring XPS for positive active materials manufactured through Comparison 4, which does not execute a Co coating process, and through Embodiment 3 executing a coating process with a cobalt solution having concentration of 5 mol%.

As shown in FIG. 26, it can be seen that, in the case of coating cobalt during a washing process according to the inventive concept, the Co 2p peak intensity is larger, almost due to Co+3, than that of Comparison 4. Additionally, it can be also seen that the peak intensity by $Li_2CO_3$ is more reduced than that of Comparison 4.

**<Experimental example> Measuring residual lithium**

A result of measuring amounts of residual lithium from composite oxides manufactured through Embodiments 1 to 10 and Comparisons 4 to 9 is summarized in Table 3 as follows.

To measure residual lithium, an active material of 1g was precipitated in distilled water of 5g and agitated for 5 minutes. Next, filtrate was taken after the agitation and titration was executed with HCL of 0.1 M. Then, the residual lithium was analyzed by measuring a volume of the HCL until pH of the filtrate reaches 5.

From Table 3, it can be seen that active materials manufactured through embodiments of the inventive concept have residual lithium which is greatly reduced relative to the case as like as Comparison 5 that does not execute a baking process.

[Table 3]

| | Residual Lithium (ppm) | | |
|---|---|---|---|
| | LiOH | $Li_2CO_3$ | Total |
| Comparison 4 | 1043 | 1787 | 2830 |
| Comparison 5 | 7516 | 9733 | 17249 |
| Comparison 6 | 2628 | 987 | 3615 |
| Comparison 7 | 1017 | 1686 | 3396 |
| Comparison 8 | 1744 | 1622 | 3366 |
| Comparison 9 | 1856 | 2212 | 4068 |
| Embodiment 1 | 1506 | 1996 | 3502 |
| Embodiment 2 | 1432 | 1971 | 3403 |
| Embodiment 3 | 1562 | 1549 | 3111 |
| Embodiment 4 | 2142 | 2450 | 4592 |
| Embodiment 5 | 2556 | 862 | 3418 |
| Embodiment 6 | 1730 | 1830 | 3560 |
| Embodiment 7 | 1630 | 2166 | 3796 |
| Embodiment 8 | 2035 | 2433 | 4468 |
| Embodiment 9 | 1569 | 2067 | 3636 |
| Embodiment 10 | 2519 | 1881 | 4400 |

**<Manufacturing example> Manufacturing battery**

Slurry was manufactured by mixing the positive active materials, which were manufactured through Embodiments 1 to 10 and Comparisons 4, and 6 to 9, super-P as a conducting agent, and polyvinylidenefluoride (PVdF) as a binding agent in weight ratio of 92:5:3. Then an anode for a lithium secondary battery was manufactured by uniformly coating the slurry on an aluminum foil which has a thickness of 15 μm, and then by drying the slurry-coated aluminum foil at 135 °C under vacuum.

A coin battery was manufactured by using the anode and a lithium foil as the other electrode, using a porous polyethylene film (Celgard 2300 made by Celgard LLC; thickness of 25 *μm*) as a separator, and using a liquid electrolyte in which LiPF6 with concentration of 1.15 M was dissolved in a solvent in which ethylene carbonate and ethylmethyl carbonate are mixed in a volume ratio of 3:7.

**<Experimental example> Measuring battery characteristics - initial capacity**

Results of measuring initial capacities of batteries manufactured with active materials manufactured through Embodiments 1 to 10 and Comparisons 4, and 6 to 9 are respectively shown in FIG. 27A (Embodiments 1 to 4, Comparison 4), FIG. 27B (Embodiment 5, Comparison 6), FIG. 27C (Embodiment 6, Comparison 7), FIG. 27D (Embodiments 7 to 9, Comparison 8), and FIG. 27E (Embodiment 10, Comparison 9).

Referring to FIGS. 27A to 27E, the coating process executed according to the embodiments of the inventive concept contributed to the characteristics of capacity and efficiency that was measured as being more improved than that of a comparison examples.

Results of measuring initial capacities of batteries manufactured with active materials manufactured through Embodiments 1 to 10 and Comparisons 4, and 6 to 9 are summarized in Table 4 as follows.

[Table 4]

| | 0.1C Charge/Discharge | | |
|---|---|---|---|
| | Charge (mAh/g) | Discharge (mAh/g) | 1st Eff. (%) |
| Embodiment 1 | 242.2 | 215.9 | 89.1 |
| Embodiment 2 | 239.9 | 214.4 | 89.4 |
| Embodiment 3 | 239.0 | 215.0 | 90.0 |
| Embodiment 4 | 231.7 | 215.2 | 92.9 |
| Embodiment 5 | 213.9 | 194.1 | 90.8 |
| Embodiment 6 | 232.5 | 213.7 | 91.9 |
| Embodiment 7 | 248.9 | 222.3 | 89.3 |
| Embodiment 8 | 247.2 | 222.5 | 90.0 |
| Embodiment 9 | 245.1 | 220.9 | 90.1 |
| Embodiment 10 | 251.8 | 221.6 | 88.0 |
| Comparison 4 | 244.5 | 209.7 | 85.8 |
| Comparison 6 | 217.1 | 190.2 | 87.6 |
| Comparison 7 | 239.3 | 211.3 | 88.3 |
| Comparison 8 | 255.1 | 219.0 | 85.9 |
| Comparison 9 | 258.2 | 221.6 | 85.8 |

**<Experimental example> Measuring battery characteristics-efficiency**

Results of measuring efficiency characteristics of batteries manufactured with active materials manufactured through Embodiments 1 to 10 and Comparisons 4, and 6 to 9 are respectively shown in FIG. 28A (Embodiments 1 to 4, Comparison 4), FIG. 28B (Embodiment 5, Comparison 6), FIG. 28C (Embodiment 6, Comparison 7), FIG. 28D (Embodiments 7 to 9, Comparison 8), and FIG. 28E (Embodiment 10, Comparison 9).

Referring to FIGS. 28A to 28E, the coating process executed by the embodiments of the inventive concept contributed to making the characteristics of capacity and efficiency measured as being more improved than the comparison examples.

Results of measuring the efficiency characteristics of batteries manufactured with active materials manufactured through Embodiments 1 to 10 and Comparisons 4, and 6 to 9 are summarized in Table 5 as follows.

[Table 5]

| ITEM | 0.1C | 0.2C | 0.5C | 1.0C | 1.5C | 2.0C |
|---|---|---|---|---|---|---|
| Embodiment 1 | 100.0 % | 97.6% | 94.2 % | 91.8% | 90.2 % | 89.2 % |
| Embodiment 2 | 100.0 % | 97.8 % | 94.5 % | 92.3 % | 90.9% | 89.8 % |
| Embodiment 3 | 100.0 % | 97.7 % | 94.6% | 92.3 % | 90.7% | 89.6% |
| Embodiment 4 | 100.0 % | 97.9% | 94.5 % | 91.9% | 90.2% | 88.9 % |
| Embodiment 5 | 100.0 % | 98.9 % | 95.2 % | 92.2 % | 90.4 % | 89.0 % |
| Embodiment 6 | 100.0 % | 97.2 % | 93.0 % | 89.9 % | 88.4 % | 87.3 % |
| Embodiment 7 | 100.0 % | 96.9 % | 93.1 % | 90.2 % | 88.4 % | 86.8 % |
| Embodiment 8 | 100.0 % | 96.7 % | 92.5 % | 89.5 % | 87.4 % | 85.6 % |
| Embodiment 9 | 100.0 % | 97.0 % | 93.2 % | 90.5 % | 88.8 % | 87.4 % |
| Embodiment 10 | 100.0 % | 96.5 % | 92.7 % | 89.7 % | 87.1% | 84.4 % |
| Comparison 4 | 100.0 % | 97.3 % | 94.2% | 92.0 % | 90.6 % | 89.6 % |
| Comparison 6 | 100.0 % | 98.3% | 94.1 % | 91.1 % | 89.4 % | 88.2 % |
| Comparison 7 | 100.0 % | 96.3 % | 92.6 % | 89.4 % | 86.1 % | 82.5% |
| Comparison 8 | 100.0 % | 96.3 % | 92.6 % | 89.4 % | 86.1 % | 82.5 % |
| Comparison 9 | 100.0 % | 96.3 % | 92.6 % | 89.3 % | 85.9 % | 82.3 % |

**<Experimental example> Measuring battery characteristics-lifetime**

Results of measuring lifetime characteristics of batteries manufactured with active materials manufactured through Embodiments 1 to 10 and Comparisons 4, and 6 to 9 are respectively shown in FIG. 29A (Embodiments 1 to 4, Comparison 4), FIG. 29C (Embodiment 5, Comparison 6), FIG. 29C (Embodiment 6, Comparison 7), FIG. 29D (Embodiments 7 to 9, Comparison 8), and FIG. 29E (Embodiment 10, Comparison 9).

Referring to FIGS. 29A to 29E, the coating process executed according to the embodiments of the inventive concept contributed to making the characteristics of lifetime measured as being more improved than the comparison examples.

Results of measuring the lifetime characteristics of batteries manufactured with active materials manufactured through Embodiments 1 to 10 and Comparisons 4, and 6 to 9 are summarized in Table 6 as follows.

[Table 6]

| | Room Temperature Lifetime |
|---|---|
| | 50th / 1st (%) |
| Embodiment 1 | 77.4 |
| Embodiment 2 | 80.4 |
| Embodiment 3 | 78.9 |
| Embodiment 4 | 74.9 |
| Embodiment 5 | 89.5 |
| Embodiment 6 | 55.0 |
| Embodiment 7 | 54.6 |
| Embodiment 8 | 61.4 |

(continued)

| | Room Temperature Lifetime |
|---|---|
| | 50th / 1st (%) |
| Embodiment 9 | 63.3 |
| Embodiment 10 | 68.5 |
| Comparison 4 | 77.5 |
| Comparison 6 | 88.7 |
| Comparison 7 | 55.0 |
| Comparison 8 | 53.1 |
| Comparison 9 | 63.0 |

**<Experimental example> Measuring battery characteristics-high temperature storage**

As results of measuring high temperature storage characteristics of batteries manufactured with active materials manufactured through Embodiments 1 to 3 and 5 to 10, and Comparisons 4 and 6 to 9, the results before storage are respectively shown in FIG. 30A (Embodiments 1 to 3, Comparison 4), FIG. 30B (Embodiment 5, Comparison 6), FIG. 30C (Embodiment 6, Comparison 7), FIG. 30D (Embodiments 7 to 9, Comparison 8), and FIG. 30E (Embodiment 10, Comparison 9), and the results after storage are respectively shown in FIG. 31A (Embodiments 1 to 3, Comparison 4), FIG. 31B (Embodiment 5, Comparison 6), FIG. 31C (Embodiment 6, Comparison 7), FIG. 31D (Embodiments 7 to 9, Comparison 8), and FIG. 31E (Embodiment 10, Comparison 9).

Referring to FIGS. 30A to 30E and 31A to 31E, the coating process executed by the embodiments of the inventive concept contributed to greatly improving the high temperature storage characteristics because impedances after high temperature storage increased less than those of the comparison examples.

Results of measuring the high temperature storage characteristics of batteries manufactured with active materials manufactured through Embodiments 1 to 3, and 5 to 10 and Comparisons 4, and 6 to 9 are summarized in Table 7 as follows.

[Table 7]

| | High Temperature Storage (Ohm) | |
|---|---|---|
| | Before Storage | After Storage |
| Embodiment 1 | 4.5 | 16.1 |
| Embodiment 2 | 4.3 | 16.6 |
| Embodiment 3 | 4.3 | 13.1 |
| Embodiment 5 | 4.4 | 28.5 |
| Embodiment 6 | 6.2 | 6.7 |
| Embodiment 7 | 5.0 | 10.0 |
| Embodiment 8 | 4.5 | 8.6 |
| Embodiment 9 | 4.5 | 8.7 |
| Embodiment 10 | 7.2 | 28.4 |
| Comparison 4 | 20.8 | 40.3 |
| Comparison 6 | 10.0 | 96.2 |
| Comparison 7 | 21.9 | 60.6 |
| Comparison 8 | 348.9 | 656.0 |
| Comparison 9 | 434.5 | 498.0 |

According to embodiments of the inventive concept, it may be allowable to improve a secondary battery, which includes a lithium complex oxide, in the characteristics of capacity, resistance, and lifetime with different interplanar distances of crystalline structures between a primary particle locating on the surface part of a secondary particle and a primary particle locating in the internal part secondary particle by coating different elements and washing in the processes of forming precursors and/or an active material.

While the inventive concept has been described with reference to exemplary embodiments, it will be apparent to those skilled in the art that various changes and modifications may be made without departing from the scope of the appended claims. Therefore, it should be understood that the above embodiments are not limiting, but illustrative.

## Claims

1. A lithium complex oxide secondary particle which is formed by agglomeration of a plurality of primary particles and configured to satisfy a relation as follows:

<Relation> $d1 > d2$

wherein

d1 is an interplanar distance of a crystalline structure in a primary particle locating in the internal part of secondary particle among the plurality of primary particles measured from diffraction patterns, and
d2 is an interplanar distance of a crystalline structure in a primary particle locating on a surface part of the secondary particle relation measured from diffraction patterns,

wherein the interplanar distances d1 and d2 mean averages of 10 adjacent interplanar distances based on an interplanar distance of a part which is measured by TEM analysis, and wherein the interplanar distance between 10 consecutive adjacent oxide layers d1 is $\geq$ 4.8 nm and the interplanar distance between 10 consecutive adjacent oxide layers d2 is $\leq$ 4.75 nm; and
wherein the secondary particle is given by the following Formula 1:

[Formula 1] $Li_{X1}Ni_{1-(x1+y1+z1)}Co_{x1}M1_{y1}M2_{z1}M3_{r1}O_{a}$,

wherein in the Formula 1,

M1 is Mg, Al, or Mg and Al,
M2 is Co, and
M3 is Ti, and
wherein $0.95 \leq X1 \leq 1.05$, $1.50 \leq a \leq 2.1$, $0.02 \leq x1 \leq 0.25$, $0.01 \leq y1 \leq 0.20$, $0 \leq z1 \leq 0.20$, and $0 \leq r1 \leq 0.20$, and wherein the lithium complex oxide secondary particle has a hexagonal structure.

2. The lithium complex oxide secondary particle of claim 1, wherein a lithium ion pathway is formed toward the center from the surface of the secondary particle.

3. The lithium complex oxide secondary particle of claim 1, wherein the secondary particle has a bound energy (P1) of spin-orbit-spit 2p3/2 peak and a bound energy (P2) of 2p1/2 peak in a Co 2p core-level spectrometry obtained through XPS measurement, and
wherein the P1 and the P2 are ranged in $779eV \leq P1 \leq 780eV$ and $794eV \leq P2 \leq 795eV$.

4. The lithium complex oxide secondary particle of claim 1, wherein the secondary particle has a ratio of peak intensity ($I_{531}$) around 531 eV and peak intensity ($I_{528}$) around 528.5 eV during an O 1s core-level spectrometry that is obtained through XPS measurement, and
wherein the ratio is $I_{531}/I_{528} \leq 2$.

5. The lithium complex oxide secondary particle of claim 1, wherein the secondary particle has a ratio between peak intensity ($I_{289}$) around 289 eV and peak intensity ($I_{284}$) around 284.5 eV during a C 1s core-level spectrometry that is obtained through XPS measurement, and

wherein the ratio is $I_{289}/I_{284} \leq 0.9$.

6. A method of preparing a lithium complex oxide secondary particle of claim 1, the method comprising: manufacturing precursors of a lithium complex oxide secondary particle given by the following Formula 2:

[Formula 2] $Ni_{1-(x2+y2+z2)}Co_{x2}M1_{y2}M2_{z2}(OH)_2$,

wherein in Formula 2,

M1 is Mg, Al, or Mg and Al, and
M2 is Co, and
wherein $0 \leq x2 \leq 0.25$, $0 \leq y2 \leq 0.20$, and $0 \leq z2 \leq 0.20$;
reacting precursors of a lithium complex oxide secondary particle with a lithium compound and manufacturing a positive active material by first thermal treating the reactant;
washing the positive active material with distilled water or an alkaline solution;
reactively coating the washed positive active material with a solution containing M2 that is Co;
drying particles of the positive active material; and
mixing the dried positive active material with M3 that is a metal Ti and doping the metal M3 into the particles by second thermally treating the mixture.

7. The method of claim 6, wherein the reactively coating comprises: reactively coating the washed positive active material with the solution including Co.

8. A lithium secondary battery comprising a lithium complex oxide secondary particle of any one of claims 1 to 7.

9. The lithium secondary battery of claim 8, wherein the lithium secondary battery has residual lithium equal to or smaller than 6,000 ppm, wherein the residual lithium is measured by precipitating 1 g of active material in 5 g distilled water and agitating for 5 minutes, followed by taking the filtrate after the agitation and performing titration with 0.1 M HCl, whereupon the residual lithium is analyzed by measuring a volume of the HCl until pH of the filtrate reaches 5.

**Patentansprüche**

1. Ein Lithiumkomplexoxid-Sekundärteilchen, das durch Agglomeration einer Mehrzahl von Primärteilchen gebildet und so konfiguriert ist, dass eine Relation wie folgt erfüllt ist:

<Relation> $d1 > d2$

wobei

d1 ein interplanarer Abstand einer kristallinen Struktur in einem Primärteilchen ist, das sich im inneren Teil des Sekundärteilchens unter der Mehrzahl von Primärteilchen befindet, gemessen aus Beugungsmustern, und
d2 ein interplanarer Abstand einer kristallinen Struktur in einem Primärteilchen ist, das sich auf einem Oberflächenteil des Sekundärteilchens der Relation befindet, gemessen aus Beugungsmustern,

wobei die interplanaren Abstände d1 und d2 Mittelwerte von 10 benachbarten interplanaren Abständen bedeuten, basierend auf einem interplanaren Abstand eines Teils, der durch TEM-Analyse gemessen wird, und wobei der interplanare Abstand zwischen 10 aufeinanderfolgenden benachbarten Oxidschichten $d1 \geq 4{,}8$ nm und der interplanare Abstand zwischen 10 aufeinanderfolgenden benachbarten Oxidschichten $d2 \leq 4{,}75$ nm beträgt; und wobei das Sekundärteilchen durch die folgende Formel 1 dargestellt ist:

[Formel 1] $Li_{X1}Ni_{1-(x1+y1+z1)}Co_{x1}M1_{y1}M2_{z1}M3_{r1}O_a$,

wobei in Formel 1

M1 gleich Mg, Al oder Mg und Al ist,
M2 gleich Co ist und

M3 gleich Ti ist, und
wobei $0,95 \leq X1 \leq 1,05$, $1,50 \leq a \leq 2,1$, $0,02 \leq x1 \leq 0,25$, $0,01 \leq y1 \leq 0,20$, $0 \leq z1 \leq 0,20$ und $0 \leq r1 \leq 0,20$, und wobei das Lithiumkomplexoxid-Sekundärteilchen eine hexagonale Struktur aufweist.

**2.** Das Lithiumkomplexoxid-Sekundärteilchen nach Anspruch 1, wobei von der Oberfläche des Sekundärteilchens ein Lithiumionenpfad zum Zentrum gebildet ist.

**3.** Das Lithiumkomplexoxid-Sekundärteilchen nach Anspruch 1, wobei das Sekundärteilchen eine gebundene Energie (P1) des 2p3/2-Peaks der Spin-Bahn-Aufspaltung und eine gebundene Energie (P2) des 2p1/2-Peaks in einer Co 2p-Core-Level-Spektrometrie, erhalten durch XPS-Messung, aufweist und
wobei die P1 und die P2 in einem Bereich von $779 \text{ eV} \leq P1 \leq 780 \text{ eV}$ und $794 \text{ eV} \leq P2 \leq 795 \text{ eV}$ liegen.

**4.** Das Lithiumkomplexoxid-Sekundärteilchen nach Anspruch 1, wobei das Sekundärteilchen ein Verhältnis der Peakintensität ($I_{531}$) um 531 eV und der Peakintensität ($I_{528}$) um 528,5 eV während einer O 1s-Core-Level-Spektrometrie, die durch XPS-Messung erhalten wird, aufweist und
wobei das Verhältnis $I_{531}/I_{528} \leq 2$ ist.

**5.** Das Lithiumkomplexoxid-Sekundärteilchen nach Anspruch 1, wobei das Sekundärteilchen ein Verhältnis zwischen Peakintensität ($I_{289}$) um 289 eV und Peakintensität ($I_{284}$) um 284,5 eV während einer C 1s-Core-Level-Spektrometrie, die durch XPS-Messung erhalten wird, aufweist und
wobei das Verhältnis $I_{289}/I_{284} \leq 0,9$ ist.

**6.** Ein Verfahren zur Herstellung eines Lithiumkomplexoxid-Sekundärteilchens von Anspruch 1, wobei das Verfahren umfasst:
Herstellen von Vorläufern eines Lithiumkomplexoxid-Sekundärteilchens, die durch die folgende Formel 2 dargestellt sind:

[Formel 2] $$Ni_{1-(x2+y2+z2)}Co_{x2}M1_{y2}M2_{z2}(OH)_2,$$

wobei in Formel 2

M1 gleich Mg, Al oder Mg und Al ist und
M2 gleich Co ist, und
wobei $0 \leq x2 \leq 0,25$, $0 \leq y2 \leq 0,20$ und $0 \leq z2 \leq 0,20$;
Umsetzen der Vorläufer eines Lithiumkomplexoxid-Sekundärteilchens mit einer Lithiumverbindung und Herstellen eines positiven aktiven Materials durch eine erste thermische Behandlung des Reaktanten;
Waschen des positiven aktiven Materials mit destilliertem Wasser oder einer Alkalilösung;
reaktives Beschichten des gewaschenen positiven aktiven Materials mit einer Lösung, die M2 enthält, welches Co ist;
Trocknen der Teilchen des positiven aktiven Materials; und
Mischen des getrockneten positiven aktiven Materials mit M3, das ein Metall Ti ist, und Dotieren des Metalls M3 in die Teilchen durch eine zweite thermische Behandlung des Gemischs.

**7.** Das Verfahren nach Anspruch 6, wobei das reaktive Beschichten umfasst: reaktives Beschichten des gewaschenen positiven aktiven Materials mit der Lösung, die Co enthält.

**8.** Eine Lithium-Sekundärbatterie, umfassend ein Lithiumkomplexoxid-Sekundärteilchen nach einem der Ansprüche 1 bis 7.

**9.** Die Lithium-Sekundärbatterie nach Anspruch 8, wobei die Lithium-Sekundärbatterie ein Restlithium gleich oder kleiner als 6.000 ppm aufweist, wobei das Restlithium gemessen wird, indem 1 g aktives Material in 5 g destilliertem Wasser ausgefällt und 5 Minuten lang gerührt wird, gefolgt durch Entnehmen des Filtrats nach dem Rühren und Durchführen einer Titration mit 0,1 M HCl, woraufhin das Restlithium durch Messen eines Volumens des HCl, bis der pH-Wert des Filtrats 5 erreicht, analysiert wird.

## Revendications

1. Particule secondaire en oxyde complexe de lithium qui est formée par agglomération d'une pluralité de particules primaires et configurée pour satisfaire à la relation qui suit :

<Relation> $d1 > d2$

dans laquelle

d1 est la distance interplanaire d'une structure cristalline dans une particule primaire localisée dans la partie interne de la particule secondaire parmi la pluralité de particules primaires, mesurée à partir de spectres de diffraction, et
d2 est la distance interplanaire d'une structure cristalline dans une particule primaire localisée sur une partie de surface de la particule secondaire de la relation, mesurée à partir de spectres de diffraction, dans laquelle les distances interplanaires d1 et d2 sont des moyennes de 10 distances interplanaires adjacentes basées sur la distance interplanaire d'une partie qui est mesurée par analyse MET,

et dans laquelle la distance interplanaire entre 10 couches d'oxyde adjacentes consécutives d1 est ≥ 4,8 nm et la distance interplanaire entre 10 couches d'oxyde adjacentes consécutives d2 est ≤ 4,75 nm ; et
dans laquelle la particule secondaire est donnée par la formule 1 qui suit :

[Formule 1] $Li_{X1}Ni_{1-(x1+y1+z1)}Co_{x1}Ml_{y1}M2_{z1}M3_{r1}O_a$,

dans laquelle, dans la formule 1,

M1 est Mg, Al, ou Mg et Al,
M2 est Co, et
M3 est Ti, et
dans laquelle $0{,}95 \leq X1 \leq 1{,}05$, $1{,}50 \leq a \leq 2{,}1$, $0{,}02 \leq x1 \leq 0{,}25$, $0{,}01 \leq y1 \leq 0{,}20$, $0 \leq z1 \leq 0{,}20$, et $0 \leq r1 \leq 0{,}20$, et laquelle particule secondaire en oxyde complexe de lithium a une structure hexagonale.

2. Particule secondaire en oxyde complexe de lithium selon la revendication 1, dans laquelle un chemin d'ions lithium est formé en direction du centre à partir de la surface de la particule secondaire.

3. Particule secondaire en oxyde complexe de lithium selon la revendication 1, laquelle particule secondaire a une énergie liée (P1) de pic spin-orbite de flèche 2p3/2 et une énergie liée (P2) de pic 2p1/2 dans une spectrométrie de niveau cœur Co 2p obtenue par mesure XPS, et dans laquelle les P1 et P2 sont situées dans les plages 779 eV ≤ P1 ≤ 780 eV et 794 eV ≤ P2 ≤ 795 eV.

4. Particule secondaire en oxyde complexe de lithium selon la revendication 1, laquelle particule secondaire a un rapport de l'intensité de pic ($I_{531}$) aux alentours de 531 eV à l'intensité de pic ($I_{528}$) aux alentours de 528,5 eV durant une spectrométrie de niveau cœur O 1s qui est obtenue par mesure XPS, et
dans laquelle le rapport est $I_{531}/I_{528} \leq 2$.

5. Particule secondaire en oxyde complexe de lithium selon la revendication 1, laquelle particule secondaire a un rapport de l'intensité de pic ($I_{289}$) aux alentours de 289 eV à l'intensité de pic ($I_{284}$) aux alentours de 284,5 eV durant une spectrométrie de niveau cœur C 1s qui est obtenue par mesure XPS, et
dans laquelle le rapport est $I_{289}/I_{284} \leq 0{,}9$.

6. Procédé de préparation d'une particule secondaire en oxyde complexe de lithium de la revendication 1, le procédé comprenant :
la fabrication de précurseurs d'une particule secondaire en oxyde complexe de lithium représentés par la formule 2 qui suit :

[Formule 2] $Ni_{1-(x2+y2+z2)}CO_{x2}M1_{y2}M2_{z2}(OH)_2$

dans lequel, dans la formule 2,

M1 est Mg, Al, ou Mg et Al, et
M2 est Co, et
dans lequel $0 \leq x2 \leq 0,25$, $0 \leq y2 \leq 0,20$, et $0 \leq z2 \leq 0,20$ ;
la réaction des précurseurs d'une particule secondaire en oxyde complexe de lithium avec un composé du lithium, et la fabrication d'un matériau actif positif par un premier traitement thermique du réactif ;
le lavage du matériau actif positif avec de l'eau distillée ou une solution alcaline ;
le revêtement réactif du matériau actif positif lavé avec une solution contenant M2 qui est Co ;
le séchage des particules du matériau actif positif ; et
le mélange du matériau actif positif séché avec M3 qui est du Ti métallique et le dopage du métal M3 dans les particules par un deuxième traitement thermique du mélange.

**7.** Procédé selon la revendication 6, dans lequel le revêtement réactif comprend : le revêtement réactif du matériau actif positif lavé avec la solution contenant du Co.

**8.** Batterie rechargeable au lithium comprenant une particule secondaire en oxyde complexe de lithium de l'une quelconque des revendications 1 à 7.

**9.** Batterie rechargeable au lithium selon la revendication 8, laquelle batterie rechargeable au lithium a 6 000 ppm ou moins de lithium résiduel, dans laquelle le lithium résiduel est mesuré par précipitation de 1 g de matériau actif dans 5 g d'eau distillée et agitation pendant 5 minutes, opération suivie de la prise du filtrat après l'agitation et de la mise en œuvre d'un titrage avec du HCl 0,1 M, suite à quoi le lithium résiduel est analysé par mesure du volume du HCl jusqu'à ce que le pH du filtrat atteigne 5.

Fig. 1

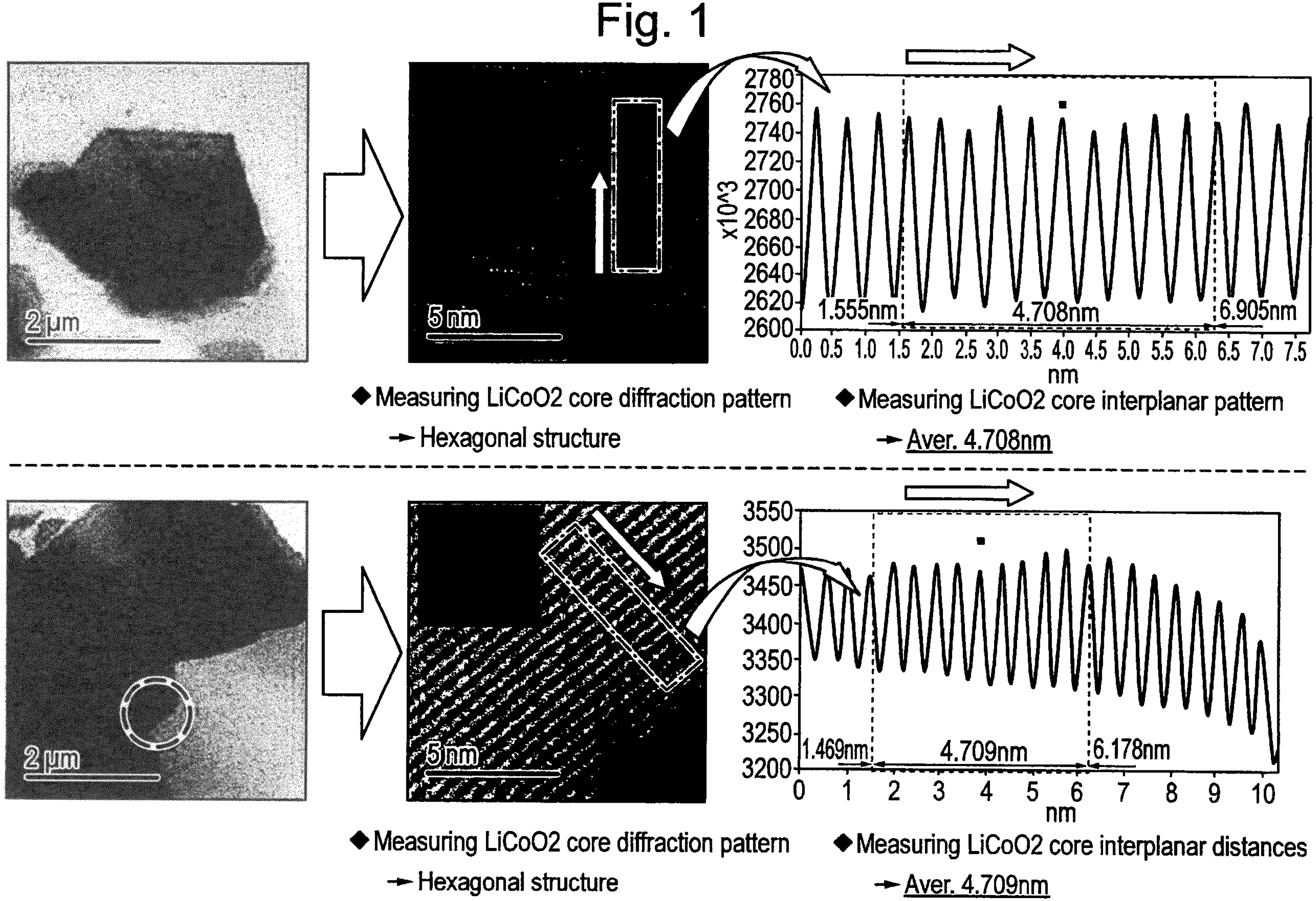
2 μm
5 nm
x10^3
2780
2760
2740
2720
2700
2680
2660
2640
2620
2600
0.0 0.5 1.0 1.5 2.0 2.5 3.0 3.5 4.0 4.5 5.0 5.5 6.0 6.5 7.0 7.5
nm
1.555nm
4.708nm
6.905nm
◆Measuring LiCoO2 core diffraction pattern
→ Hexagonal structure
◆Measuring LiCoO2 core interplanar pattern
→ Aver. 4.708nm
2 μm
5 nm
3550
3500
3450
3400
3350
3300
3250
3200
0 1 2 3 4 5 6 7 8 9 10
nm
1.469nm
4.709nm
6.178nm
◆Measuring LiCoO2 core diffraction pattern
→ Hexagonal structure
◆Measuring LiCoO2 core interplanar distances
→ Aver. 4.709nm

Fig. 2

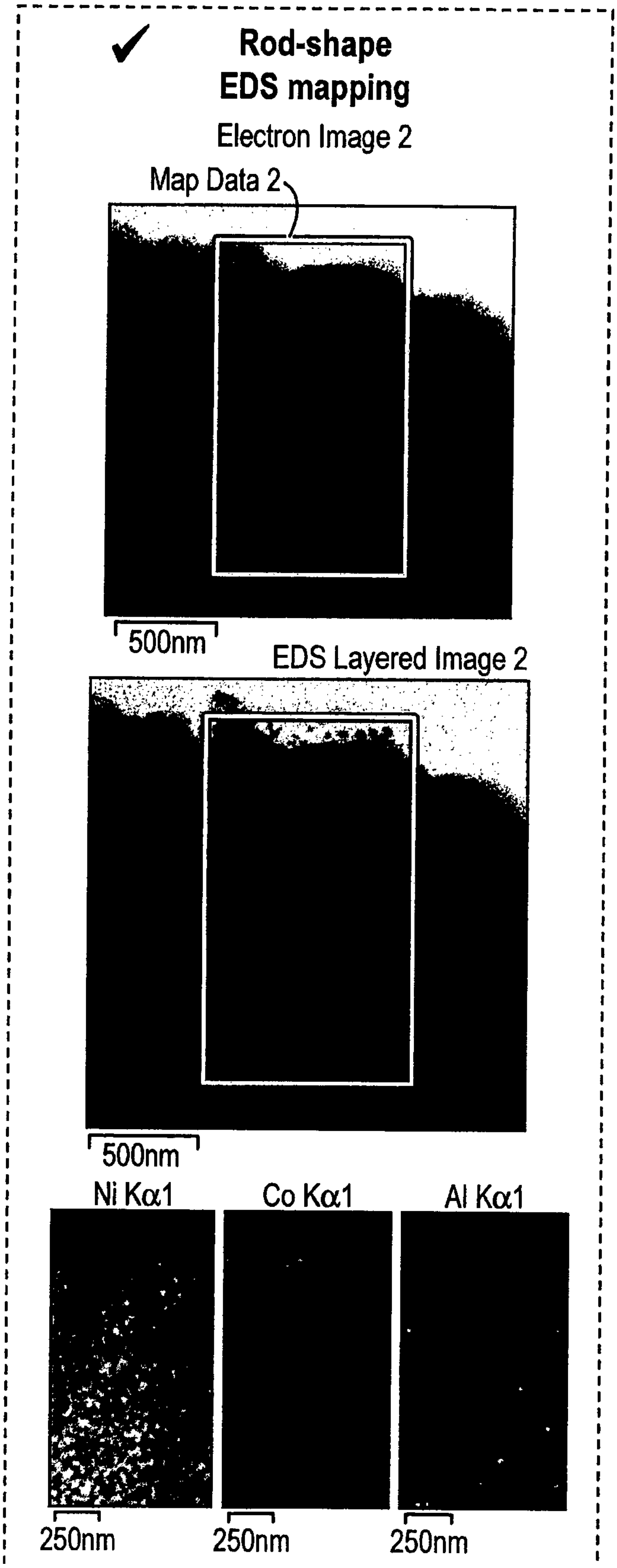
✓ Rod-shape
EDS mapping
Electron Image 2
Map Data 2
500nm
EDS Layered Image 2
500nm
Ni Kα1
Co Kα1
Al Kα1
250nm
250nm
250nm

Fig. 3

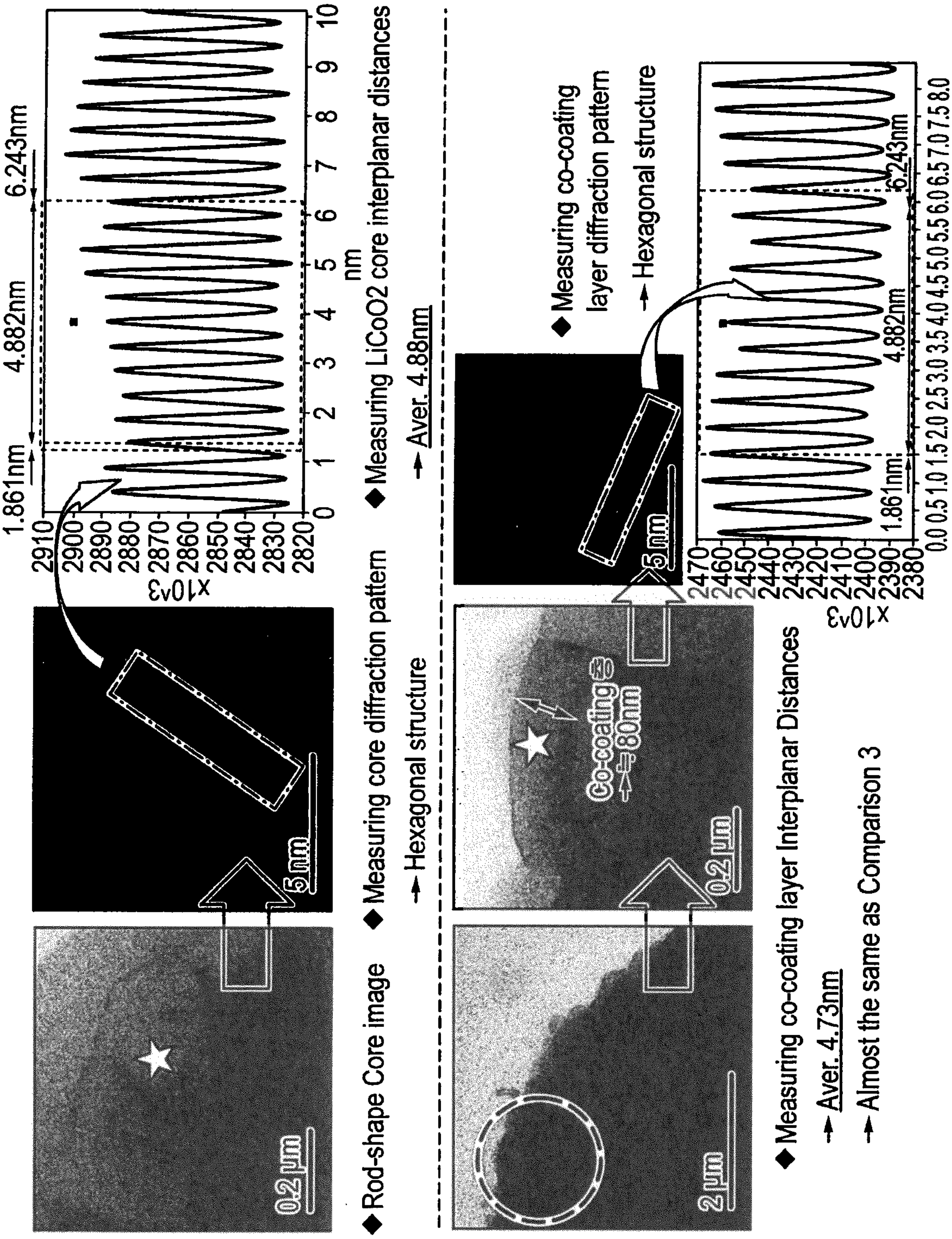
0.2 μm
5 nm
◆ Rod-shape Core image
◆ Measuring core diffraction pattern
→ Hexagonal structure
x10^3
1.861nm
4.882nm
6.243nm
nm
◆ Measuring LiCoO2 core interplanar distances
→ Aver. 4.88nm
2 μm
0.2 μm
Co-coating ≒ 80nm
5 nm
◆ Measuring co-coating layer Interplanar Distances
→ Aver. 4.73nm
→ Almost the same as Comparison 3
◆ Measuring co-coating layer diffraction pattern
→ Hexagonal structure

Fig. 4

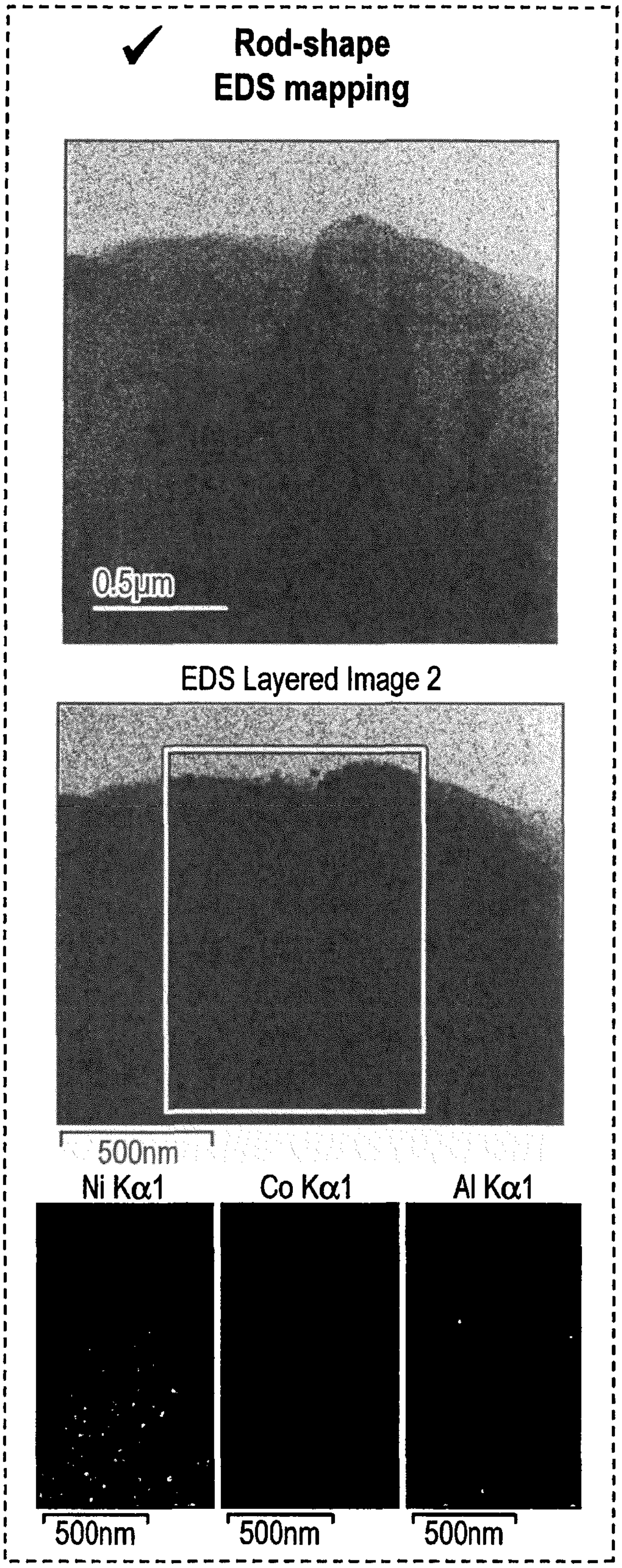
✔ Rod-shape
EDS mapping
0.5μm
EDS Layered Image 2
500nm
Ni Kα1
Co Kα1
Al Kα1
500nm
500nm
500nm

Fig. 5

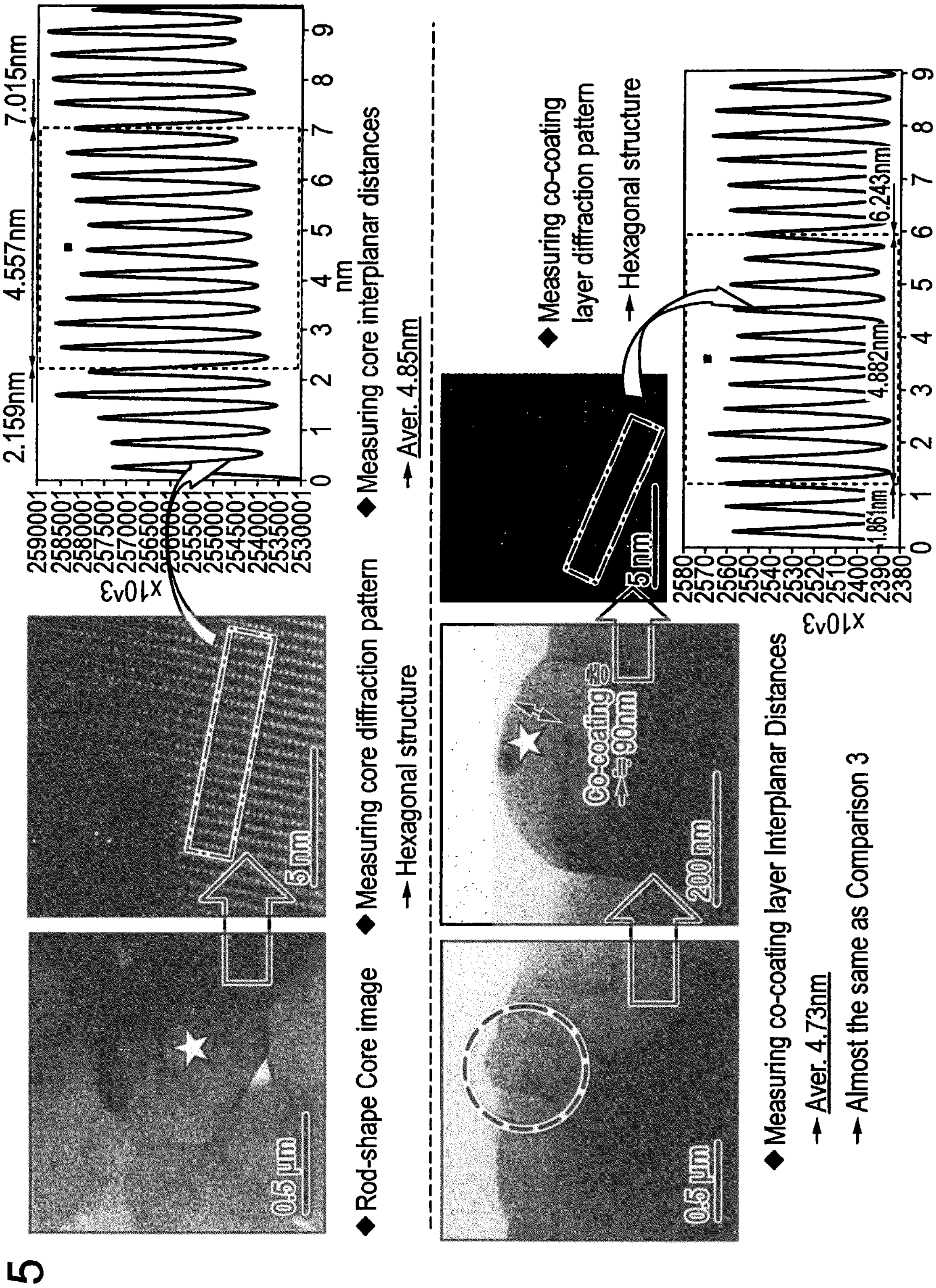
0.5 µm
5 nm
x10^3
2.159nm
4.557nm
7.015nm
nm
Rod-shape Core image
Measuring core diffraction pattern
→ Hexagonal structure
Measuring core interplanar distances
→ Aver. 4.85nm
0.5 µm
200 nm
Co-coating 층 ≒90nm
5 nm
Measuring co-coating layer diffraction pattern
→ Hexagonal structure
1.861nm
4.882nm
6.243nm
x10^3
Measuring co-coating layer Interplanar Distances
→ Aver. 4.73nm
→ Almost the same as Comparison 3

Fig. 6

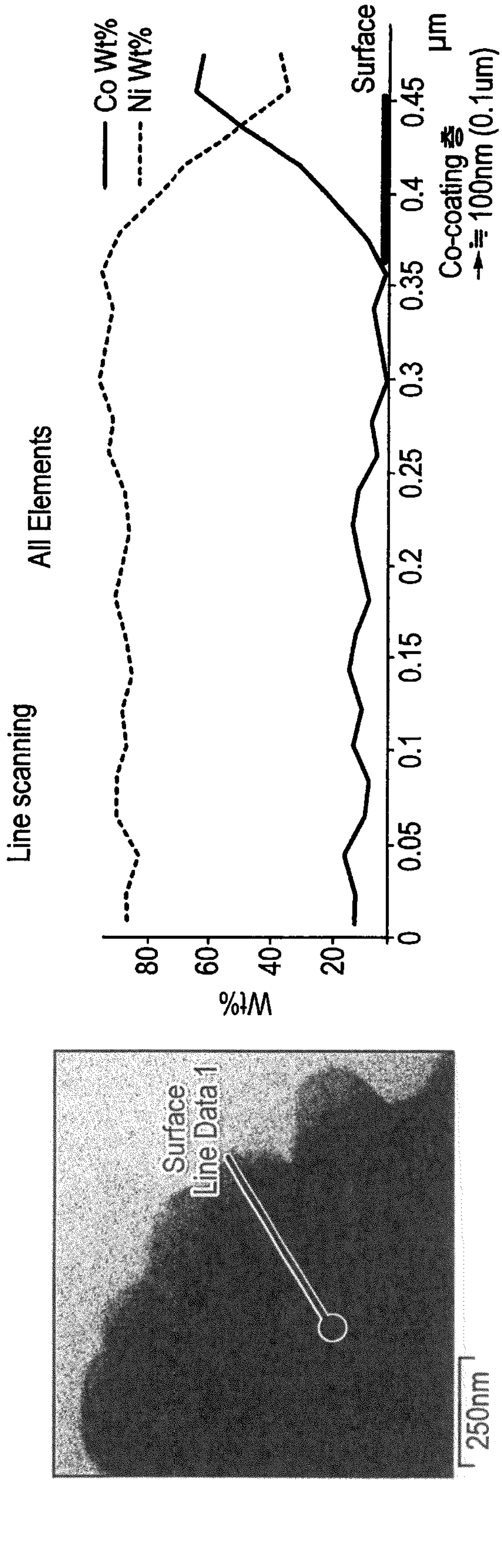
Line scanning
All Elements
Co Wt%
Ni Wt%
Wt%
80
60
40
20
0
0.05
0.1
0.15
0.2
0.25
0.3
0.35
0.4
0.45
μm
Surface
Co-coating 층
→ ≒ 100nm (0.1um)
Surface
Line Data 1
250nm

Fig. 7

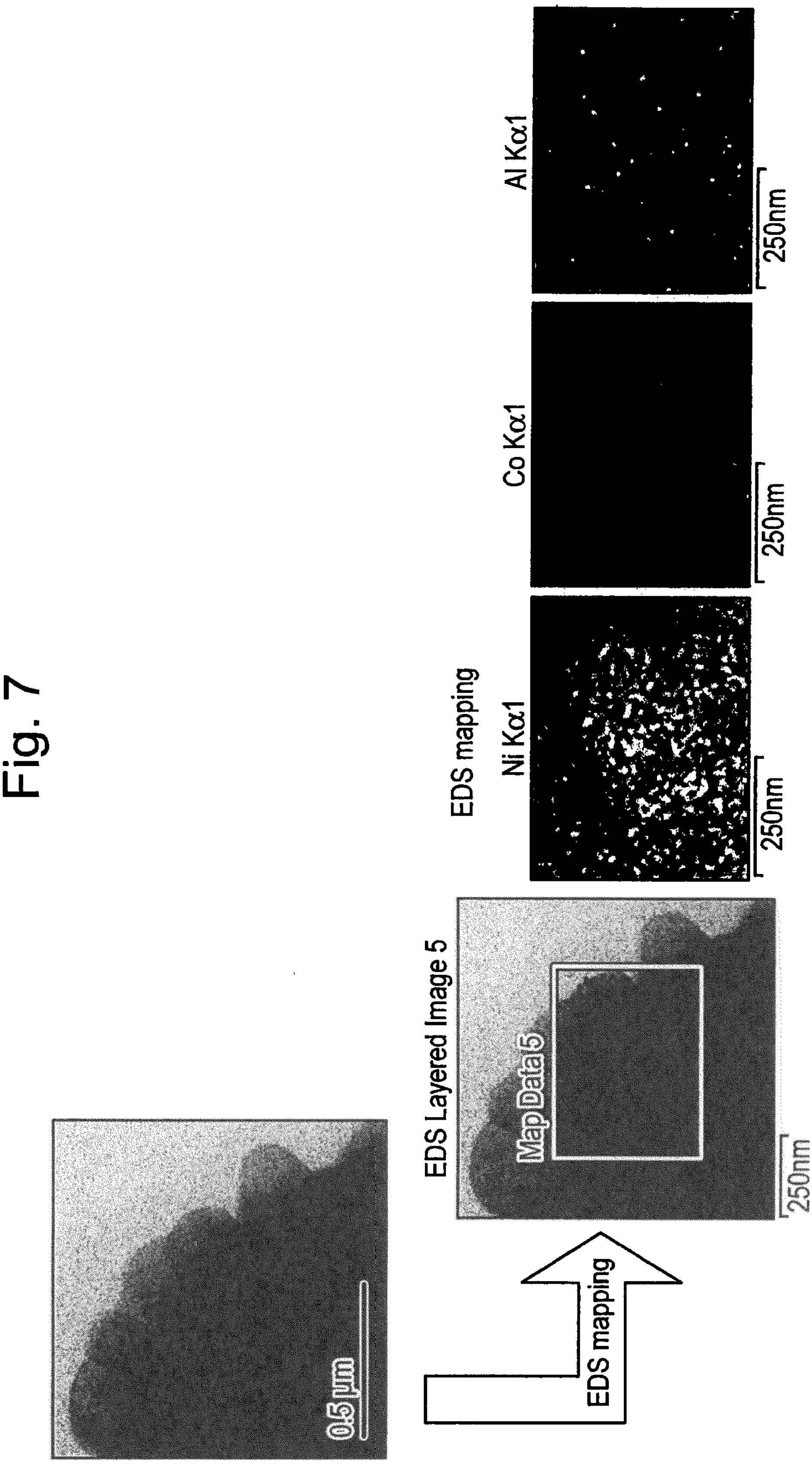

0.5 µm
EDS mapping
EDS Layered Image 5
Map Data 5
250nm
EDS mapping
Ni Kα1
250nm
Co Kα1
250nm
Al Kα1
250nm

Fig. 8

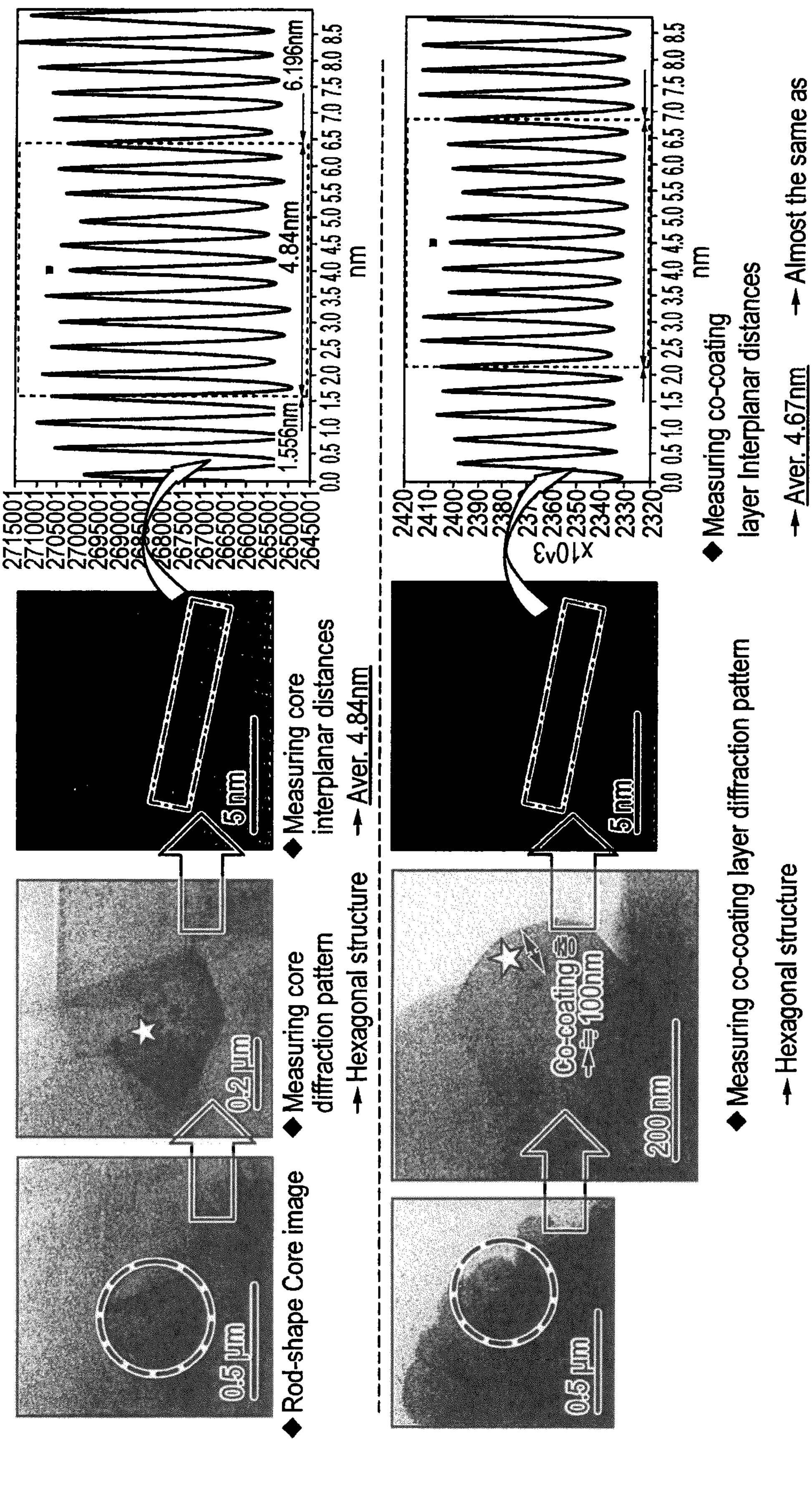
0.5 μm
◆Rod-shape Core image
0.2 μm
◆Measuring core diffraction pattern
→Hexagonal structure
5 nm
◆Measuring core interplanar distances
→ Aver. 4.84nm
1.556nm
4.84nm
6.196nm
nm
0.5 μm
200 nm
Co-coating ≒100nm
◆Measuring co-coating layer diffraction pattern
→Hexagonal structure
5 nm
x10^3
nm
◆Measuring co-coating layer Interplanar distances
→ Aver. 4.67nm
→Almost the same as Comparison 3

Fig. 9

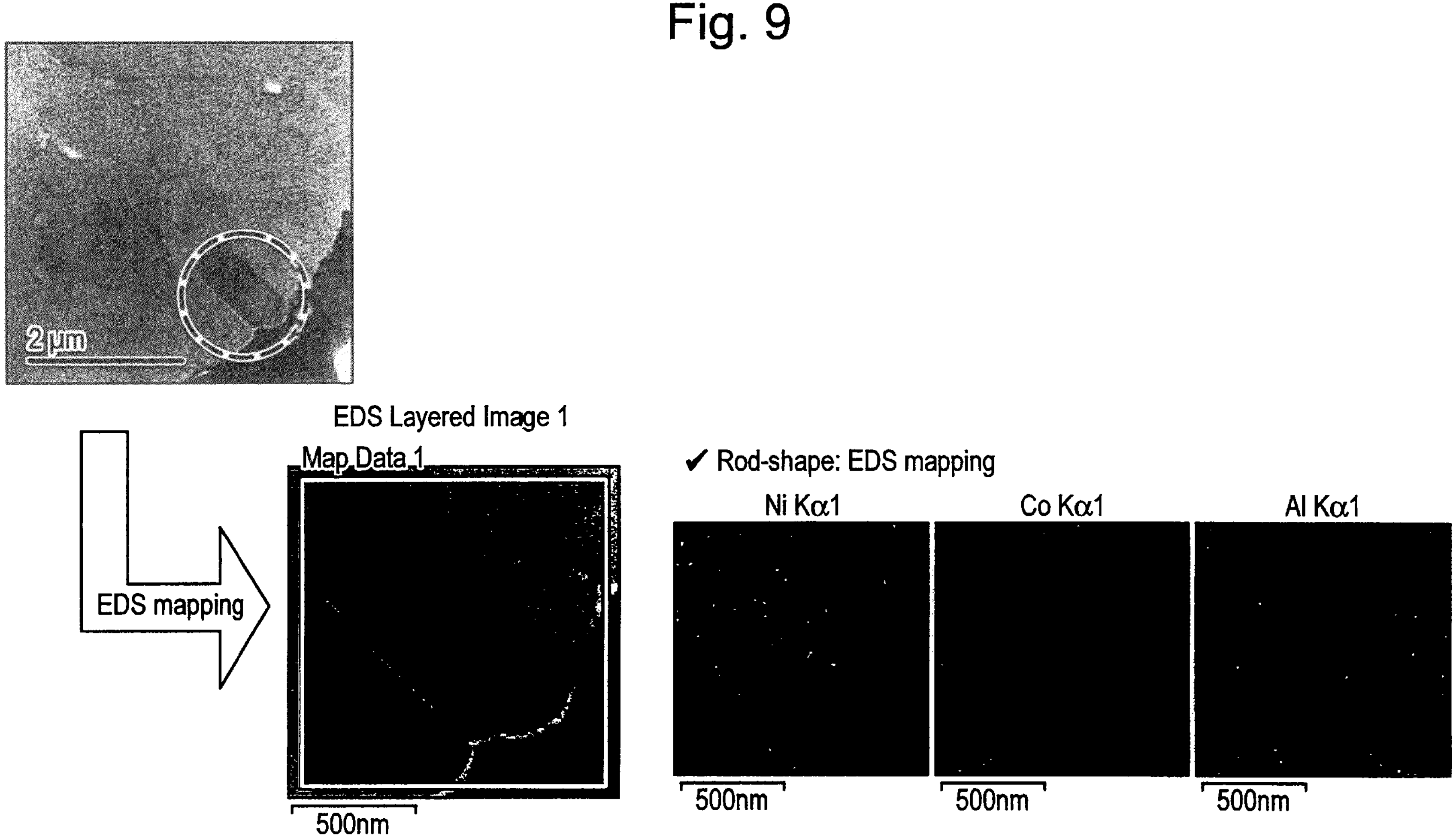
2 μm
EDS mapping
EDS Layered Image 1
Map Data 1
500nm
✔ Rod-shape: EDS mapping
Ni Kα1
Co Kα1
Al Kα1
500nm
500nm
500nm

Fig. 10

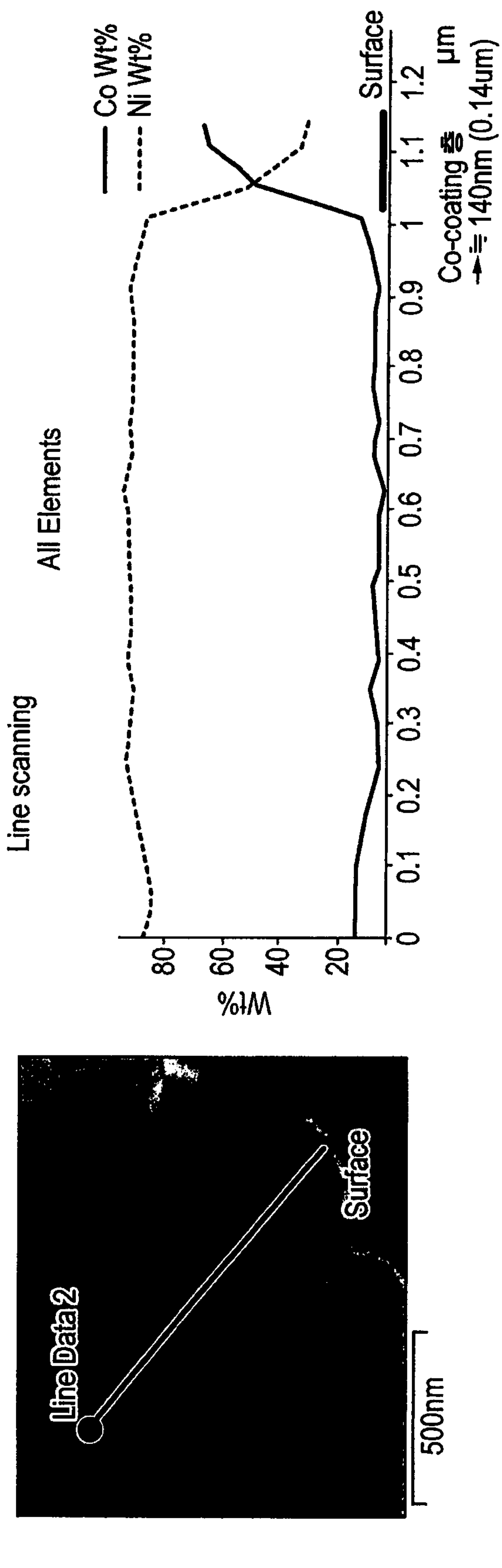
Line scanning
All Elements
Co Wt%
Ni Wt%
Wt%
80
60
40
20
0
0.1
0.2
0.3
0.4
0.5
0.6
0.7
0.8
0.9
1
1.1
1.2
μm
Surface
Co-coating 층
≒140nm (0.14um)
Line Data 2
Surface
500nm

# Fig. 11

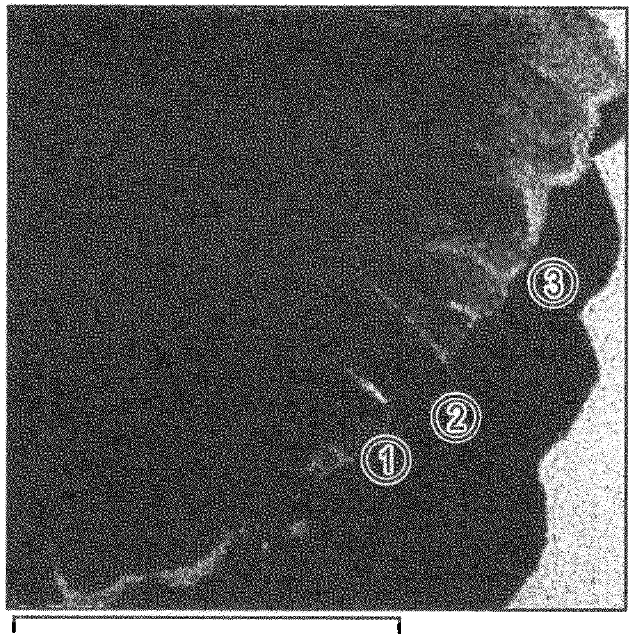


◆ Analyzing concentration grade on particle surface

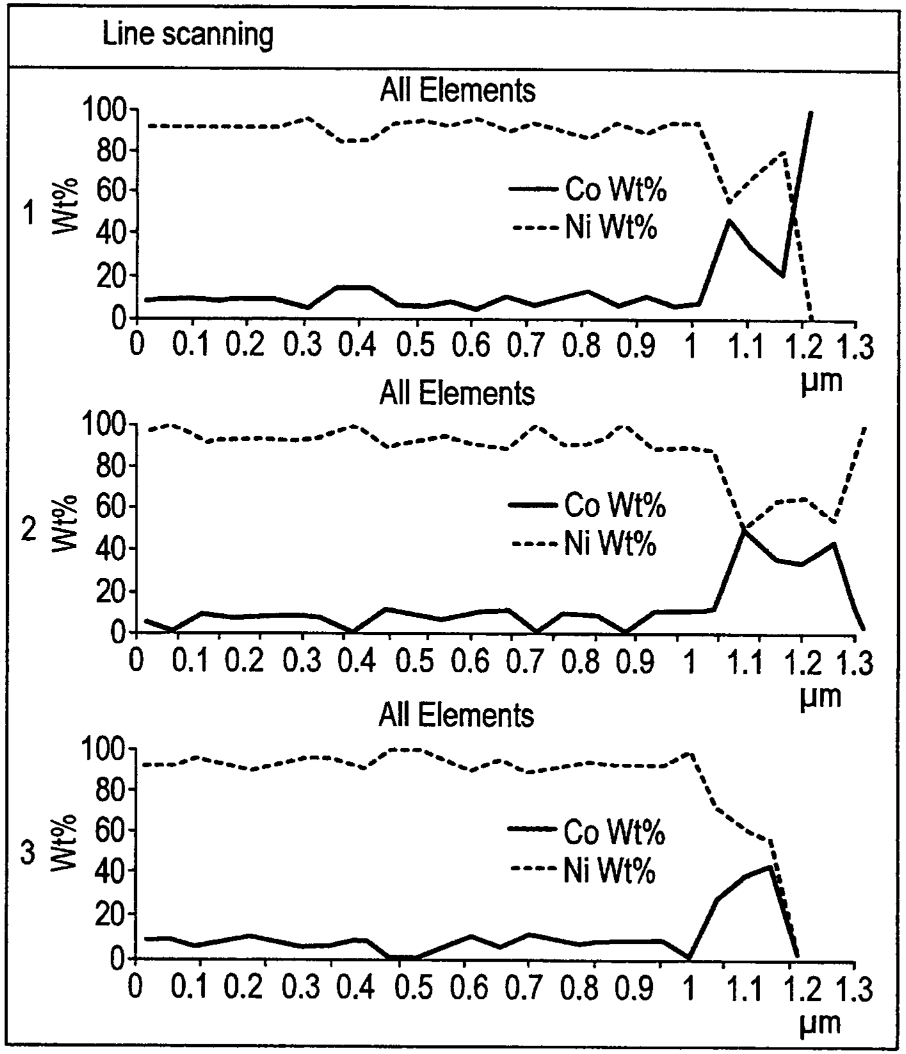

Fig. 12

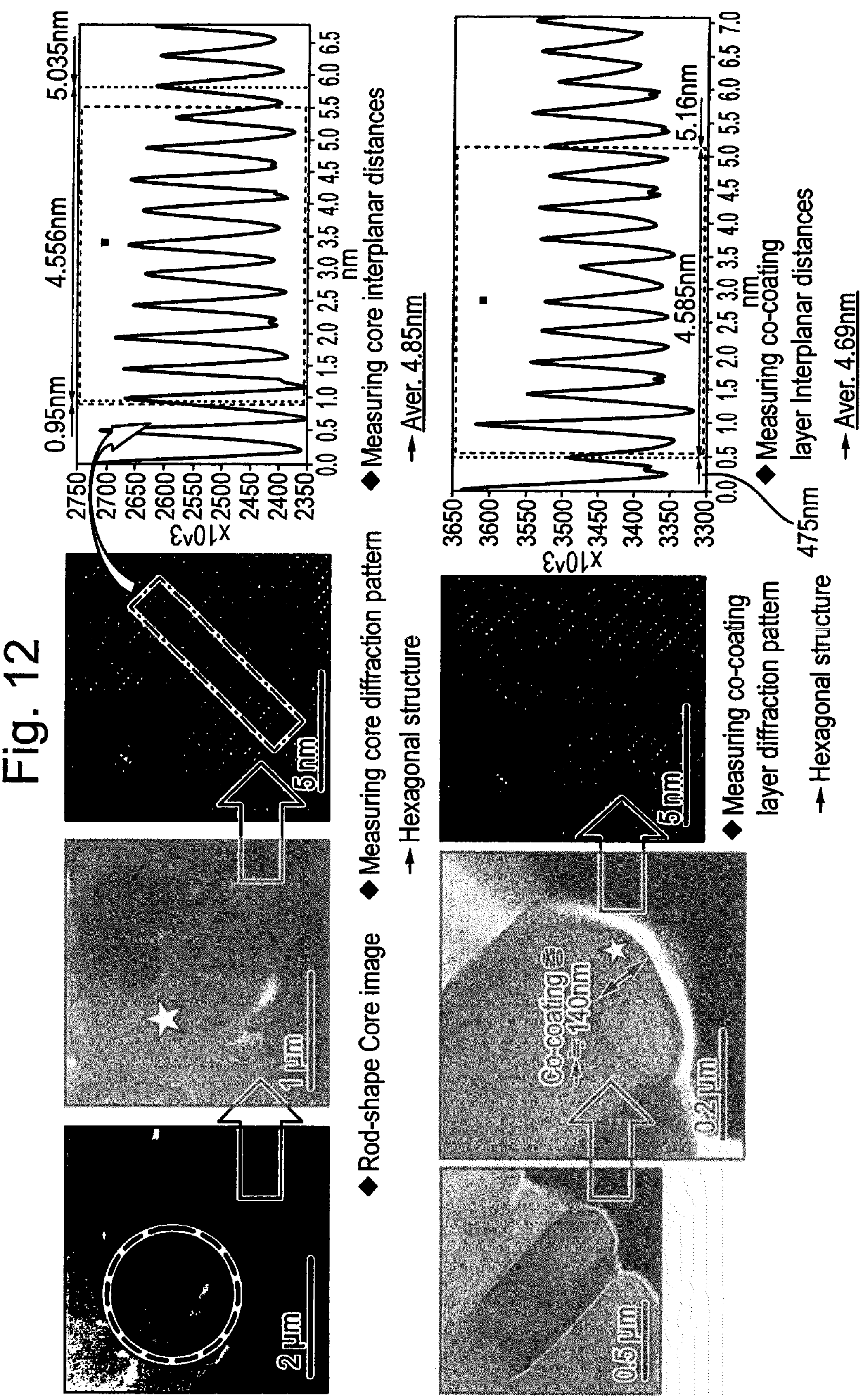

2 µm
1 µm
5 nm
◆ Rod-shape Core image
◆ Measuring core diffraction pattern
→ Hexagonal structure
0.95nm
4.556nm
5.035nm
x10^3
nm
◆ Measuring core interplanar distances
→ Aver. 4.85nm
0.5 µm
Co-coating ≒ 140nm
0.2 µm
5 nm
◆ Measuring co-coating layer diffraction pattern
→ Hexagonal structure
475nm
4.585nm
5.16nm
◆ Measuring co-coating layer Interplanar distances
→ Aver. 4.69nm

Fig. 13

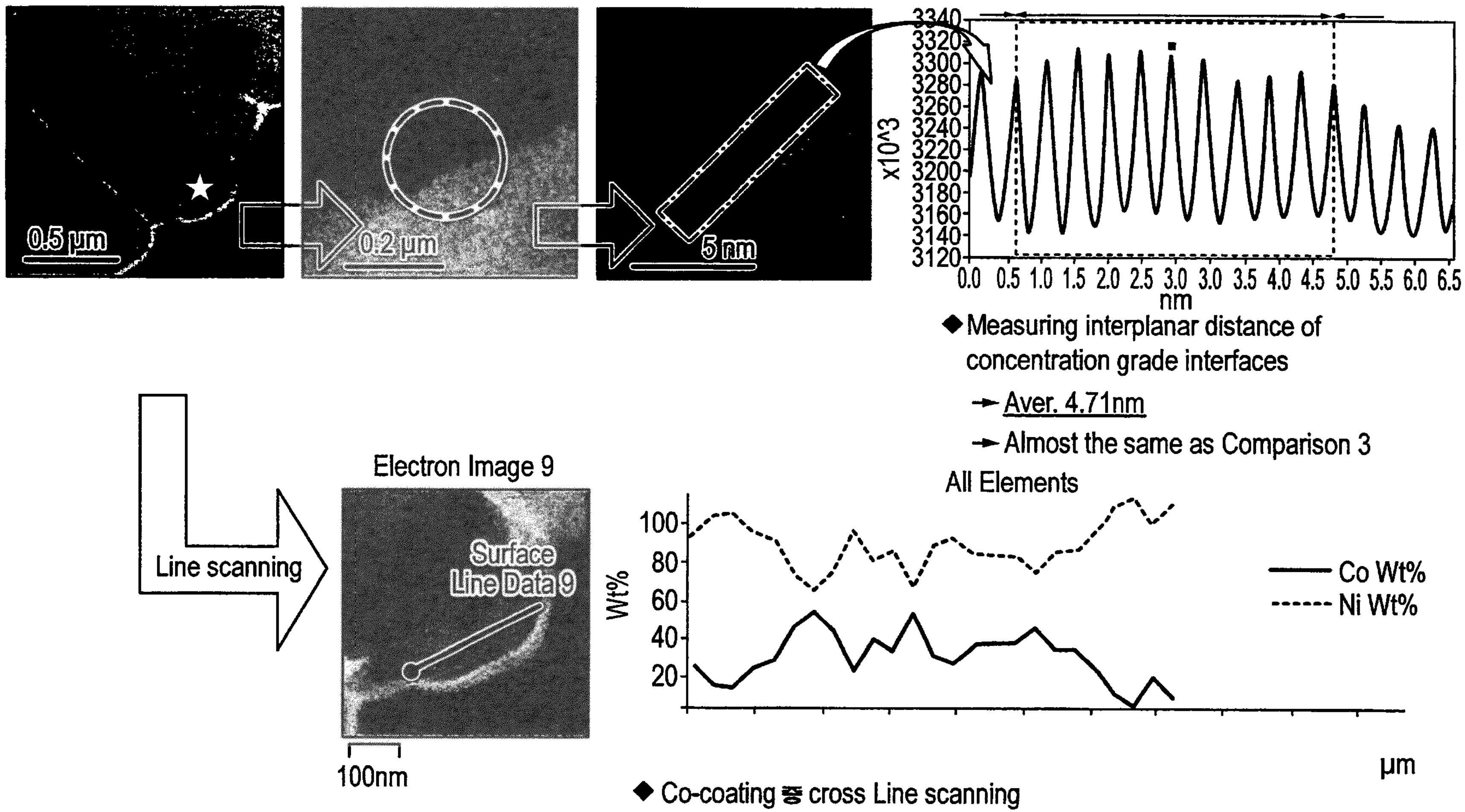
0.5 µm
0.2 µm
5 nm
x10^3
3340
3320
3300
3280
3260
3240
3220
3200
3180
3160
3140
3120
0.0 0.5 1.0 1.5 2.0 2.5 3.0 3.0 3.5 4.0 4.5 5.0 5.5 6.0 6.5
nm
◆ Measuring interplanar distance of concentration grade interfaces
→ Aver. 4.71nm
→ Almost the same as Comparison 3
Line scanning
Electron Image 9
Surface Line Data 9
100nm
All Elements
Wt%
100
80
60
40
20
Co Wt%
Ni Wt%
µm
◆ Co-coating 층 cross Line scanning

Fig. 14

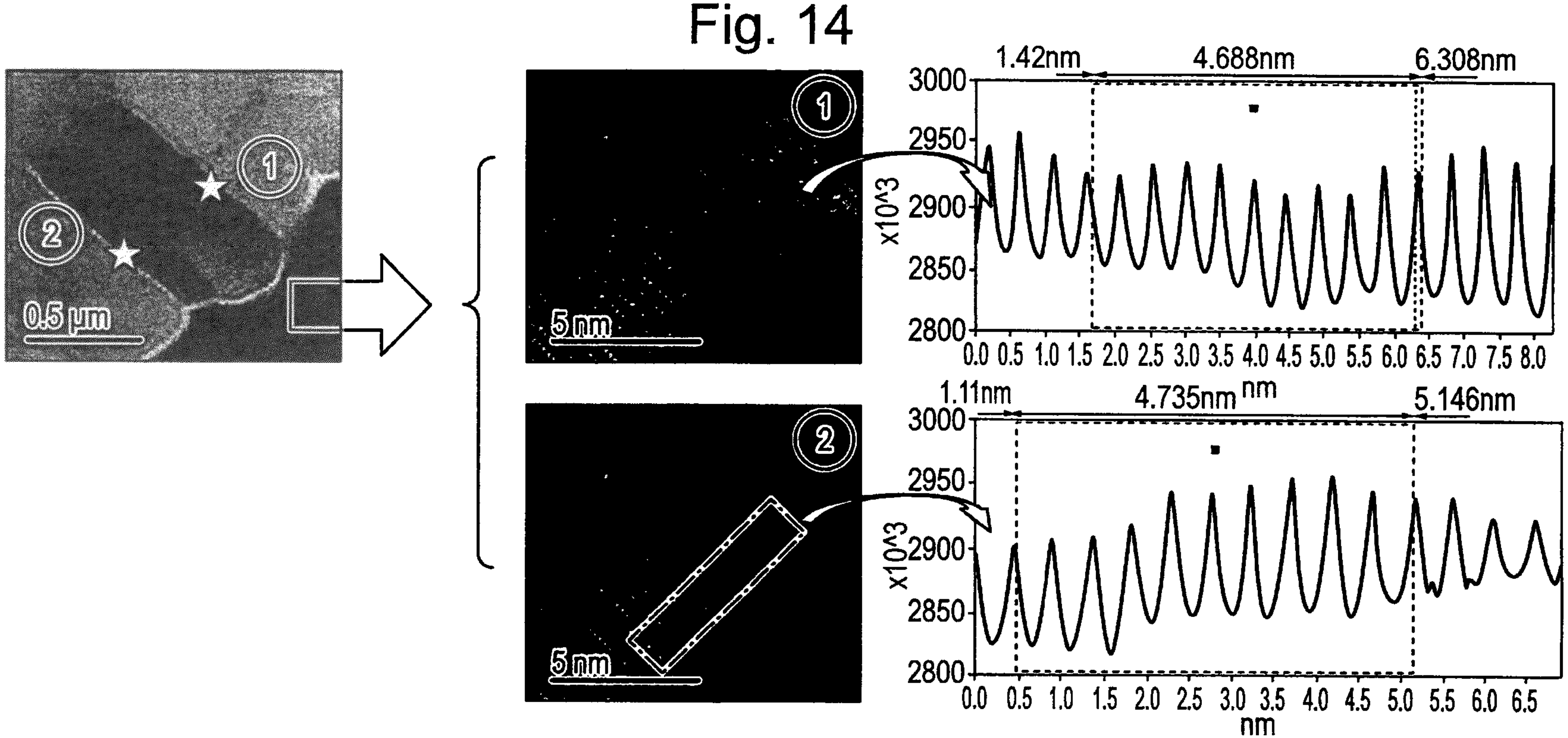


| | Diffraction pattern | Interplanar distance |
|---|---|---|
| 1 | Hexagonal structure | 4.69nm |
| 2 | Hexagonal structure | 4.71nm |

Fig. 15

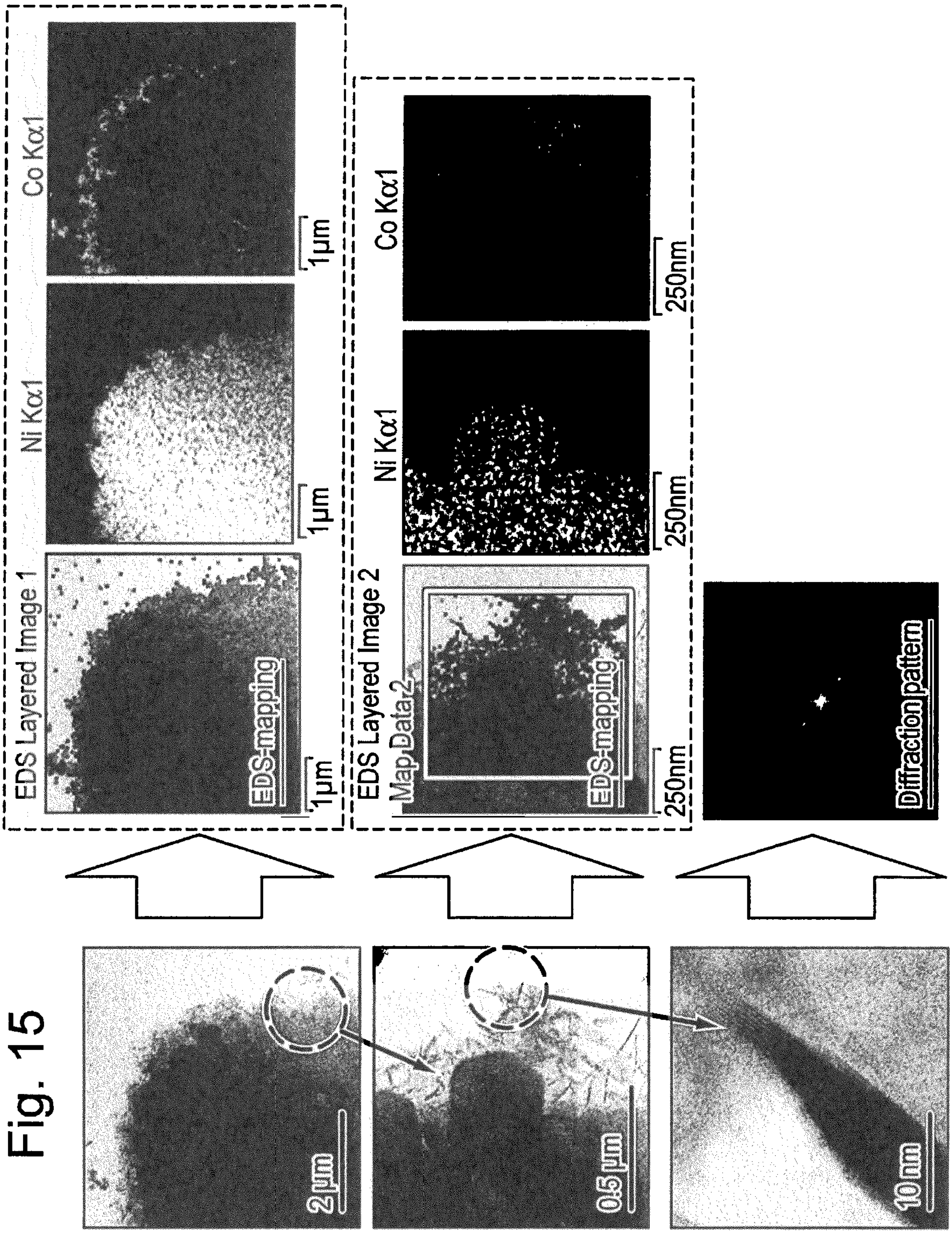
EDS Layered Image 1
EDS-mapping
1μm
Ni Kα1
1μm
Co Kα1
1μm
EDS Layered Image 2
Map Data 2
EDS-mapping
250nm
Ni Kα1
250nm
Co Kα1
250nm
Diffraction pattern
2μm
0.5μm
10nm

Fig. 16

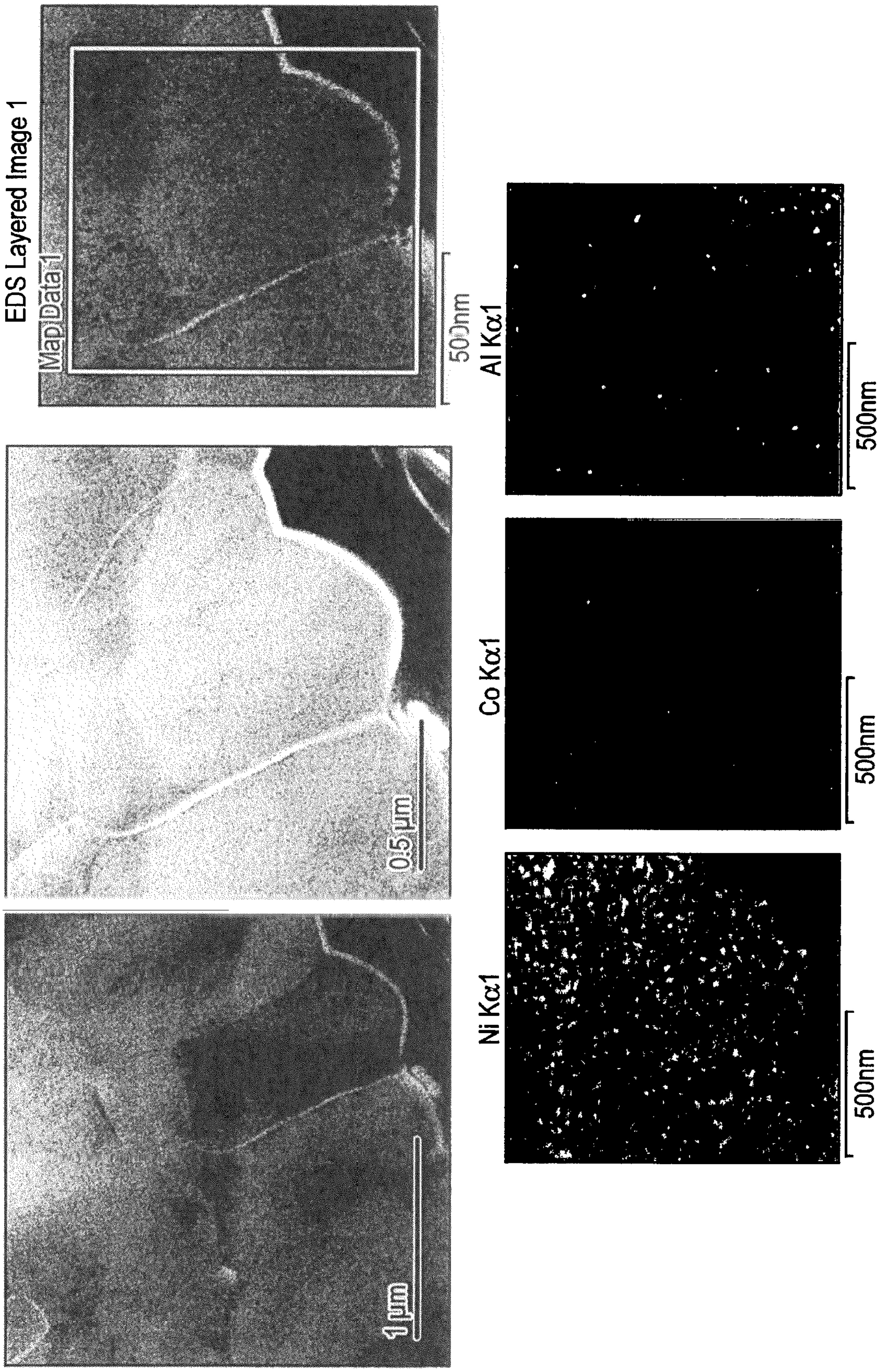
EDS Layered Image 1
Map Data 1
500nm
0.5 µm
1 µm
Al Kα1
500nm
Co Kα1
500nm
Ni Kα1
500nm

Fig. 17

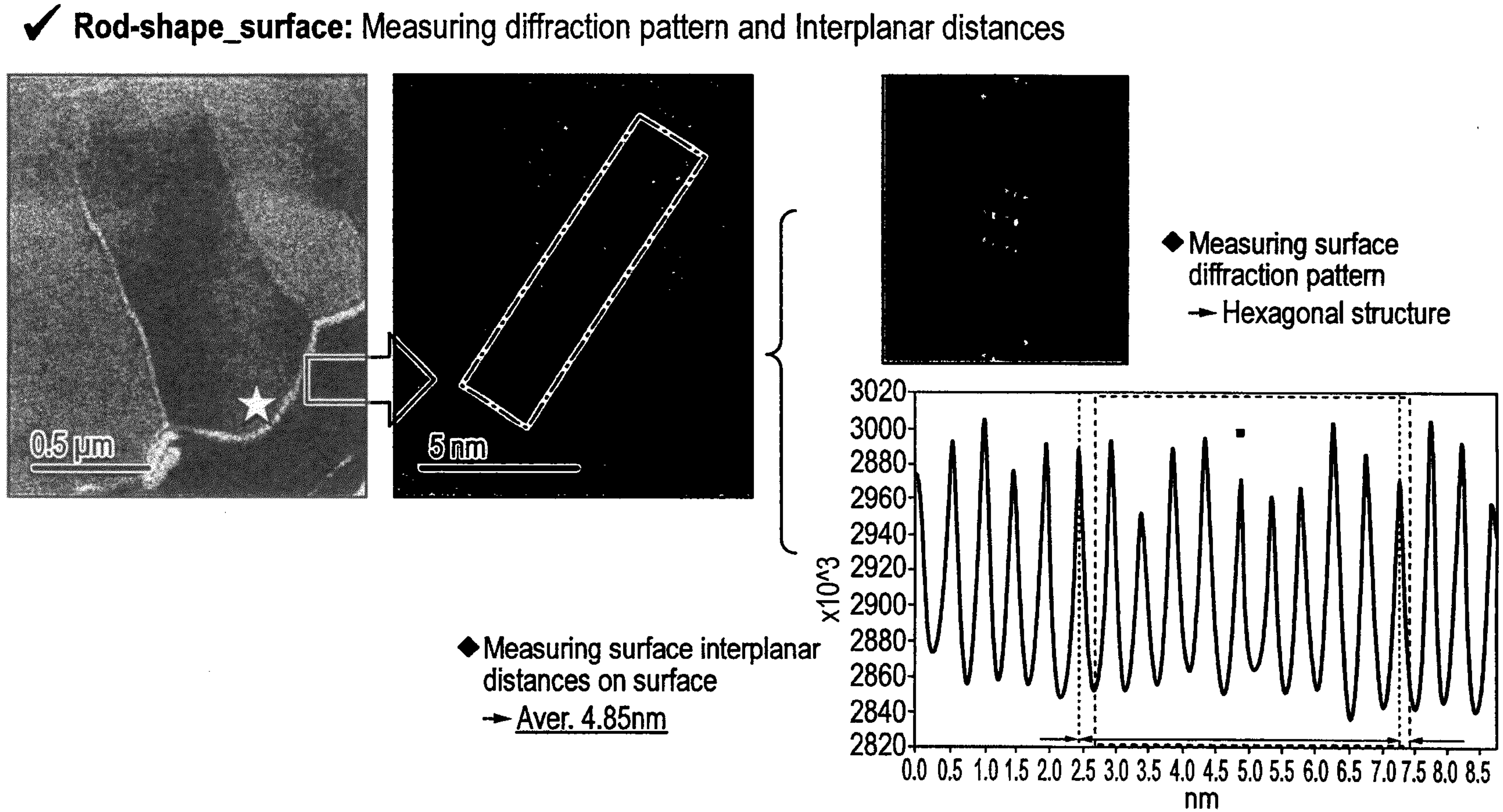
Rod-shape_surface: Measuring diffraction pattern and Interplanar distances
0.5 µm
5 nm
◆ Measuring surface diffraction pattern
→ Hexagonal structure
◆ Measuring surface interplanar distances on surface
→ Aver. 4.85nm
x10^3
3020
3000
2880
2960
2940
2920
2900
2880
2860
2840
2820
0.0 0.5 1.0 1.5 2.0 2.5 3.0 3.5 4.0 4.5 5.0 5.5 6.0 6.5 7.0 7.5 8.0 8.5
nm

Fig. 18

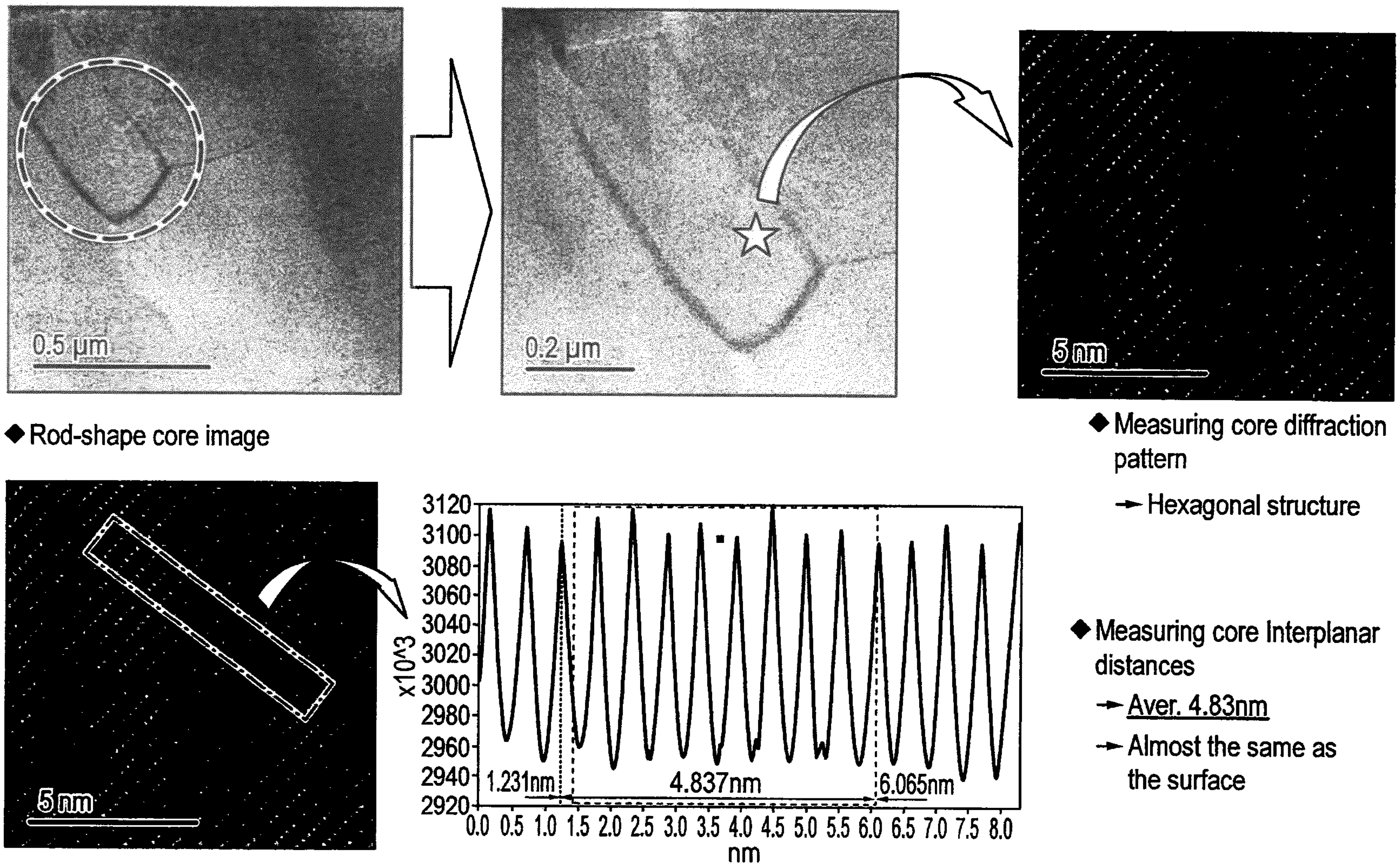
0.5 µm
0.2 µm
5 nm
◆ Rod-shape core image
◆ Measuring core diffraction pattern
→ Hexagonal structure
5 nm
x10^3
3120
3100
3080
3060
3040
3020
3000
2980
2960
2940
2920
1.231nm
4.837nm
6.065nm
0.0 0.5 1.0 1.5 2.0 2.5 3.0 3.5 4.0 4.5 5.0 5.5 6.0 6.5 7.0 7.5 8.0
nm
◆ Measuring core Interplanar distances
→ Aver. 4.83nm
→ Almost the same as the surface

# Fig. 19

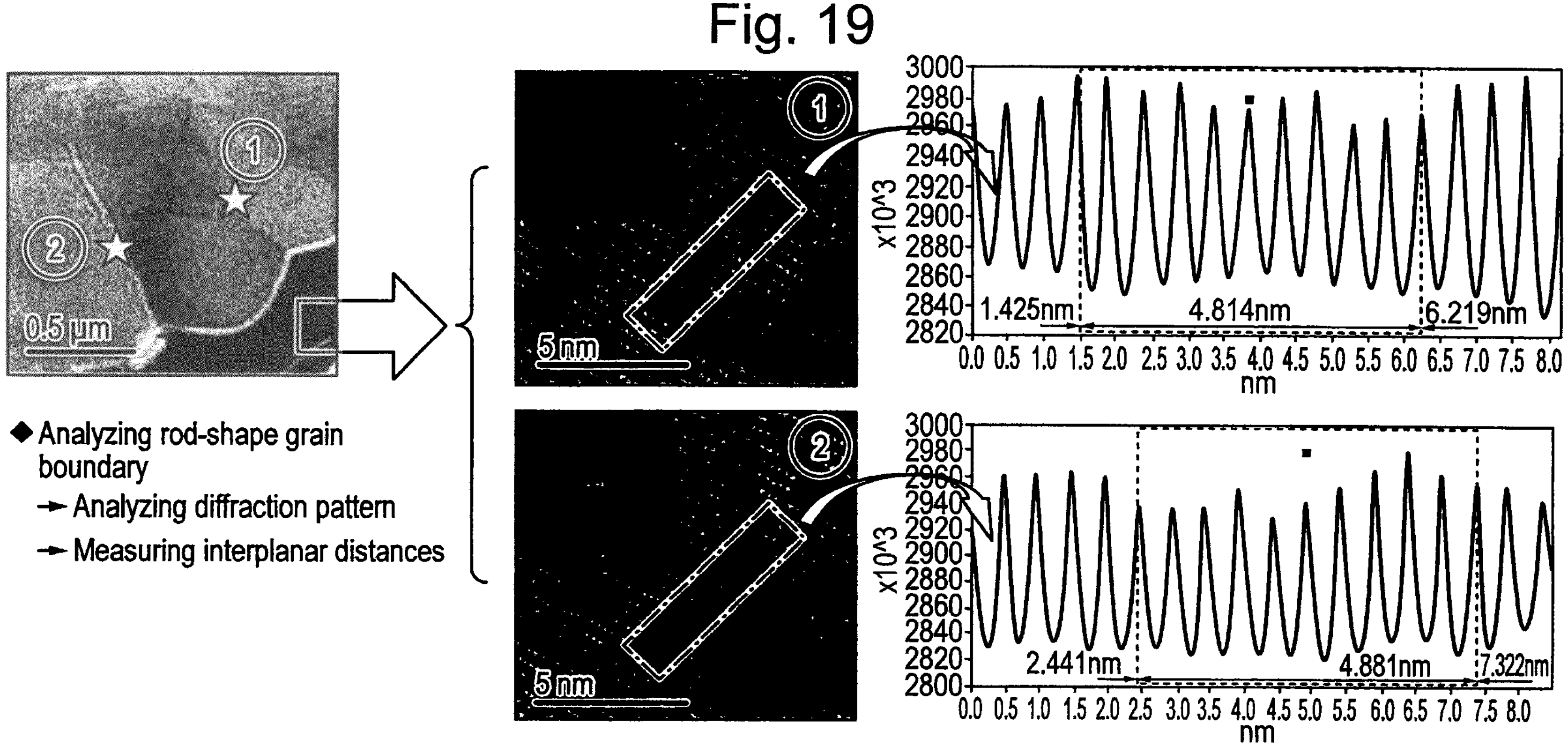


| | Diffraction pattern | Interplanar distance |
|---|---|---|
| 1 | Hexagonal structure | 4.81nm |
| 2 | Hexagonal structure | 4.88nm |

Fig. 20

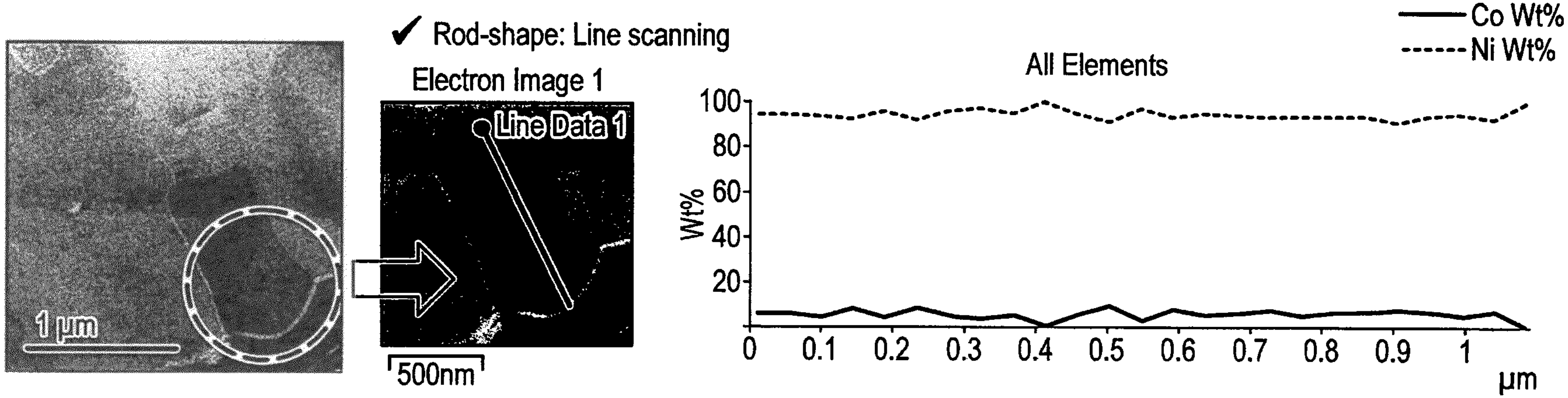
1 µm
Rod-shape: Line scanning
Electron Image 1
Line Data 1
500nm
All Elements
Al Wt%
Co Wt%
Ni Wt%
Wt%
100
80
60
40
20
0
0.1
0.2
0.3
0.4
0.5
0.6
0.7
0.8
0.9
1
µm

# Fig. 21

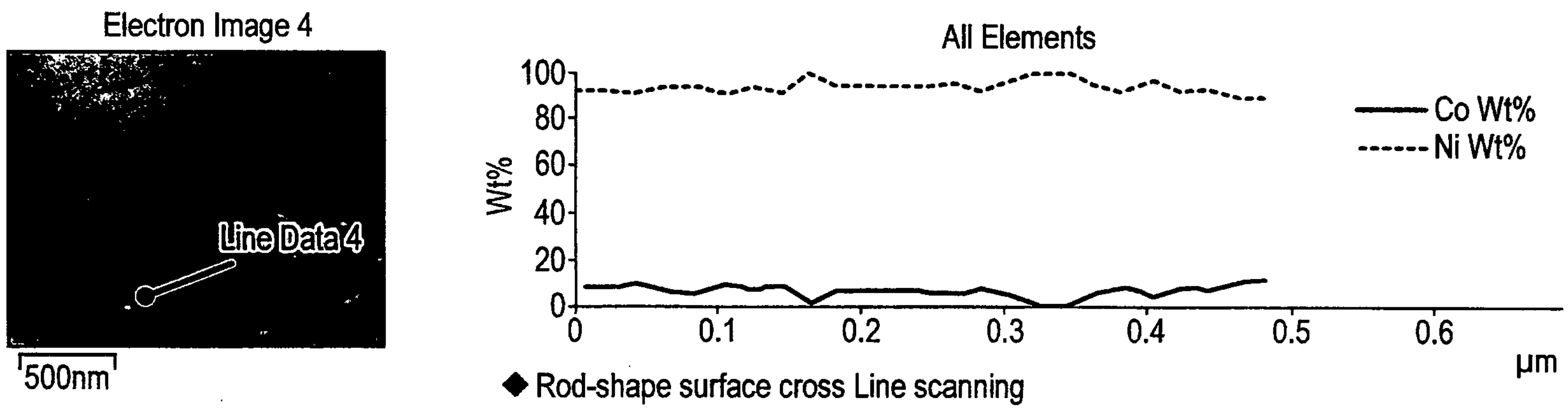
Electron Image 4
Line Data 4
500nm
All Elements
100
80
60
40
20
0
Wt%
0
0.1
0.2
0.3
0.4
0.5
0.6
µm
Co Wt%
Ni Wt%
◆ Rod-shape surface cross Line scanning

Fig. 22

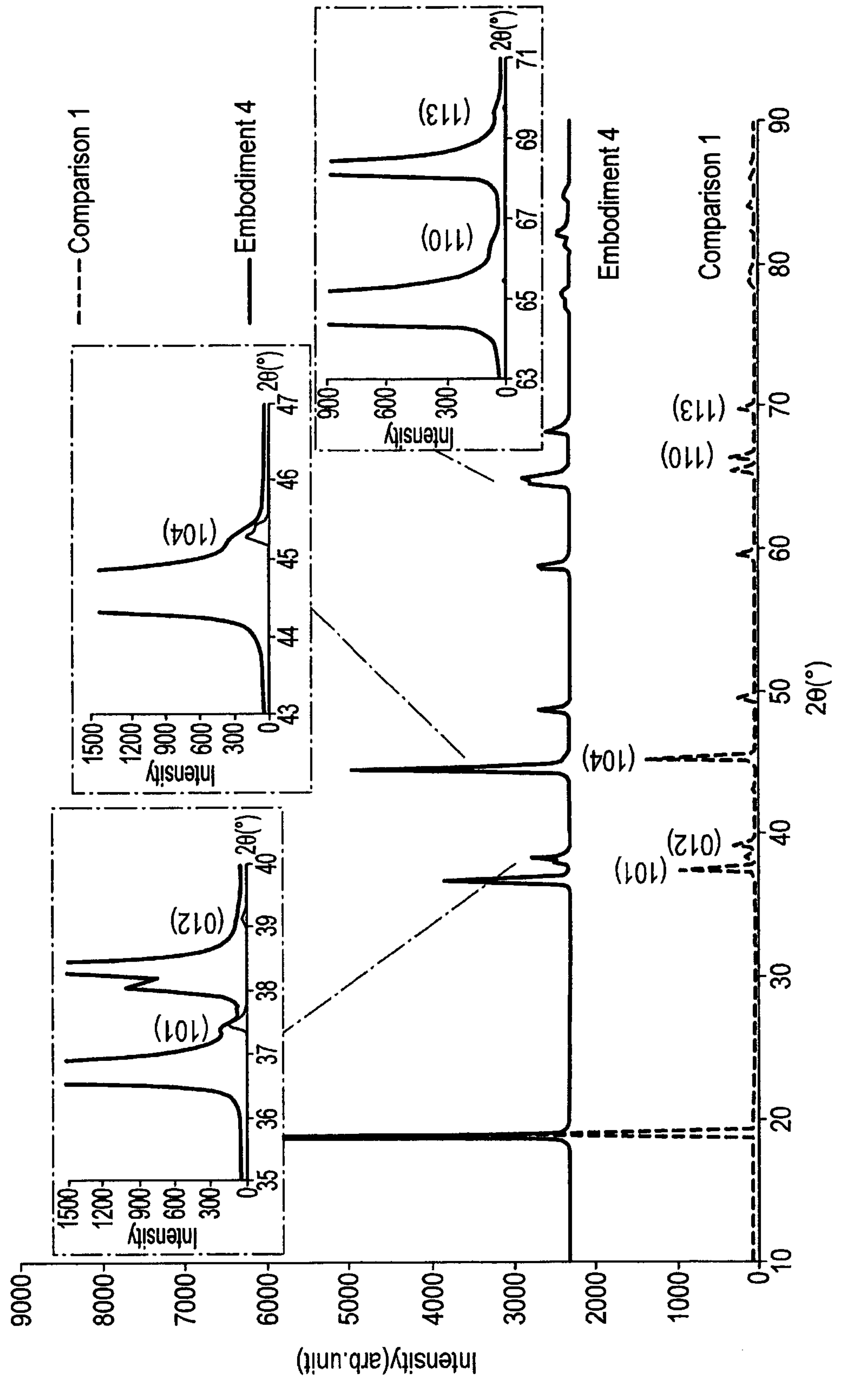

Comparison 1
Embodiment 4
Intensity(arb.unit)
2θ(°)
Intensity
(101)
(012)
(104)
(110)
(113)

Fig. 23

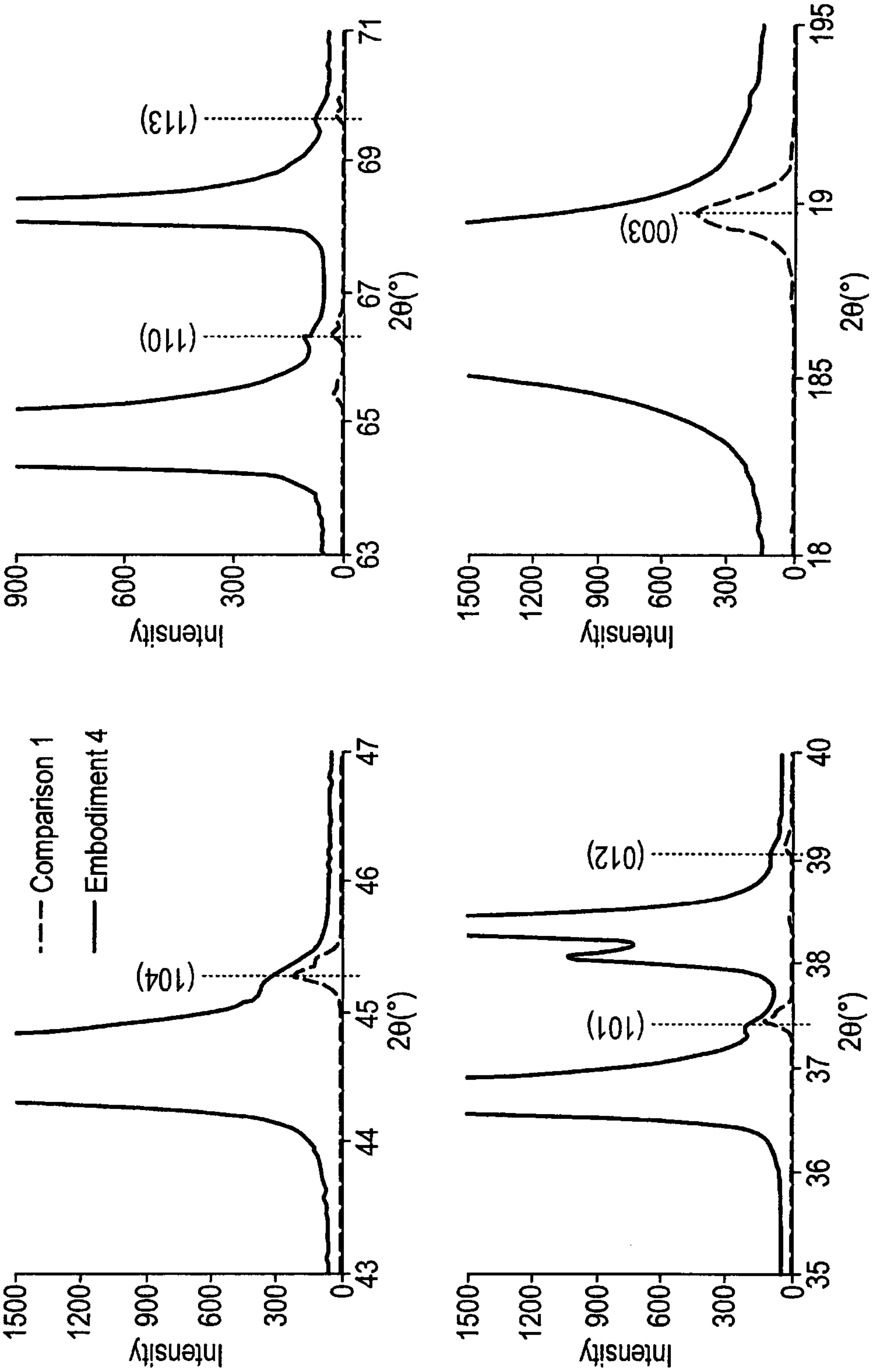
Comparison 1
Embodiment 4
Intensity
2θ(°)
(104)
(101)
(012)
(110)
(113)
(003)
1500
1200
900
600
300
0
43
44
45
46
47
35
36
37
38
39
40
63
65
67
69
71
18
185
19
195

Fig. 24

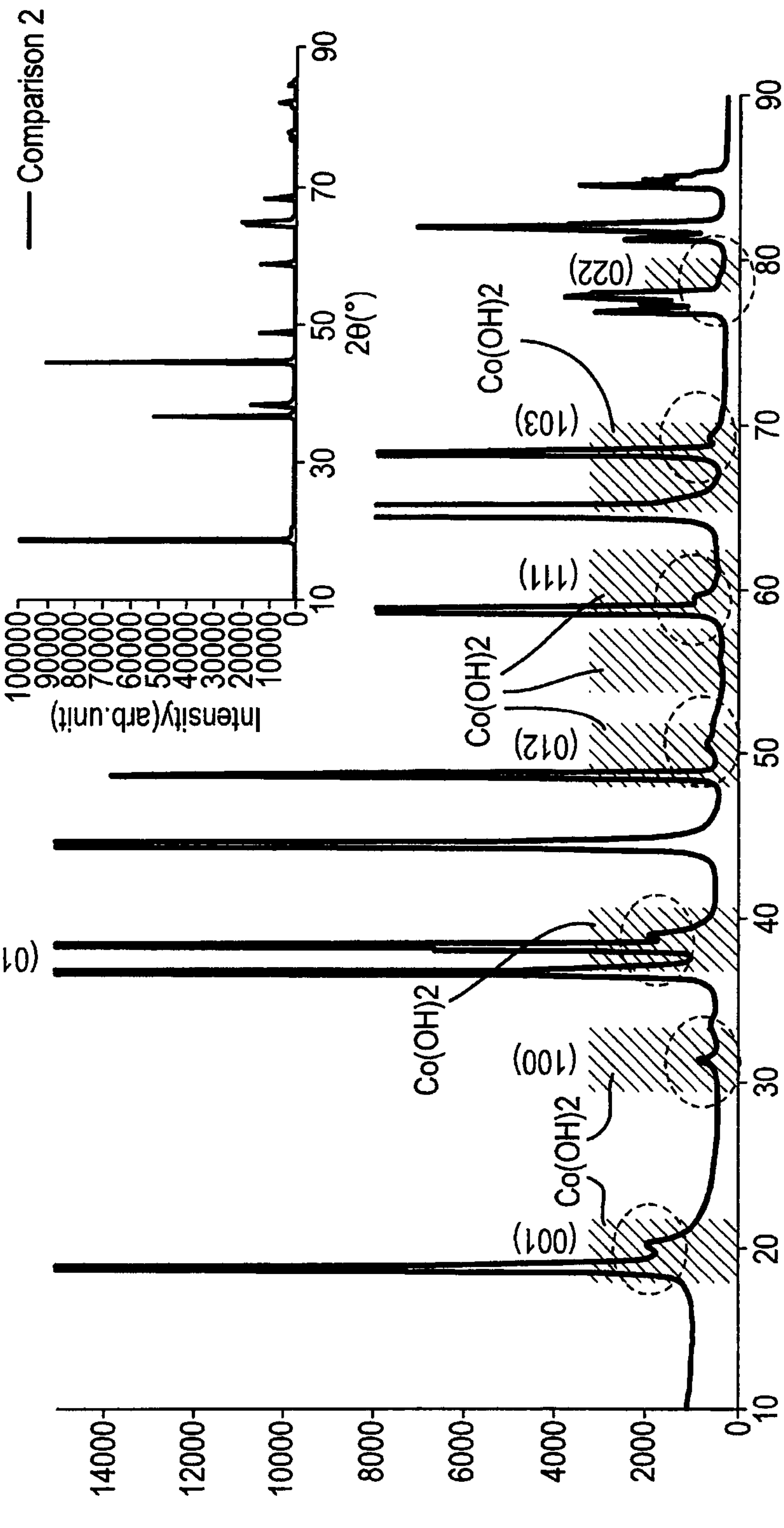
Comparison 2
Intensity(arb.unit)
2θ(°)
Co(OH)2
(001)
(100)
(011)
(012)
(111)
(103)
(022)

Fig. 25

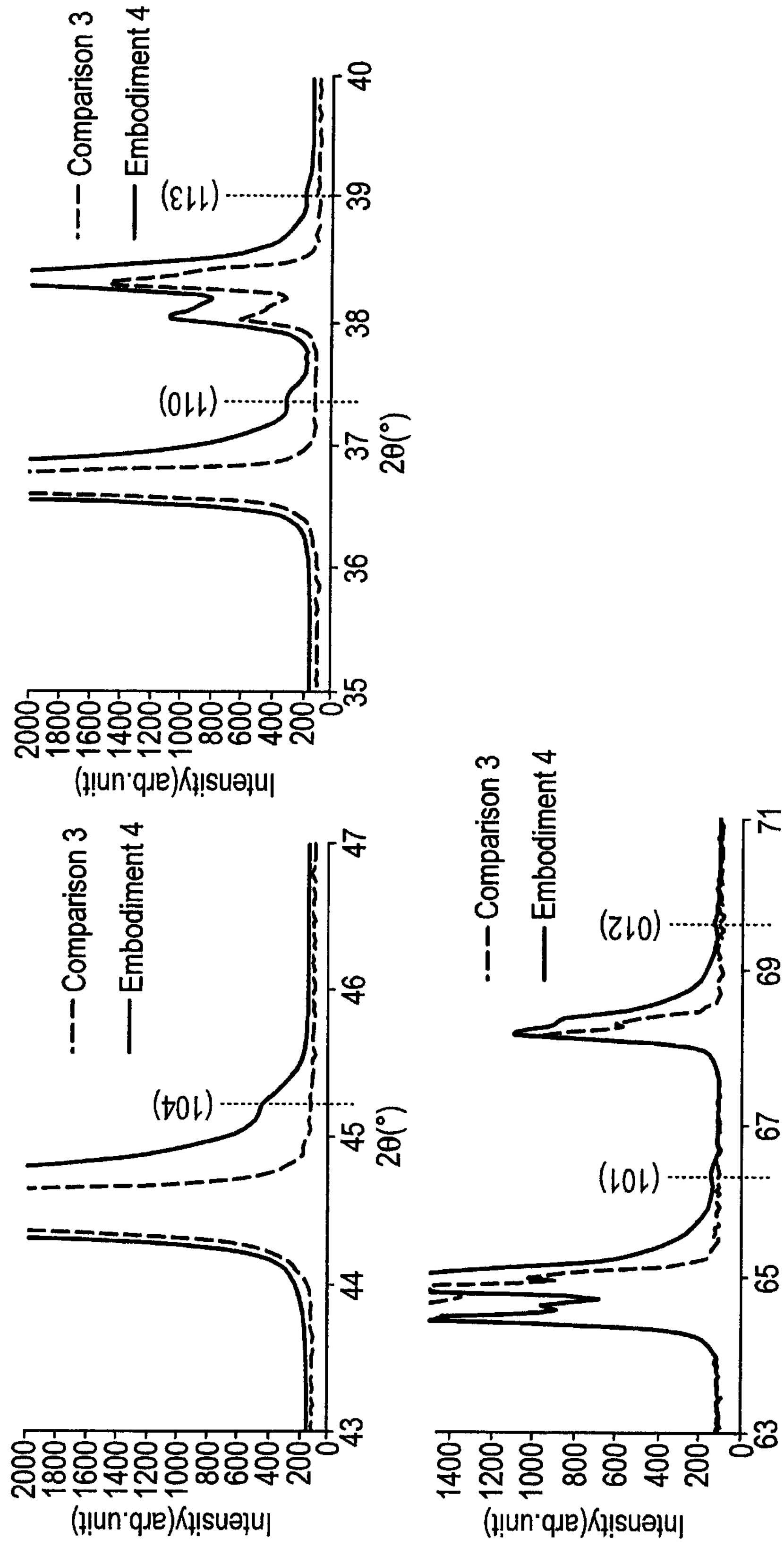
Comparison 3
Embodiment 4
(110)
(113)
(104)
(101)
(012)
Intensity(arb.unit)
2θ(°)
0
200
400
600
800
1000
1200
1400
1600
1800
2000
35
36
37
38
39
40
43
44
45
46
47
63
65
67
69
71

Fig. 26a

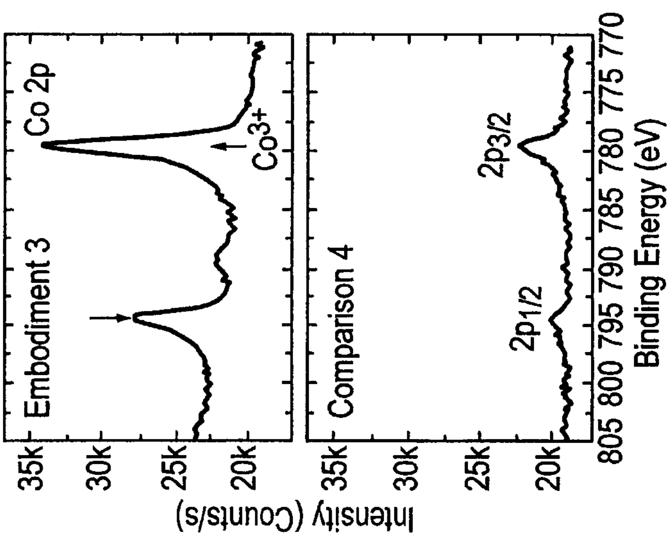


Fig. 26b

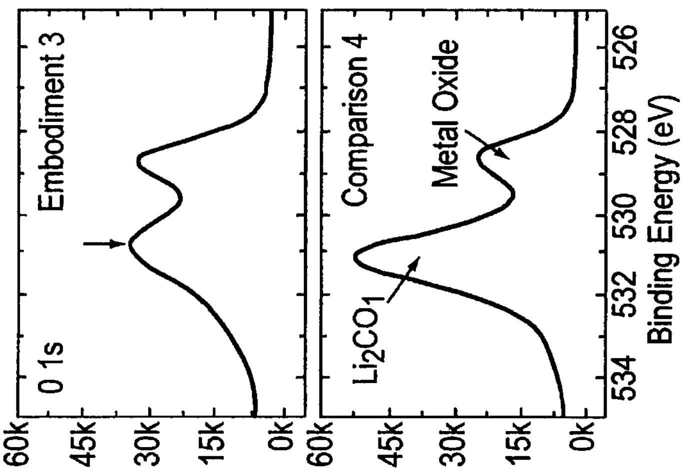


Fig. 26c

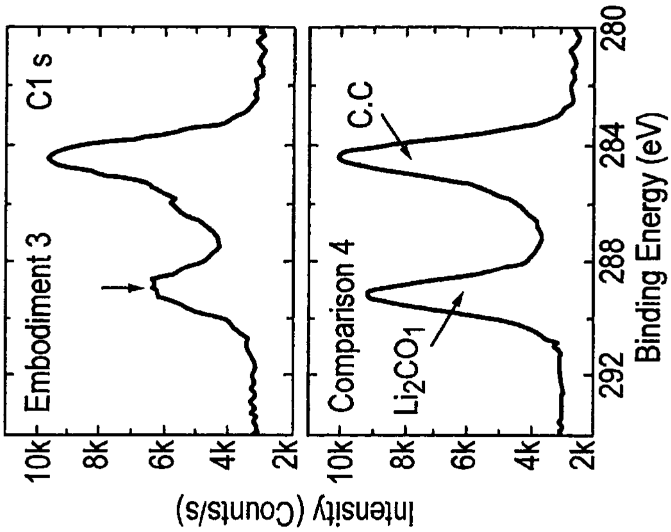

Fig. 27a

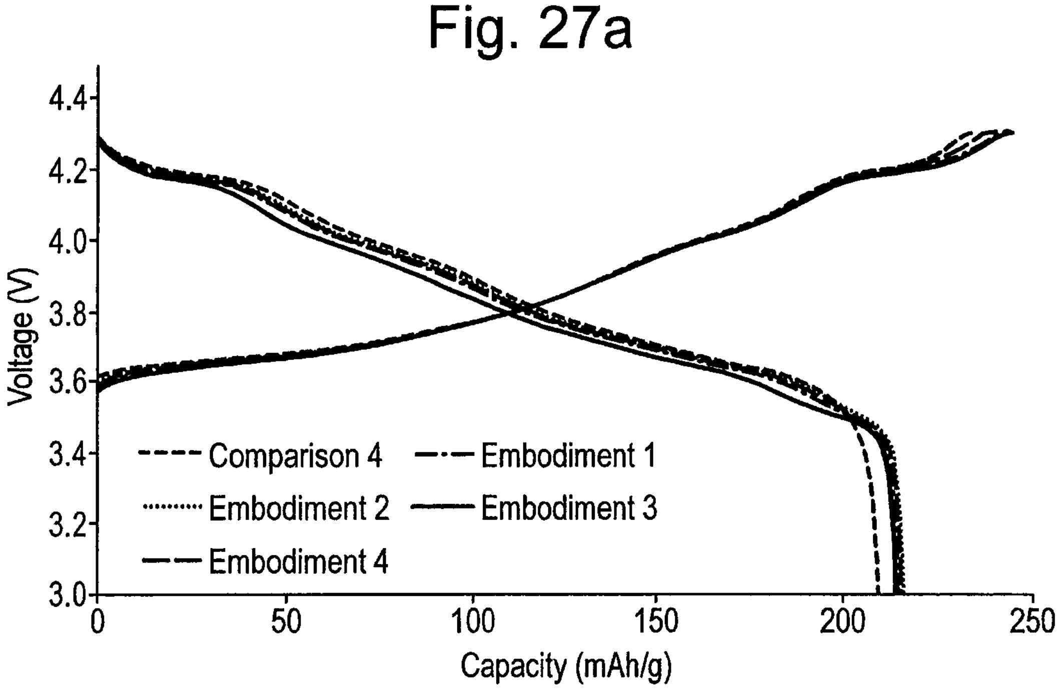


Fig. 27b

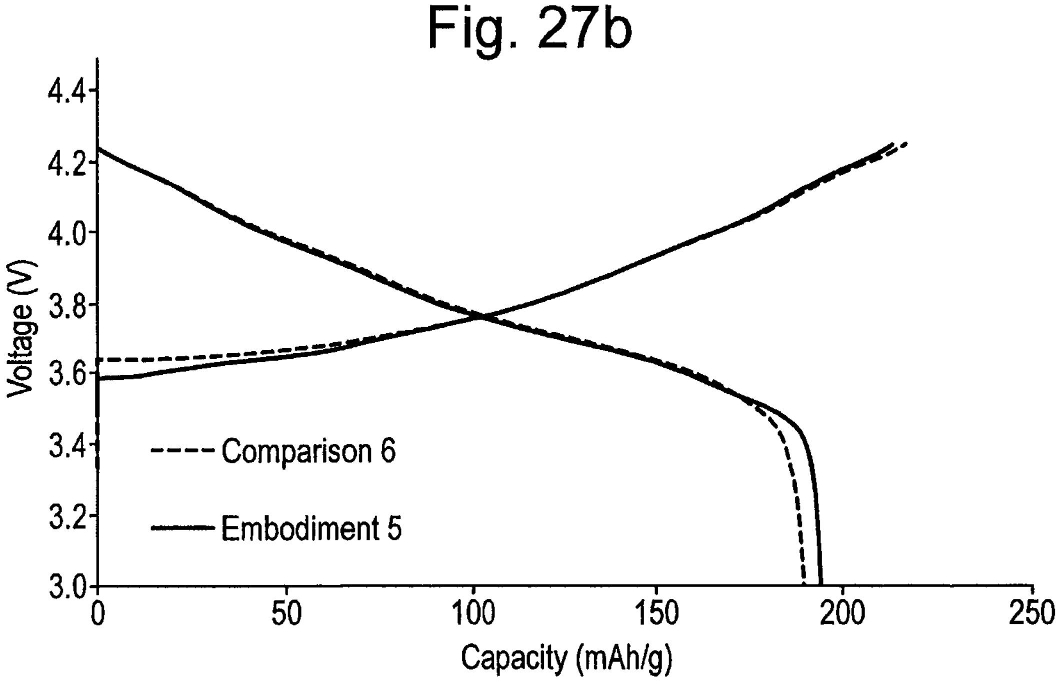

Fig. 27c

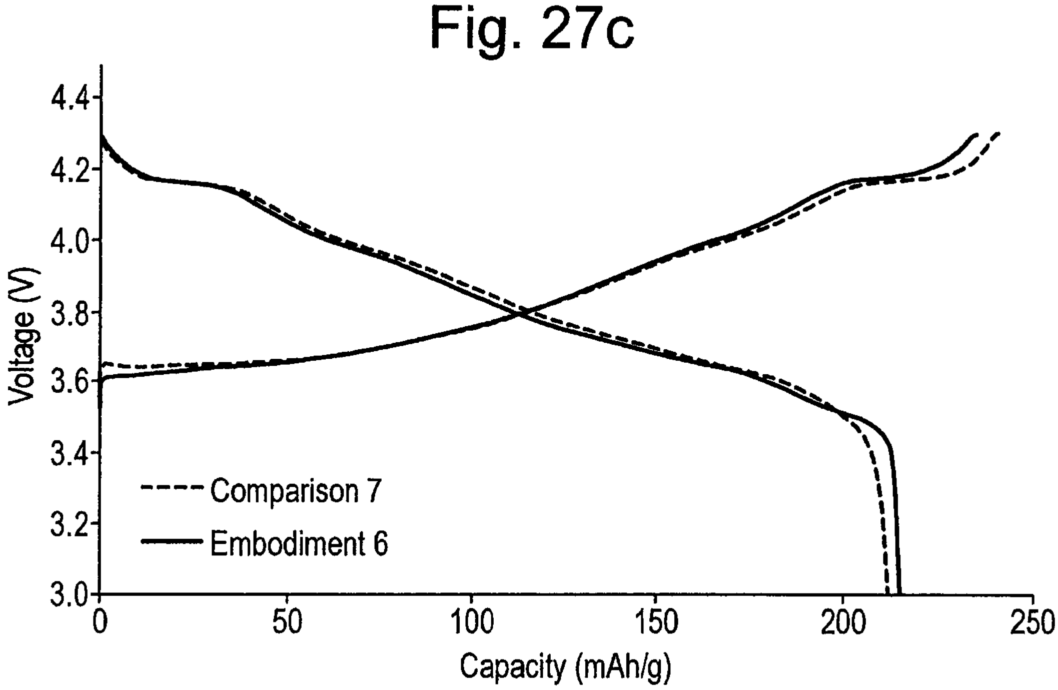


Fig. 27d

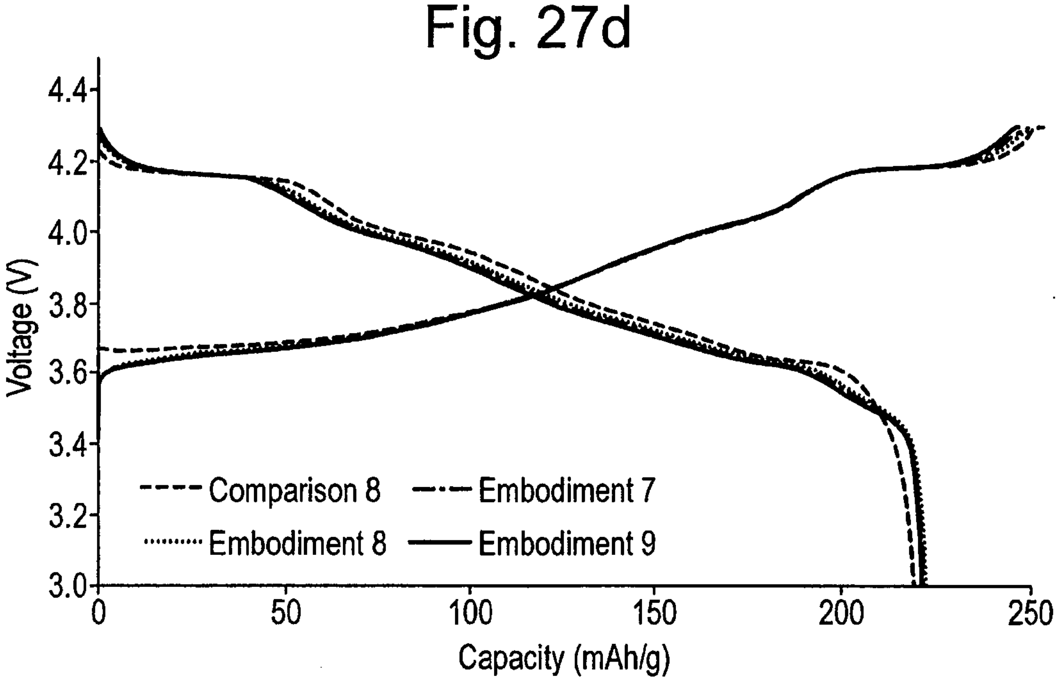

Fig. 27e

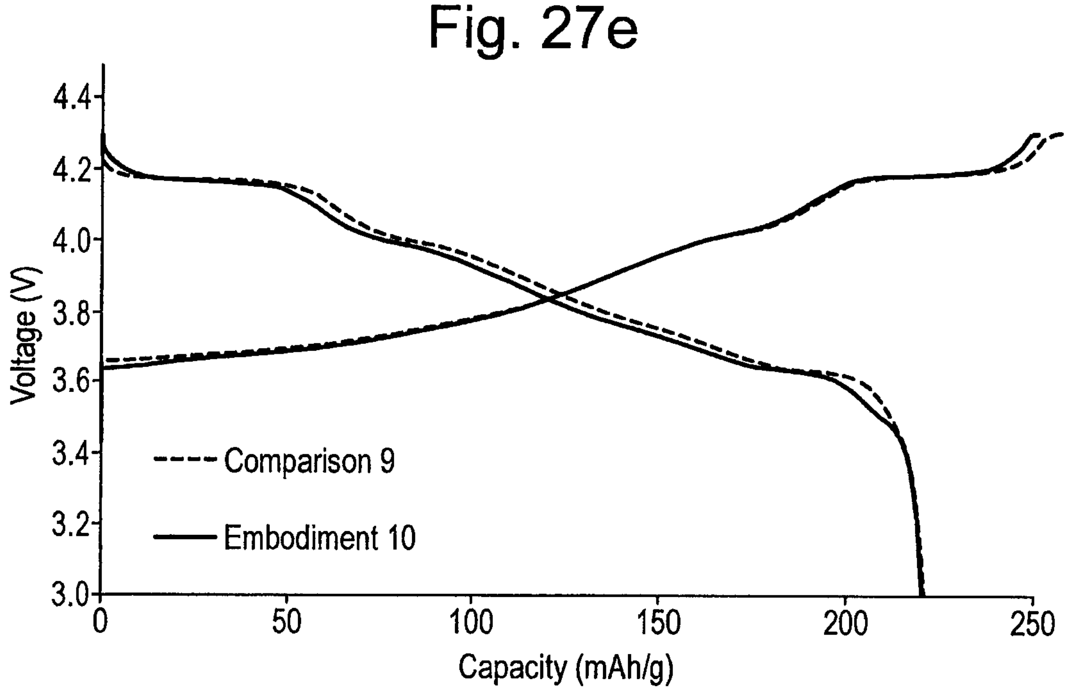


Fig. 28a

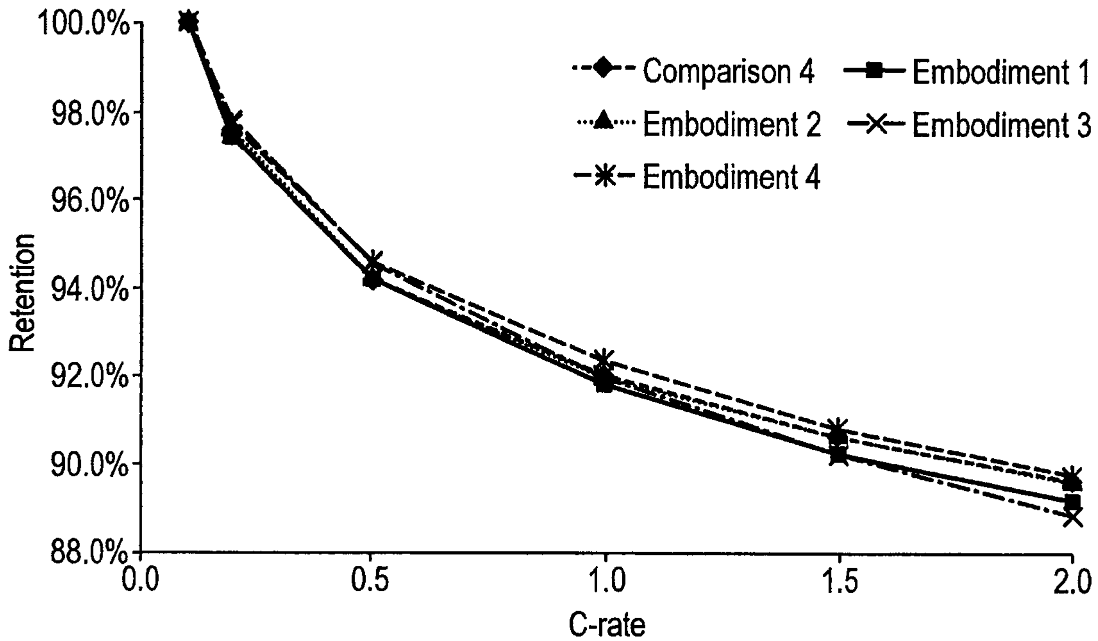

Fig. 28b

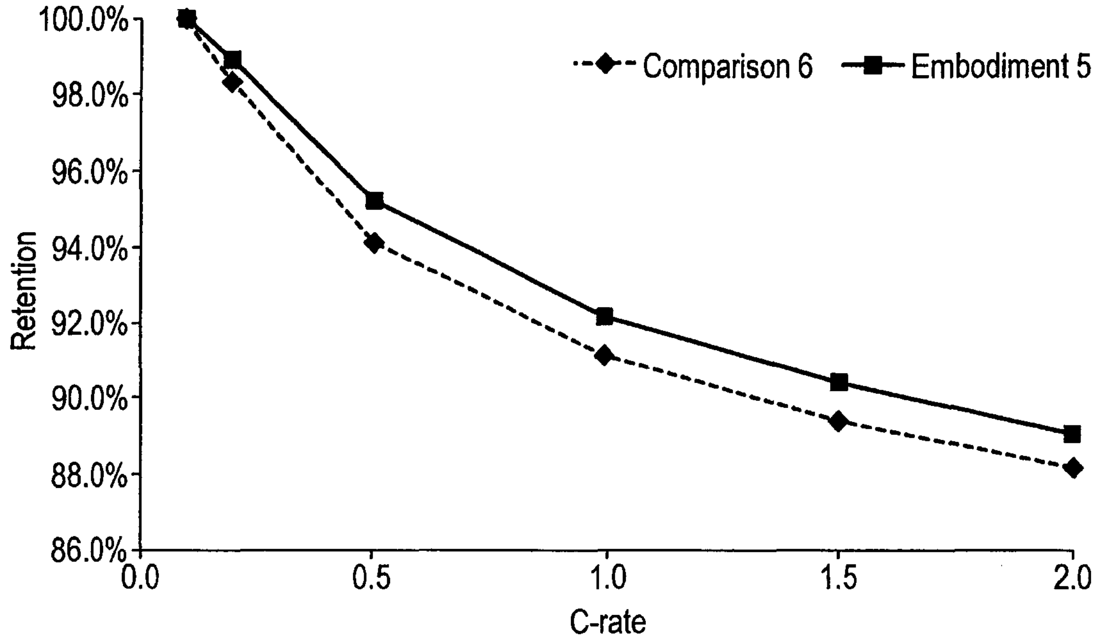


Fig. 28c

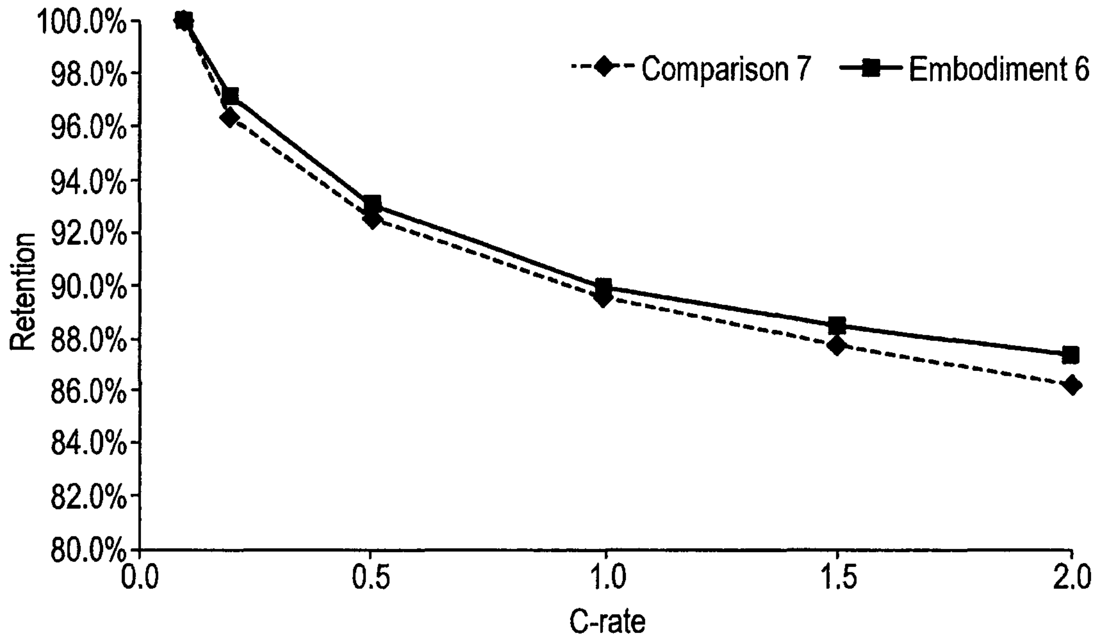

Fig. 28d

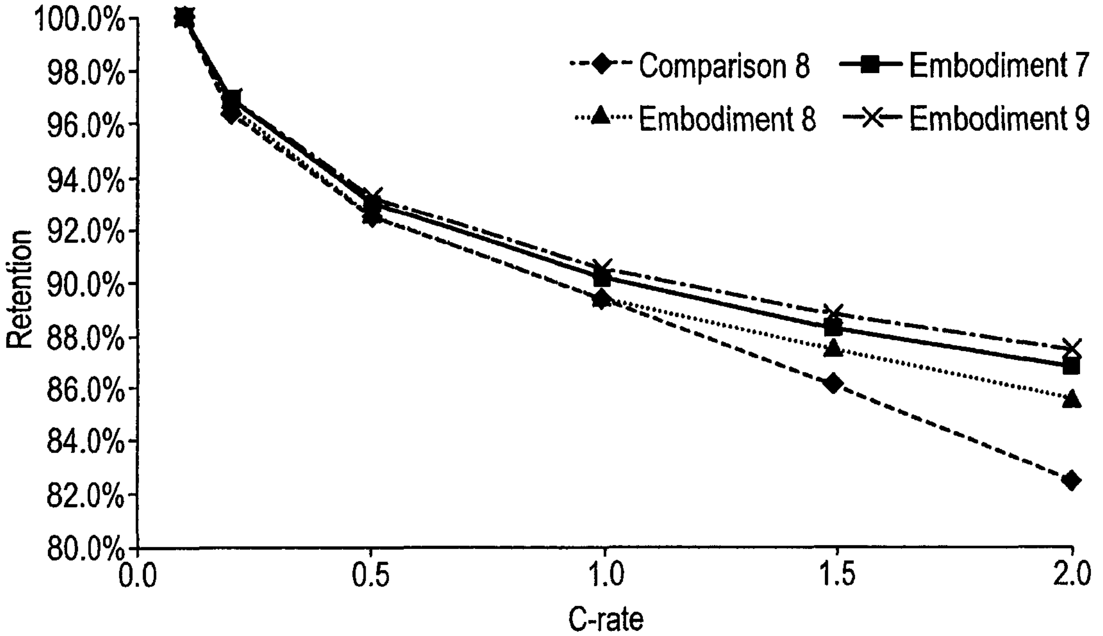


Fig. 28e

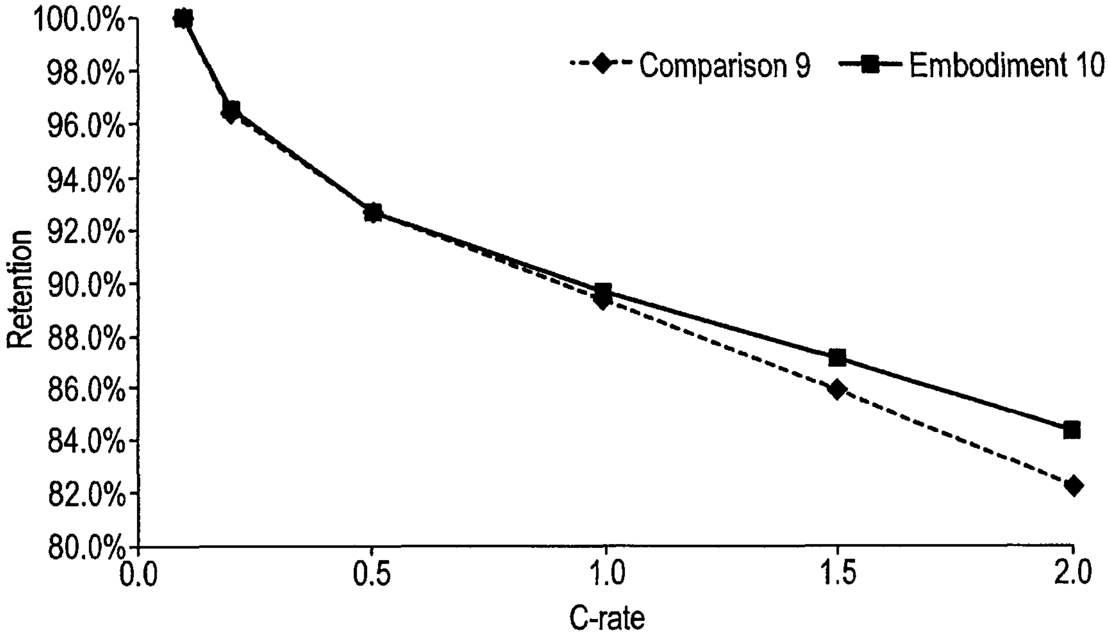

Fig. 29a

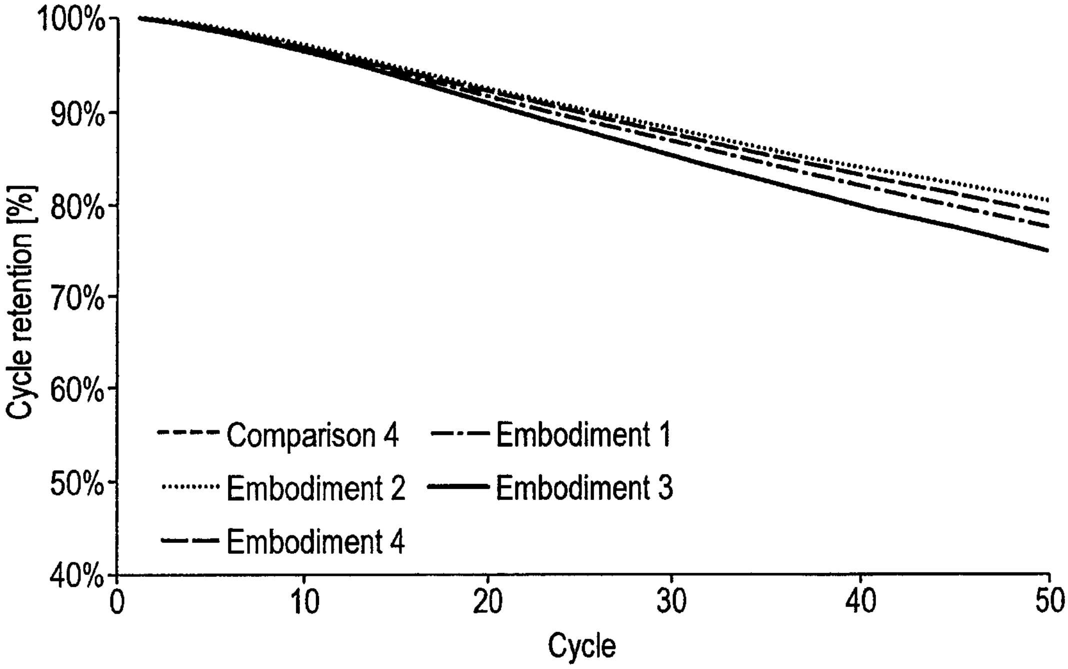


Fig. 29b

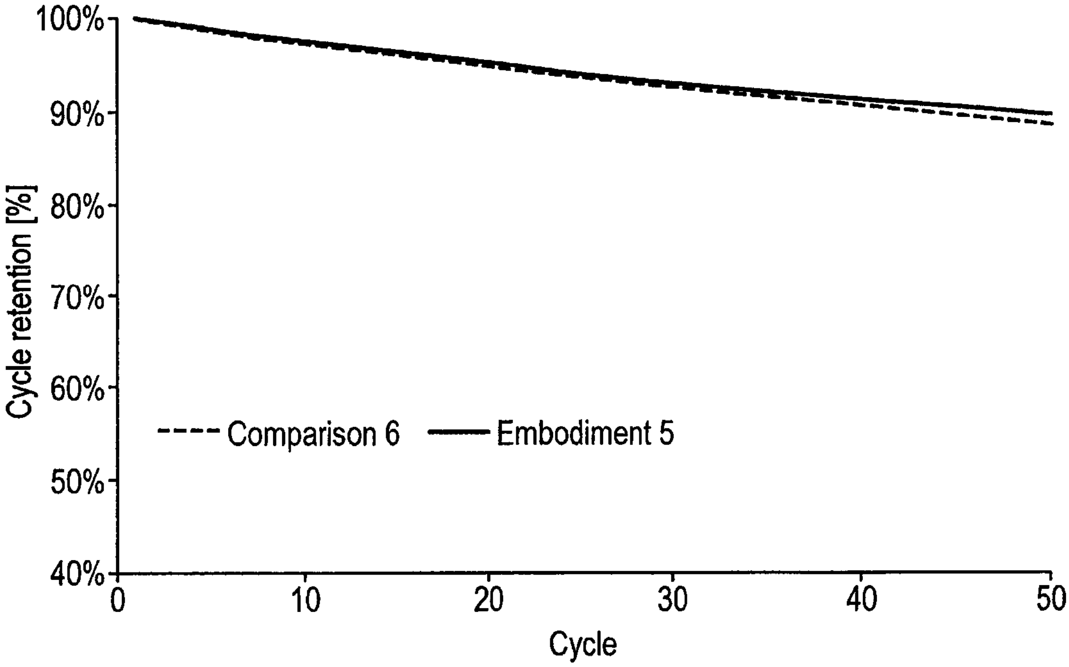

Fig. 29c

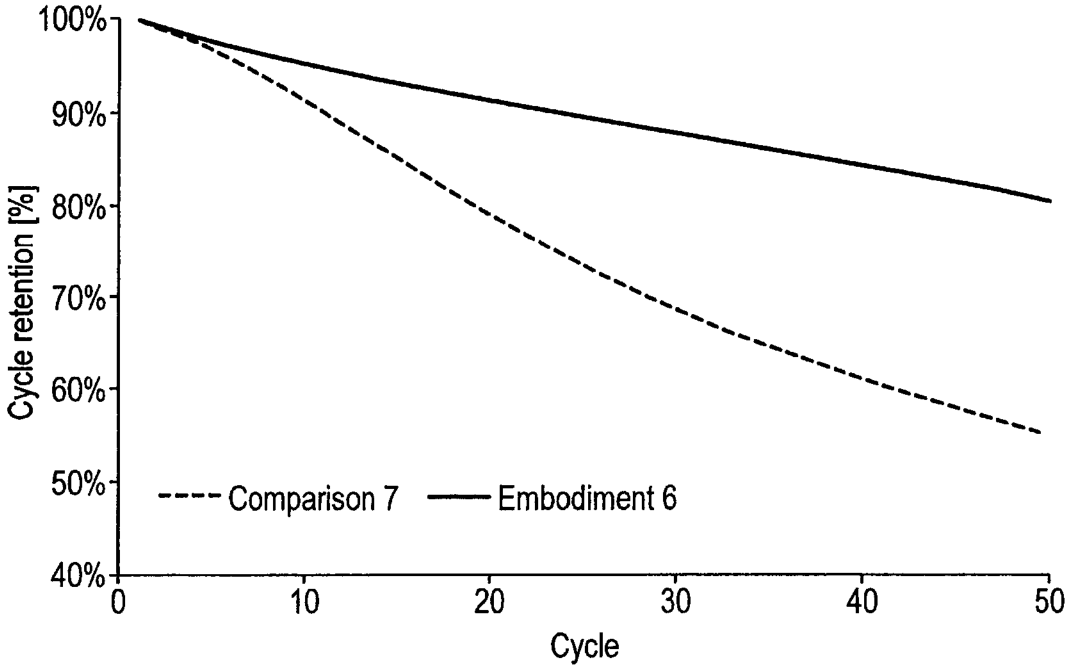


Fig. 29d

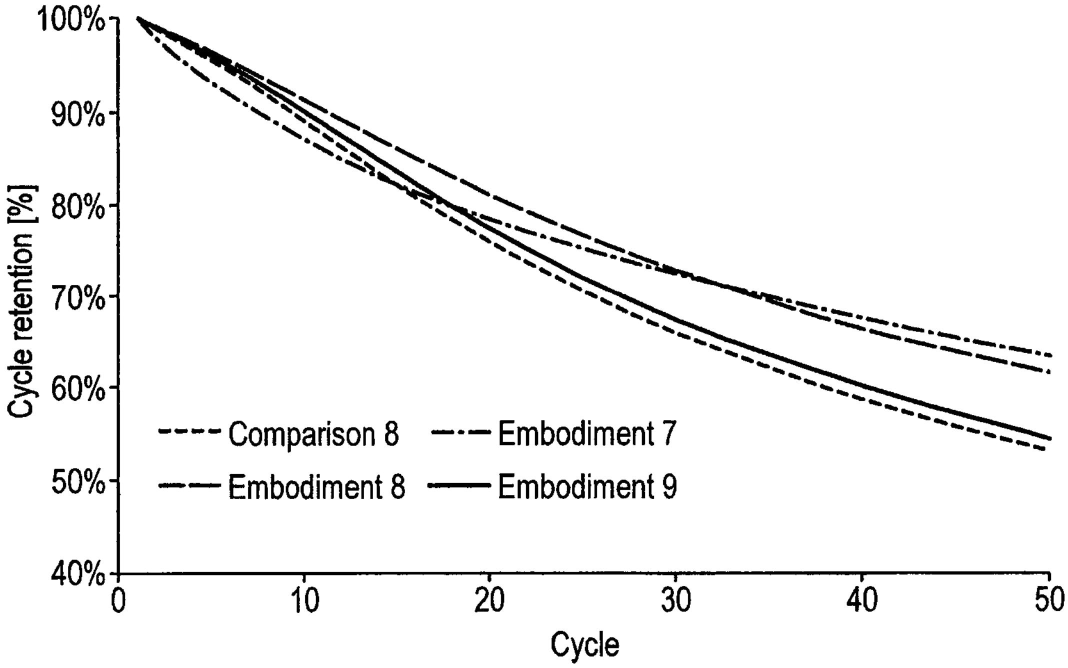

Fig. 29e

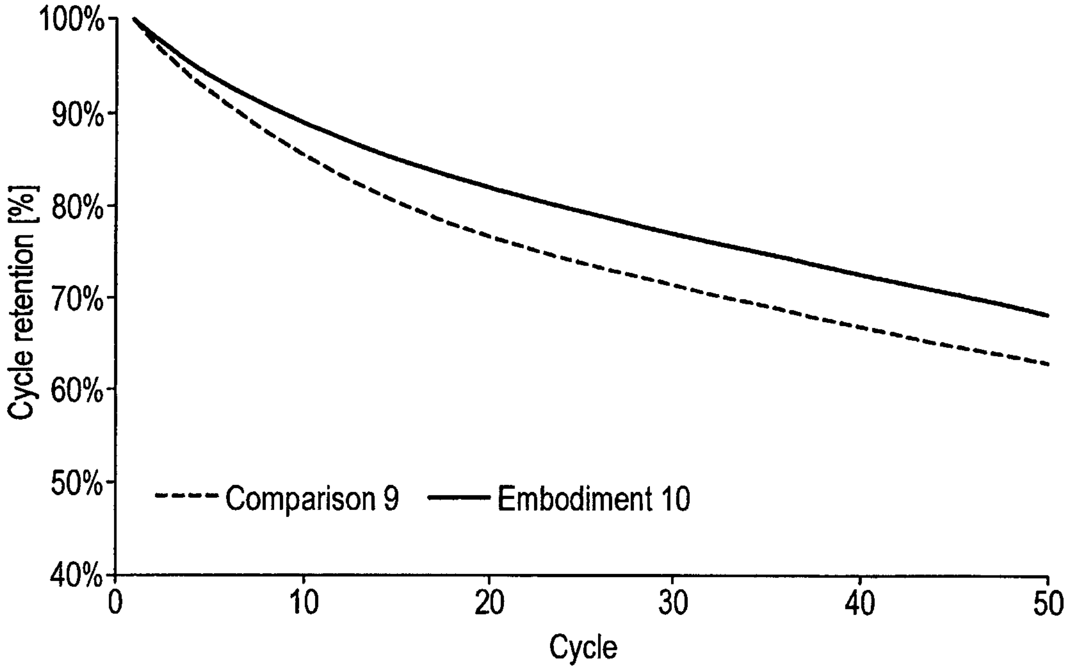


Fig. 30a

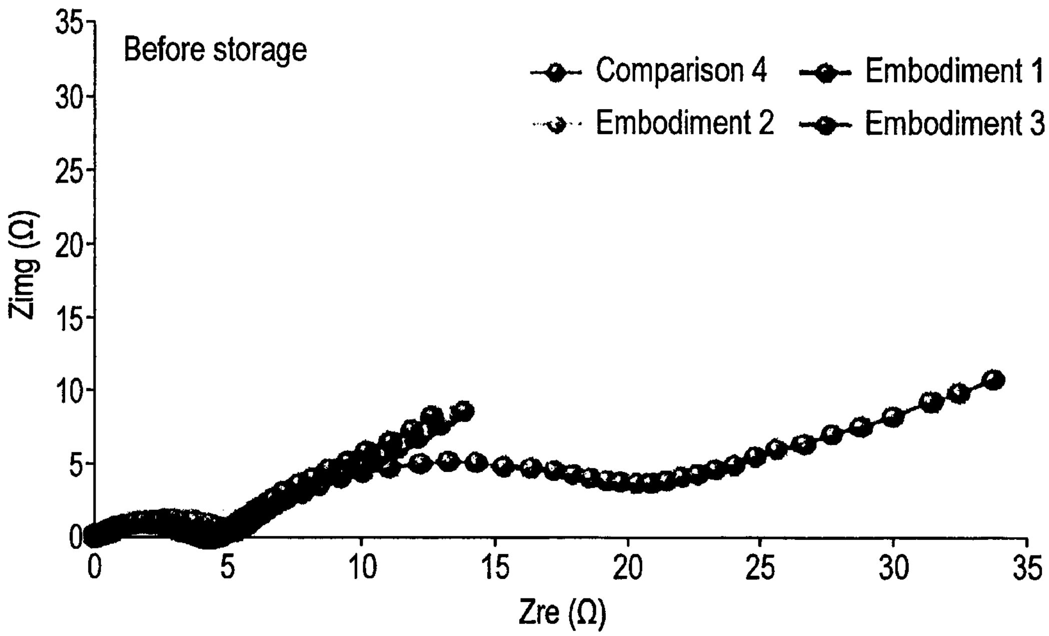

Fig. 30b

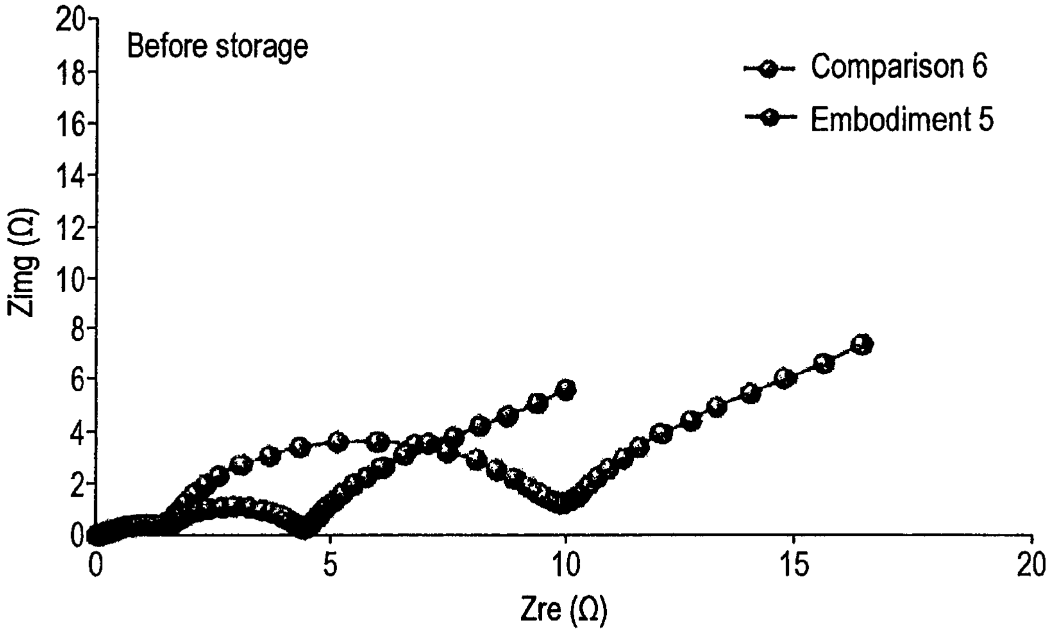


Fig. 30c

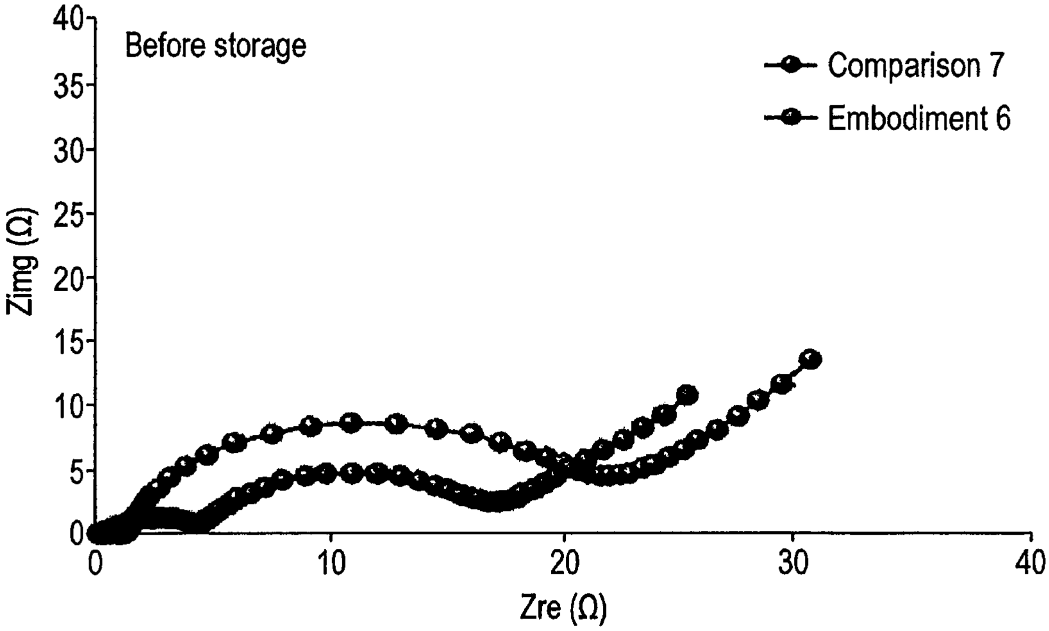

Fig. 30d

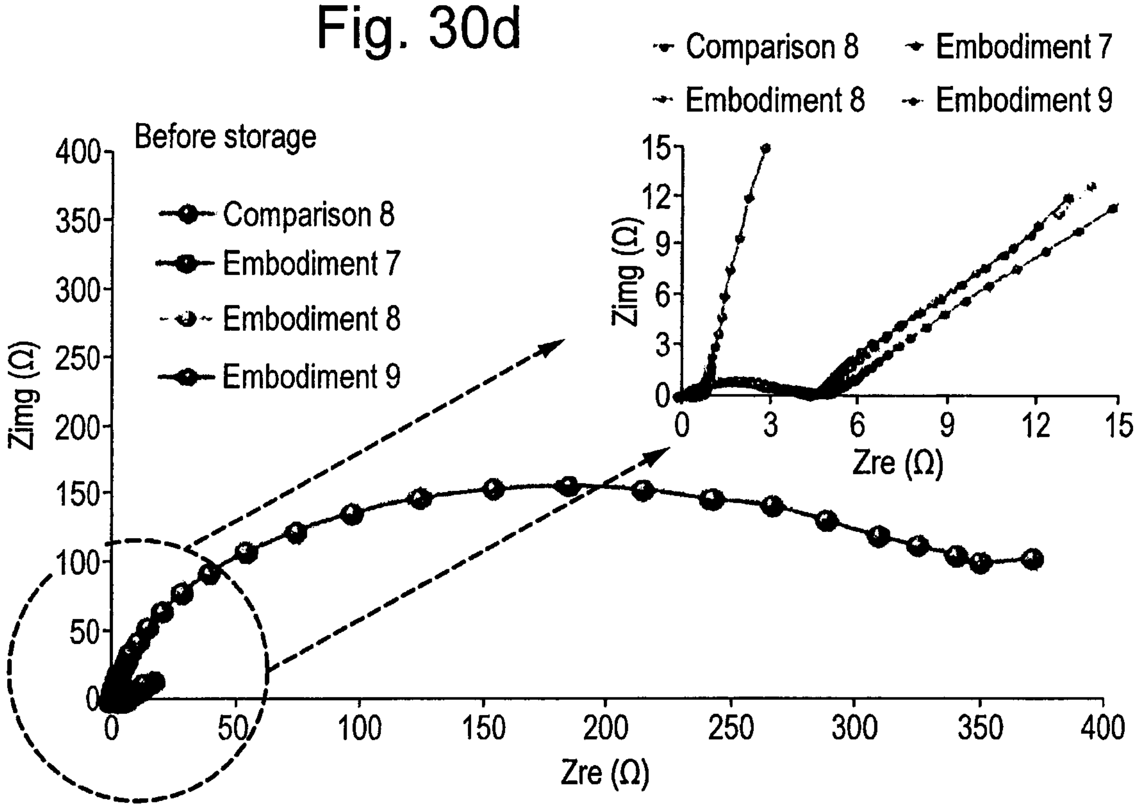


Fig. 30e

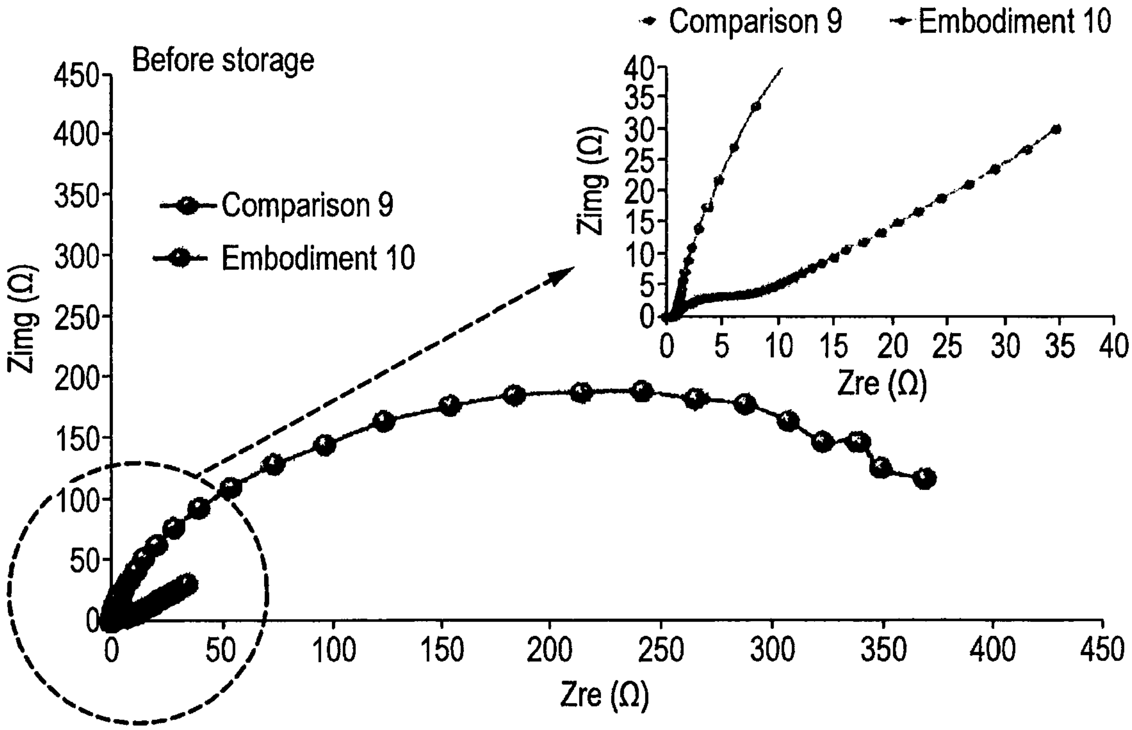

Fig. 31a

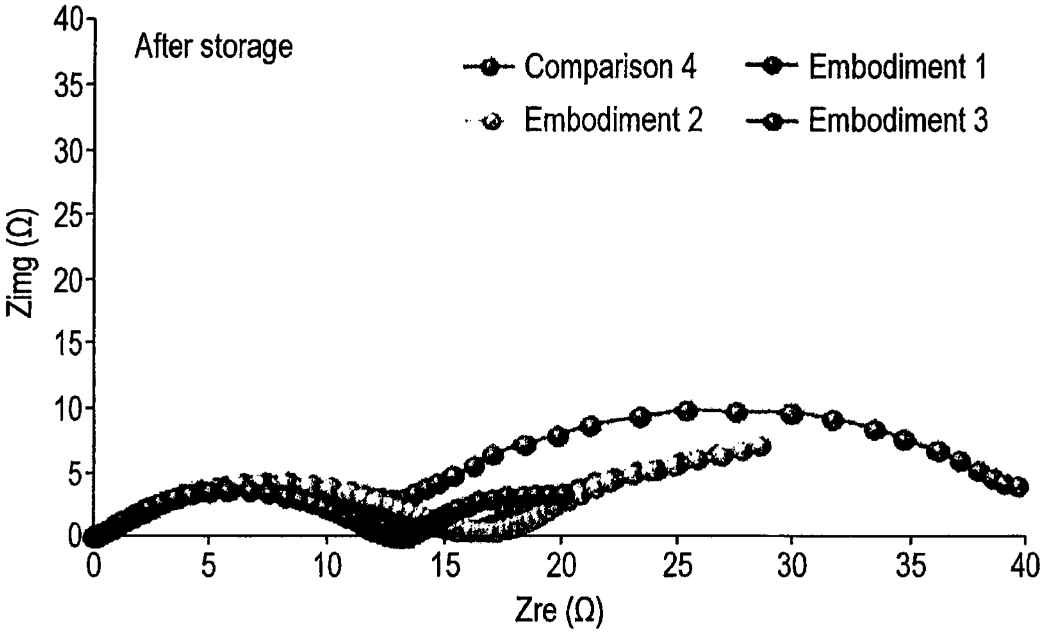


Fig. 31b

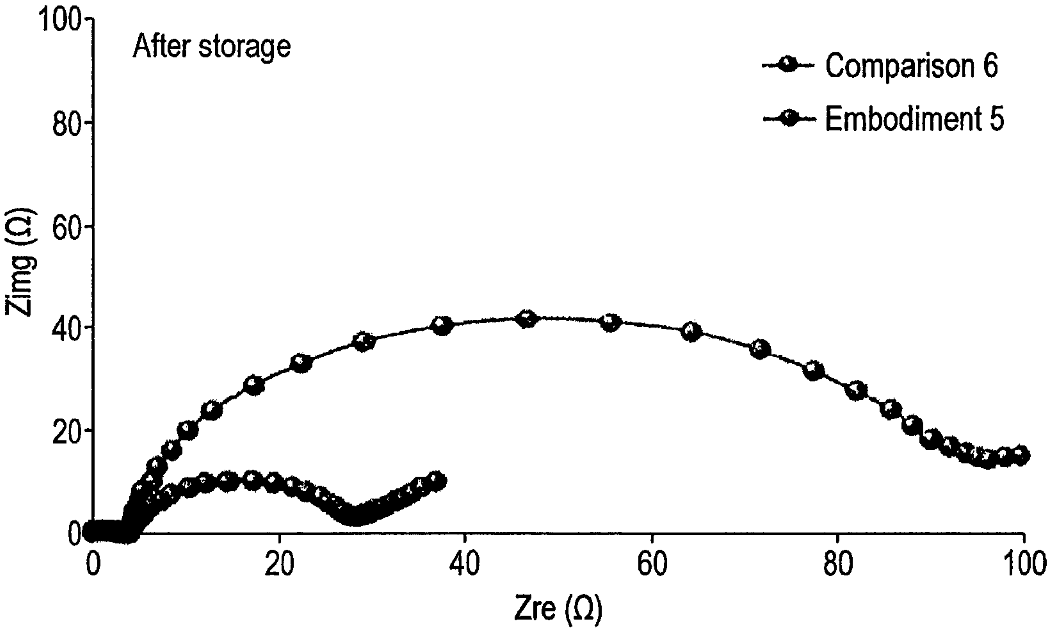

Fig. 31c

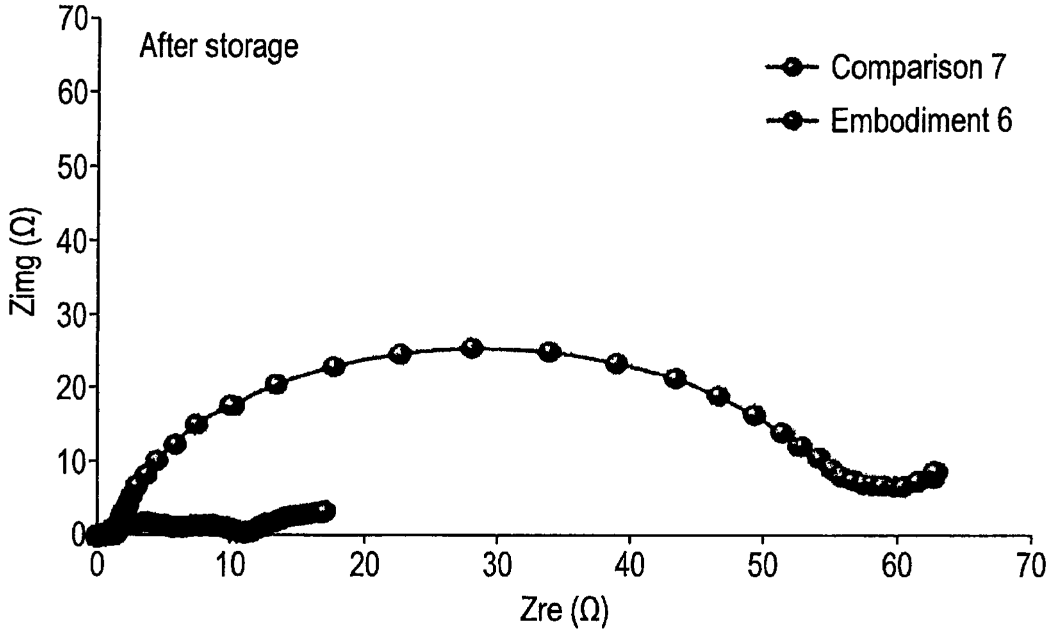


Fig. 31d

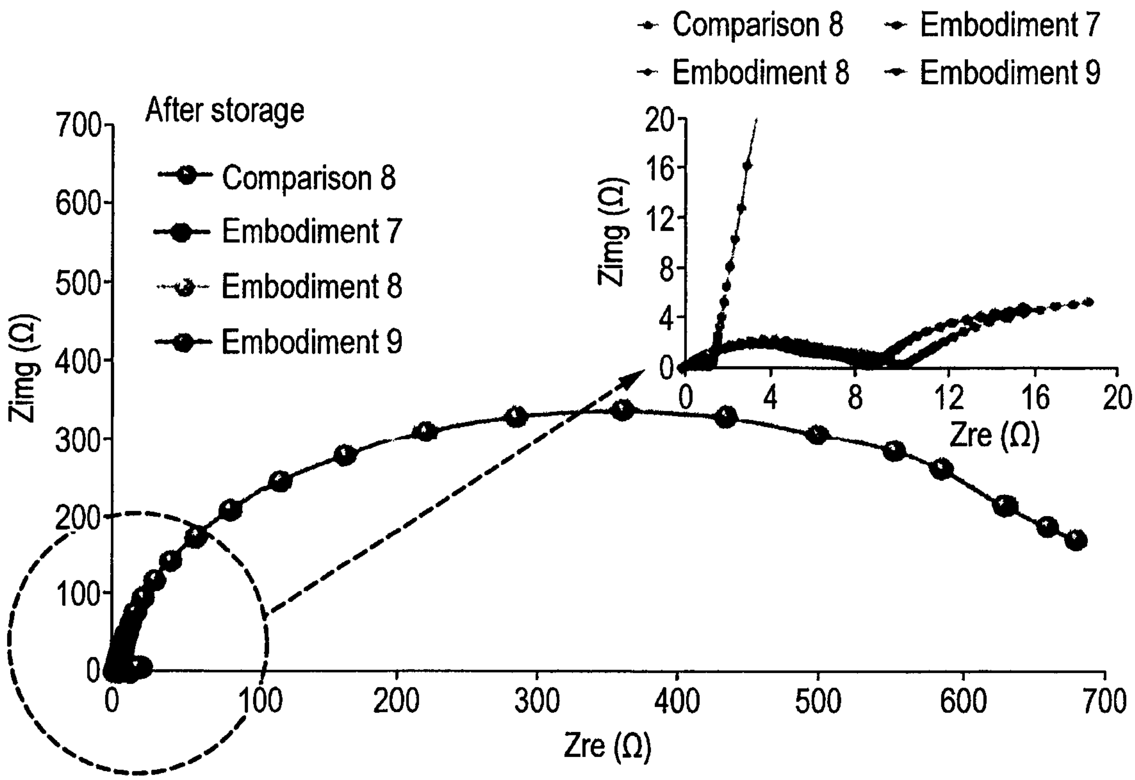

Fig. 31e

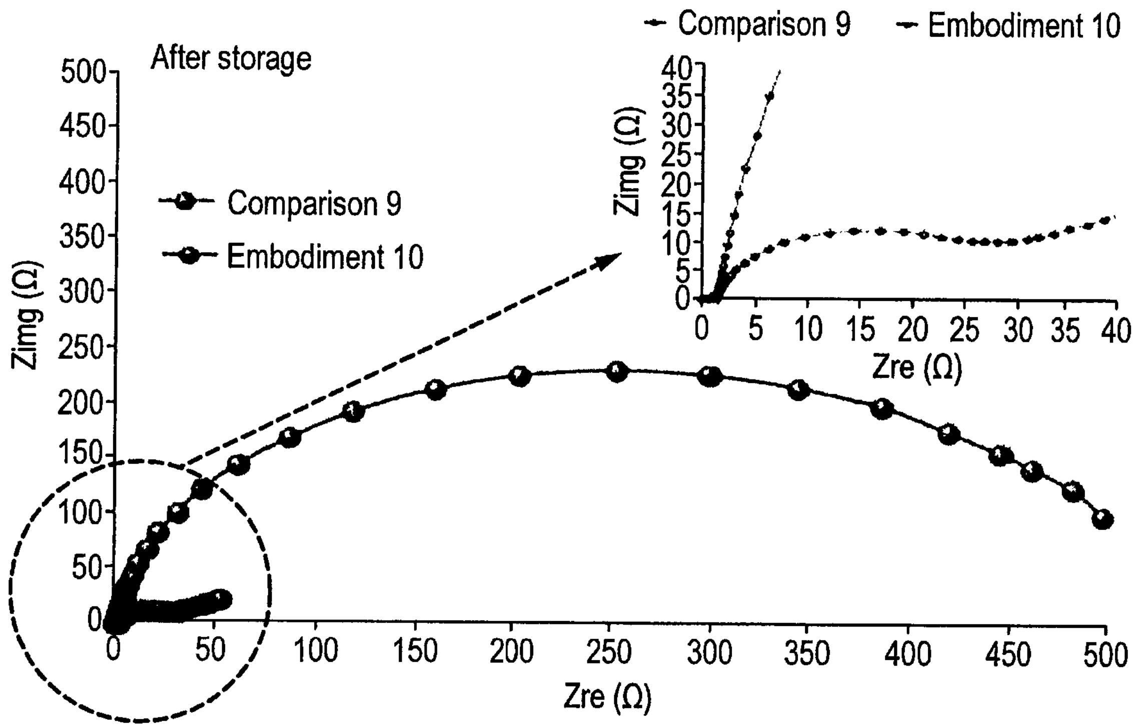
After storage
Comparison 9
Embodiment 10
Zimg (Ω)
Zre (Ω)
500
450
400
350
300
250
200
150
100
50
0
0
50
100
150
200
250
300
350
400
450
500
Comparison 9
Embodiment 10
40
35
30
25
20
15
10
5
0
0
5
10
15
20
25
30
35
40
Zimg (Ω)
Zre (Ω)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 20140081663 A